(19) Europäisches Patentamt
European Patent Office
Office européen des brevets

(11) EP 2 339 402 A1

(12) EUROPEAN PATENT APPLICATION

(43) Date of publication:
**29.06.2011 Bulletin 2011/26**

(21) Application number: **10197142.2**

(22) Date of filing: **28.12.2010**

(51) Int Cl.:
***G03F 7/11*** *(2006.01)* ***B41C 1/10*** *(2006.01)*
***B41N 1/14*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.12.2009 JP 2009298571**

(71) Applicant: **Fujifilm Corporation**
**Minato-ku**
**Tokyo (JP)**

(72) Inventors:
- **Sasaki, Tomoya**
  **Shizuoka (JP)**
- **Iwai, Yu**
  **Shizuoka (JP)**

(74) Representative: **HOFFMANN EITLE**
**Patent- und Rechtsanwälte**
**Arabellastraße 4**
**81925 München (DE)**

# (54) Lithographic printing plate precursor and method of preparing lithographic printing plate

(57) The invention is to provide a lithographic printing plate precursor which exhibits good stain resistance, maintains the good stain resistance even when preserved for a long period of time, is excellent in printing durability, UV ink printing durability and chemical resistance, and is capable of conducting development processing with a developer close to neutral region or on-press development, and a method of preparing a lithographic printing plate using the lithographic printing plate precursor, and is directed to a lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in its side chain and an image-forming layer containing (A) a polymerization initiator, (B) a polymerizable compound and (C) a binder polymer, and a method of preparing a lithographic printing plate using the lithographic printing plate precursor.

EP 2 339 402 A1

## Description

FIELD OF THE INVENTION

The present invention relates to a lithographic printing plate precursor capable of undergoing a so-called direct plate making, which can be directly conducting plate making by scanning of laser beam based on digital signals, for example, from a computer, and a method of preparing a lithographic printing plate using the lithographic printing plate precursor.

BACKGROUND OF THE INVENTION

Heretofore, negative lithographic printing plate precursors have been widely known and ordinarily comprise a photosensitive layer (image-forming layer, image-recording layer) of, for example, a diazo resin-containing type, a photopolymerization type and a photo-crosslinking type on a hydrophilic support. In order to prepare a lithographic printing plate, it is ordinarily conducted that a transparent negative film original (a lith film) is placed on such a lithographic printing plate precursor and the lithographic printing plate precursor was exposed imagewise using an ultraviolet ray. However, such operations require a great deal of time and effort. In recent years, with the progress of image-forming techniques, a computer-to-plate technique has been developed wherein the plate making is conducted by laser exposure based on digitized data, for example, from a computer, directly to a lithographic printing plate precursor, without using the lith film. Also, lithographic printing plate precursors of high-sensitive laser recording system for use in such techniques have been developed.

After the image exposure, the lithographic printing plate precursor is subjected to development processing. Specifically, a lithographic printing plate is obtained while leaving the photosensitive layer in the portion for forming the image area, the unnecessary other portion of the photosensitive layer is removed by dissolving with an alkaline developer to reveal the hydrophilic surface of support thereby forming the non-image area. Such alkali development processing has problems in view of safety and global environment. In order to cope with this situation, in recent years, development processing with a developer closer to neutral region or on-press development technique of conducting development processing on a printing machine has been developed.

For the photosensitive layer used in the lithographic printing plate precursor of laser recording system, the photopolymerization type is most suitable from the standpoint of high-sensitivity. However, since adhesion property of the photopolymerizable photosensitive layer to a support is not necessarily strong, disadvantages occur in that a solid image portion fails and in that a fine line or a highlight portion becomes thin or drops out, when a lithographic printing plate prepared therefrom is subjected to printing of high-speed and a large volume. Therefore, the photo-adhesion property between the photosensitive layer and the support is an important factor and a large number of investigations and developments have been made.

For instance, in JP-A-2006-239867 (the term "JP-A" as used herein means an "unexamined published Japanese patent application"), a lithographic printing plate precursor which contains a copolymer having a weight average molecular weight of 30,000 or more and containing a repeating unit having an ethylenically unsaturated bond and a repeating unit having a functional group capable of interacting with a surface of support and is capable of forming an image without undergoing alkali development is described.

In JP-A-2008-256742, a negative lithographic printing plate precursor having on a support, a layer containing an organic resin fine particle and a photosensitive layer containing a sensitizing dye having an absorption maximum in a range from 350 to 450 nm. As a specific example of the organic resin for forming the organic resin fine particle, a resin having a methacryl group connected with an ammonium structure in its side chain is described.

However, in the prior art techniques, it is difficult to achieve a good balance between stain resistance, particularly, stain resistance when the lithographic printing plate precursor is preserved for a long period of time, and printing durability. Further, UV ink printing durability and chemical resistance are also insufficient.

The UV ink printing durability means printing durability in case of using UV ink. The UV ink is different from conventional ink and has high polarity and high viscosity and high tackiness. Thus, the UV ink tends to attack the image area and the printing durability using the UV ink ordinarily decreases in comparison with the printing durability using conventional ink. Therefore, it is an important problem to increase the UV ink printing durability.

The chemical resistance means durability of the image area against a specific dampening water (fountain solution). Various kinds of the dampening waters for use at printing are present and the components thereof widely varied. The dampening water is ordinarily marketed as its stock solution and it is used after dilution. When the stock solution of the specific dampening water is brought into contact with a lithographic printing plate before printing, the image area is dissolved or peeled to cause a problem of the generation of printing failure. Though the reason for this is not quite clear, it is presumed that an organic solvent contained in the specific dampening water may engage.

SUMMARY OF THE INVENTION

An object of the present invention is to provide a lithographic printing plate precursor which exhibits good stain resistance, maintains the good stain resistance even when preserved for a long period of time, is excellent in printing durability, UV ink printing durability and chemical resistance, and is capable of conducting development processing with a developer close to neutral region or on-press development, and a method of preparing a lithographic printing plate using the lithographic printing plate precursor.

The inventors have found that by incorporating a copolymer containing a repeating unit derived from a monomer having a specific hydrophilic-hydrophobic property and containing a carbon-carbon unsaturated double bond through a covalent bond into an intermediate layer, a good balance between the stain resistance, the stain resistance after preservation for a long period of time and the printing durability can be achieved and further surprisingly found that the UV ink printing durability and the chemical resistance are improved to complete the invention.

The present invention includes the lithographic printing plate precursor and method of preparing a lithographic printing plate described below.

(1) A lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in its side chain and an image-forming layer containing (A) a polymerization initiator, (B) a polymerizable compound and (C) a binder polymer.

(2) The lithographic printing plate precursor as described in (1) above, wherein the repeating unit contains at least one structure selected from a carboxylate anion, a sulfonate anion, a sulfate anion, a phosphate anion, a phosphonate anion, an ammonium cation, a phosphonium cation and a hydroxy group.

(3) The lithographic printing plate precursor as described in (1) or (2) above, wherein the C log P value of the monomer for forming the repeating unit is -0.16 or less.

(4) The lithographic printing plate precursor as described in any one of (1) to (3) above, wherein the repeating unit is a repeating unit represented by any of formulae (I) to (VI) shown below:

(I)

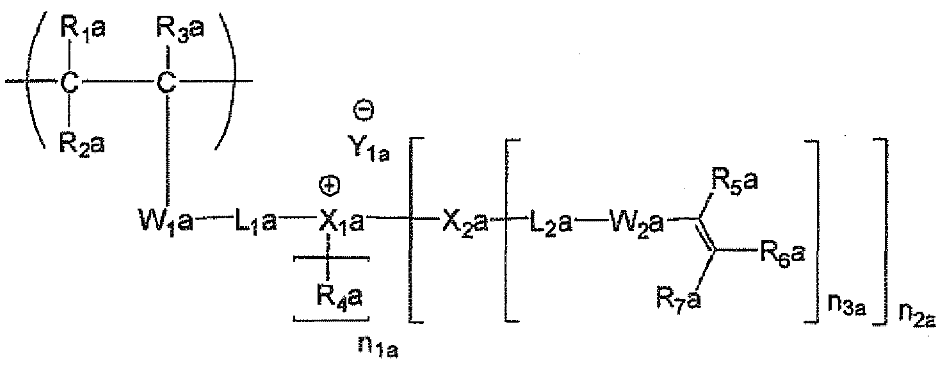

(II)

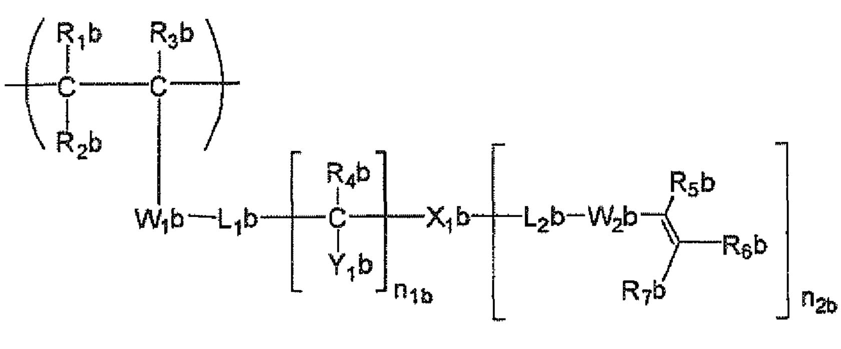

(III)

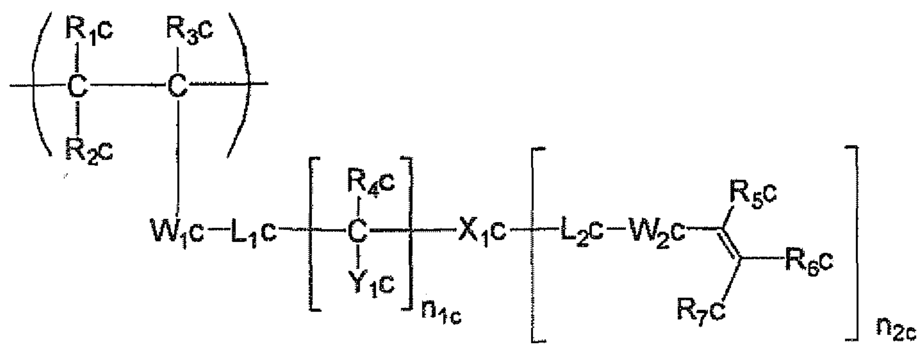

(IV)

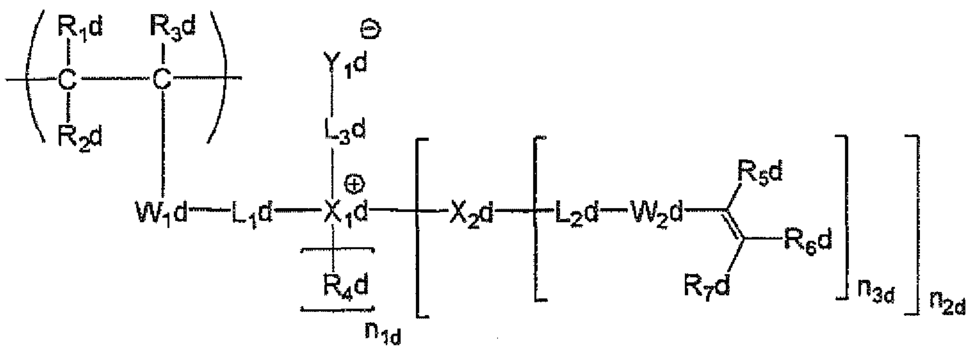

(V)

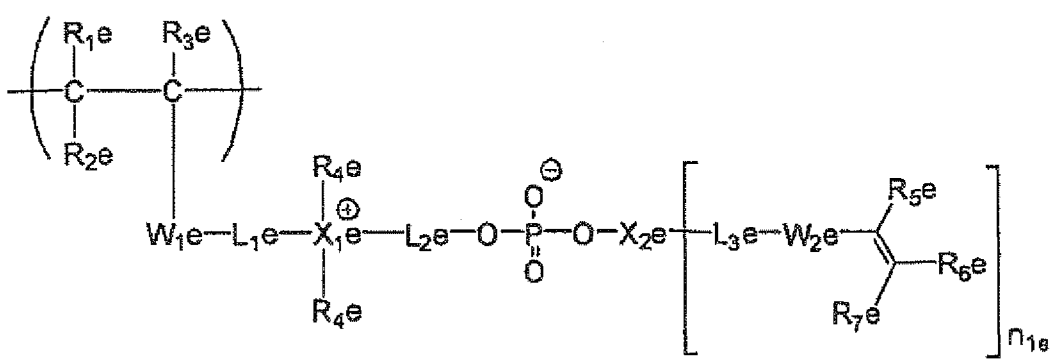

(V I)

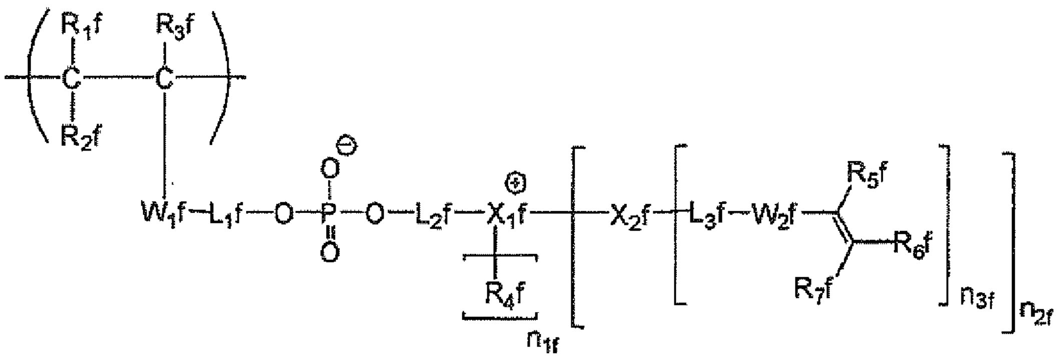

The definition of each symbol in formula (I) is described below.

$R_1a$ to $R_3a$ each represents a hydrogen atom, an alkyl group, a halogen atom or a cyano group. $R_4a$ each represents a hydrogen atom or a substituent having from 1 to 30 carbon atoms. $R_5a$ to $R_7a$ each represents a hydrogen atom, an alkyl group, -CO-O-Rx or -CO-N(Ry)(Rz). Rx represents an alkyl group.

Ry and Rz each represents a hydrogen atom, an alkyl group or an aryl group.

$L_1a$ and $L_2a$ each represents a single bond or a divalent connecting group.

$W_1a$ and $W_2a$ each represents an alkylene group, an arylene group, -O-, -S-, -CO-, -N(Rw)-, $-SO_2-$ or a divalent connecting group composed of an appropriate combination of these groups. Rw represents a hydrogen atom, an alkyl group or an aryl group.

$X_1a$ represents N or P.

$X_2a$ represents an ($n_3a$ + 1) valent connecting group, provided that when $n_3a$ is 1, $X_2a$ represents a single bond.

$Y_1a$ represents an organic or inorganic anion.

$n_1a$ represents an integer from 0 to 2.

$n_2a$ represents an integer from 1 to 3, provided that $n_1a + n_2a = 3$.

$n_3a$ represents an integer from 1 to 4.

The definition of each symbol in formula (II) is described below.

$R_1b$ to $R_3b$, $R_4b$, $R_5b$ to $R_7b$, $L_1b$, $L_2b$, $W_1b$ and $W_2b$ have the same meanings as $R_1a$ to $R_3a$, $R_4a$, $R_5a$ to $R_7a$, $L_1a$, $L_2a$, $W_1a$ and $W_2a$ in formula (I), respectively.

$X_1b$ represents an ($n_2b$ + 1) valent connecting group, provided that when $n_2b$ is 1, $X_1b$ represents a single bond.

$Y_1b$ each represents a hydrogen atom, a hydroxy group or an alkyl group, provided that at least one of $Y_1b$ represents a hydroxy group.

$n_1b$ represents an integer from 1 to 10.

$n_2b$ represents an integer from 1 to 4.

The definition of each symbol in formula (III) is described below.

$R_1c$ to $R_3c$, $R_4c$, $R_5c$ to $R_7c$, $L_1c$, $L_2c$, $W_1c$ and $W_2c$ have the same meanings as $R_1a$ to $R_3a$, $R_4a$, $R_5a$ to $R_7a$, $L_1a$, $L_2a$, $W_1a$ and $W_2a$ in formula (I), respectively.

$n_1c$ and $n_2c$ have the same meanings as $n_1b$ and $n_2b$ in formula (II), respectively.

$X_1c$ represents an ($n_2c$ + 1) valent connecting group, provided that when $n_2c$ is 1, $X_1c$ represents a single bond.

$Y_1c$ each represents a hydrogen atom, a hydroxy group, an alkyl group or a group represented by $L_3c$-Q, provided that at least one of $Y_1c$ represents a group represented by $L_3c$-Q.

$L_3c$ represents a single bond or a divalent connecting group.

Q represents $-CO_2M$, $-SO_3M$, $-OSO_3M$, $-OPO(OM_1)(OM_2)$ or $-PO(OM_3)(OM_4)$.

M, $M_1$ and $M_3$ each represents a monovalent metal ion or $N^+(R_0)_4$.

$M_2$ and $M_4$ each represents a hydrogen atom, a monovalent metal ion or $N^+(R_0)_4$.

$R_0$ each represents a hydrogen atom or an alkyl group.

The definition of each symbol in formula (IV) is described below.

$R_1d$ to $R_3d$, $R_4d$, $R_5d$ to $R_7d$, $L_1d$, $L_2d$, $W_1d$, $W_2d$, $n_3d$ and $X_1d$ have the same meanings as $R_1a$ to $R_3a$, $R_4a$, $R_5a$ to $R_7a$, $L_1a$, $L_2a$, $W_1a$, $W_2a$, $n_3a$ and $X_1a$ in formula (I), respectively.

$L_3d$ represents a divalent connecting group.

$X_2d$ represents an ($n_3d$ + 1) valent connecting group, provided that when $n_3d$ is 1, $X_2d$ represents a single bond.

$Y_1d$ represents $-CO_2^-$, $-SO_3^-$ or $-OPO(O^-)(ORp)$.

Rp represents an alkyl group.

$n_1d$ represents 0 or 1.

$n_2d$ represents 1 or 2, provided that $n_1d + n_2d = 2$.

The definition of each symbol in formula (V) is described below.

$R_1e$ to $R_3e$, $R_4e$, $R_5e$ to $R_7e$, $W_1e$, $W_2e$ and $X_1e$ have the same meanings as $R_1a$ to $R_3a$, $R_4a$, $R_5a$ to $R_7a$, $W_1a$, $W_2a$ and $X_1a$ in formula (I), respectively.

$L_1e$ and $L_2e$ have the same meanings as $L_1a$ in formula (I), respectively.

$L_3e$ has the same meaning as $L_2a$ in formula (I).

$n_1e$ has the same meaning as $n_2b$ in formula (II).

$X_2e$ represents an $(n_1e + 1)$ valent connecting group, provided that when $n_1e$ is 1, $X_2e$ represents a single bond.

The definition of each symbol in formula (VI) is described below.

$R_1f$ to $R_3f$, $R_4f$, $R_5f$ to $R_7f$, $W_1f$, $W_2f$, $X_1f$, $X_2f$ and $n_1f$ to $n_3f$ have the same meanings as $R_1a$ to $R_3a$, $R_4a$, $R_5a$ to $R_7a$, $W_1a$, $W_2a$, $X_1a$, $X_2a$ and $n_1a$ to $n_3a$ in formula (I), respectively.

$L_1f$ and $L_2f$ have the same meanings as $L_1a$ in formula (I), respectively.

$L_3f$ has the same meaning as $L_2a$ in formula (I).

(5) The lithographic printing plate precursor as described in (4) above, wherein in formula (I), $W_1a$ is -CO-O- or -CO-N(Rw)-, and $X_1a$ is N; in formula (II), $W_1b$ is -CO-O- or -CO-N(Rw)-; in formula (III), $W_1c$ is -CO-O- or -CO-N(Rw)-, and Q is $-SO_3M$, $-OPO(OM_1)(OM_2)$ or $-PO(OM_3)(OM_4)$; in formula (IV), $W_1d$ is -CO-O- or -CO-N(Rw)-, $X_1d$ is N, and $Y_1d$ is $-CO_2^-$, $-SO_3^-$ or $-OPO(O^-)(ORp)$; in formula (V), $W_1e$ is -CO-O- or -CO-N(Rw)-, and $X_1e$ is N; or in formula (VI), $W_1f$ is -CO-O- or -CO-N(Rw)-, and $X_1f$ is N.

(6) The lithographic printing plate precursor as described in any one of (1) to (5) above, wherein the C log P value of the monomer for forming the repeating unit is -1.0 or less.

(7) The lithographic printing plate precursor as described in any one of (1) to (6) above, wherein the copolymer contains a repeating unit having as a functional group capable of interacting with a surface of the support, a sulfonic acid group or a salt thereof, a phosphoric acid ester group or a salt thereof or a phosphonic acid group or a salt thereof.

(8) The lithographic printing plate precursor as described in any one of (1) to (7) above, wherein the image-forming layer further contains a sensitizing dye.

(9) The lithographic printing plate precursor as described in (8) above, wherein the sensitizing dye is a sensitizing dye having an absorption maximum in a wavelength range from 300 to 450 nm.

(10) The lithographic printing plate precursor as described in (8) above, wherein the sensitizing dye is an infrared absorbing agent.

(11) The lithographic printing plate precursor as described in any one of (1) to (10) above, wherein the image-forming layer further contains a hydrophobilizing precursor.

(12) The lithographic printing plate precursor as described in any one of (1) to (11) above, wherein the image-forming layer further contains at least one selected from a microcapsule and a microgel.

(13) The lithographic printing plate precursor as described in any one of (1) to (12) above, wherein the binder polymer is a (meth)acrylic polymer, a polyurethane resin or a polyvinyl butyral resin.

(14) The lithographic printing plate precursor as described in any one of (1) to (13) above, wherein the binder polymer has an ethylenically unsaturated bond group.

(15) The lithographic printing plate precursor as described in any one of (1) to (14) above, which comprises a protective layer on the image-forming layer.

(16) The lithographic printing plate precursor as described in (15) above, wherein the protective layer contains an inorganic stratiform compound.

(17) A method of preparing a lithographic printing plate comprising a step of imagewise exposing a lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in its side chain and an image-forming layer containing (A) a polymerization initiator, (B) a polymerizable compound and (C) a binder polymer and a step of removing an unexposed area of the image-forming layer by supplying oily ink and an aqueous component on a printing machine to initiate printing without applying any development processing to the exposed lithographic printing plate precursor.

(18) A method of preparing a lithographic printing plate comprising a step of imagewise exposing a lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in its side chain and an image-forming layer containing (A) a polymerization initiator, (B) a polymerizable compound and (C) a binder polymer and a step of removing an unexposed area of the image-forming layer by processing the exposed lithographic printing plate precursor with a developer having pH of 2 to 11.

According to the present invention, a lithographic printing plate precursor which exhibits good stain resistance, maintains the good stain resistance even when preserved for a long period of time, is excellent in printing durability, UV ink printing durability and chemical resistance, and is capable of conducting development processing with a developer close to neutral region or on-press development can be provided. Further, using the lithographic printing plate precursor, a lithographic printing plate having the excellent properties can be obtained by a simple method.

## BRIEF DESCRIPTION OF THE DRAWINGS

Fig. 1 is a view schematically showing a structure of an automatic development processor.

[Description of reference numerals and signs]

1: Rotating brush roller

2: Backing roller

3: Transport roller

4: Transport guide plate

5: Spray pipe

6: Pipe line

7: Filter

8: Plate supply table

9: Plate discharge table

10: Developer tank

11: Circulating pump

12: Lithographic printing plate precursor

## DETAILED DESCRIPTION OF THE INVENTION

[Lithographic printing plate precursor]

The lithographic printing plate precursor according to the invention comprises, in the following order, (1) a support, (2) an intermediate layer and (3) an image-forming layer containing (A) a polymerization initiator, (B) a polymerizable compound and (C) a binder polymer and the intermediate layer contains a copolymer containing a repeating unit (d1) derived from a monomer having a C log P value of -0.14 or less and containing a carbon-carbon unsaturated double bond through a covalent bond in its side chain. The term "in the following order" does not exclude the possibility that other layer(s) may be provided in between the support and the intermediate layer or between the intermediate layer and the image-forming layer.

The factors on which the lithographic printing plate precursor according to the invention exhibits the excellent performances described above are believed to be as follows. Specifically, since the specific repeating unit (d1) in the copolymer contained in the intermediate layer has a carbon-carbon unsaturated double bond, it has a function of causing a polymerization reaction with the image-forming layer in the exposed area to increase the adhesion property between the intermediate layer and the image-forming layer thereby increasing printing durability. Heretofore, the repeating unit having such a function has high hydrophobicity and rises a problem of deteriorating stain resistance of the unexposed area when incorporated in a large amount. According to the invention, on the contrary, since the repeating unit (d1) has

hydrophilicity above a certain level, it is believed that the printing durability can be increased without the deterioration of stain resistance even when introduced in the large amount. Further, the factors of improving the UV ink printing durability and chemical resistance are believed to be as follows. Specifically, since the repeating unit (d1) has low affinity to UV ink or a specific dampening water, it is believed that the UV ink or specific dampening water hardly penetrates into the interface between the intermediate layer and the image-forming layer thereby improving the UV ink printing durability and chemical resistance.

[Intermediate layer]

The intermediate layer of the lithographic printing plate precursor according to the invention contains a copolymer (hereinafter, also referred to as a "specific copolymer") containing a repeating unit (d1) derived from a monomer having a C log P value of -0.14 or less and containing a carbon-carbon unsaturated double bond through a covalent bond in its side chain.

The monomer for forming the repeating unit (d1) in the specific copolymer has a feature that the C log P value thereof is -0.14 or less.

The C log P value is a value calculated by a program "CLOGP" available from Daylight Chemical Information System, Inc. The program provides a value of "calculated log P" calculated by fragment approach of Hansch, Leo. The fragment approach is based on the chemical structure of a compound, and the chemical structure is divided into partial structures (fragments) and each share of log P assigned to the fragment are totalized to estimate the log P value of the compound. The details thereof are described in literatures shown below. In the invention, a C log P value calculated using the program CLOGP v4.82 was used.

A.J. Leo, Comprehensive Medicinal Chemistry, Vol. 4, C. Hansch, P.G. Sammens, J.B. Taylor and C.A. Ramsden, Eds., p.295, Pergamon Press, (1990).

C. Hansch and A.J. Leo, Substituent Constants for Correlation Analysis in Chemistry and Biology, John Wiley & Sons.

A.J. Leo, Calculating logPoct from Structure, Chem. Rev., 93, 1281-1306, (1993).

The log P means a common logarithm of partition coefficient P, and is a physical property value indicating, as a quantitative value, how a certain organic compound is distributed at equilibrium in a two-phase system of oil (ordinarily, 1-octanol) and water and is represented by the following equation:

$$\log P = \log(Coil/Cwater)$$

wherein Coil represents a mol concentration of the compound in the oil phase and Cwater represents a mol concentration of the compound in the aqueous phase.

As the value of log P increases in a positive direction from 0, solubility in oil increases. As an absolute value of the log P increases in a negative direction from 0, solubility in water increases. There is a negative correlation between the value of log P and a water-solubility of an organic compound, and the value is widely utilized as a parameter for estimating the hydrophilic-hydrophobic property of the organic compound.

According to the invention, it is essential that the C log P value of the monomer for forming the repeating unit (d1) of the specific copolymer is -0.14 or less. When the C log P value of the monomer is larger than -0.14, the stain resistance (particularly, stain resistance after preservation) of the non-image area deteriorates and it is impossible to achieve the good balance between the stain resistance and the printing durability, UV ink printing durability and chemical resistance.

The lower limit of the C log P value of the monomer for forming the repeating unit (d1) is -10. When the C log P value of the monomer is less than -10, the printing durability, UV ink printing durability and chemical resistance deteriorate although the satin resistance of the non-image area is good. Though the reason for this is not quite clear, it is presumed that when the C log P value of the monomer for forming the repeating unit (d1) decreases less than -10 (specifically, the hydrophilicity increases), a large difference in the hydrophilic-hydrophobic property arises among the carbon-carbon unsaturated double bond and the polymerizable compound in the image-forming layer to decrease the compatibility and thus, the polymerization reactivity between the intermediate layer and the image-forming layer (hereinafter, referred to as an interlayer) in the exposed area deteriorates or even when the interlayer polymerization proceeds, due to the excessively high hydrophilicity, the effect of improving the interlayer adhesion property in the image area is damaged.

The repeating unit derived from a monomer containing a carbon-carbon unsaturated double bond through a covalent bond at its side chain in the specific copolymer is described using a schematic view represented by formula (A) shown below. In formula (A), $C_1=C_2$ represents a carbon-carbon unsaturated double bond, $S_1$ represents an atomic

group for forming a main chain of the copolymer, and $T_1$ represents an (N + 1) valent connecting group. $R_5a$ to $R_7a$ have the same meanings as $R_5a$ to $R_7a$ in formula (I) shown below, respectively. The term "containing a carbon-carbon unsaturated double bond through a covalent bond" as used herein means that the connecting chain(s) included in the connecting group $T_1$ connecting $S_1$ and $C_1$ are all composed of the covalent bond(s).

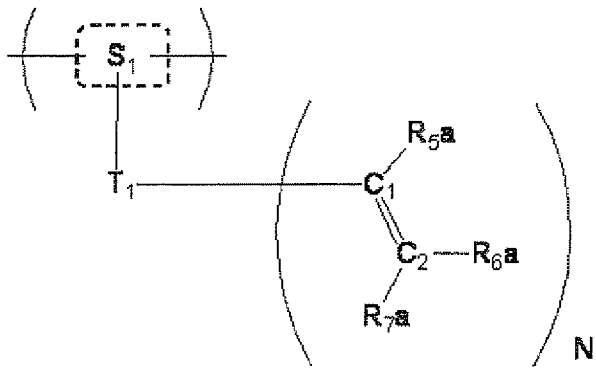

(A)

It is desired that the repeating unit (d1) contains a structure of high hydrophilicity in order to obtain the desired hydrophilic-hydrophobic property. The term "contain" as used herein means that the structure of high hydrophilicity is connected to an atom constituting a main chain of the repeating unit (d1) through a covalent bond. Specifically, the structure of high hydrophilicity may be present in any appropriate position of the repeating unit (d1). For instance, it may be present as a monovalent substituent, on an atom constituting the main chain, on an atom constituting the linking group or on an atom constituting the carbon-carbon unsaturated double bond or may be present in the connecting chain.

The structure of high hydrophilicity may be any structures which can adjust the C log P of the monomer for forming the repeating unit (d1) to -0.14 or less. The structure of high hydrophilicity is particularly preferably a structure having a charge. The structures having a charge are preferred because they ordinarily exhibit a low C log P value, such as from -1.3 to -6.1. Specific examples of the structures having a charge include an anion structure, for example, an anion formed by eliminating a proton from a protonic acid, e.g., a sulfonic acid, a sulfuric acid, a phosphoric acid, a phosphonic acid, a carboxylic acid or an alcohol or a polyvalent anion, e.g., a borate or a silicate, and a cation structure, for example, an onium cation, e.g., a phosphonium or an ammonium. In the case where the repeating unit has the anion structure, as a counter ion thereof, a metal ion and the cation structure described above are exemplified. In the case where the repeating unit has the cation structure, as a counter ion thereof, a halide ion (e.g., $F^-$, $Cl^-$, $Br^-$ or $I^-$) and the anion structure described above are exemplified. Further, the repeating unit (d1) may have both the anion structure and the cation structure. In such a case, there may be a state where the anion structure and the cation structure act each other as the counter ions to form an intramolecular salt or a state where the anion structure and the cation structure have separate counter ions, respectively.

Of the structures of high hydrophilicity, specific examples of those having no charge include a monovalent group, for example, a hydroxy group or a cyano group, and a divalent connecting group, for example, a (poly)ethyleneoxy group, an amido group, a urea group, an imido group or a bissulfonylimido group.

The structure of high hydrophilicity is preferably a carboxylate anion, a sulfonate anion, a sulfate anion, a phosphate anion, a phosphonate anion, an ammonium cation, a phosphonium cation or a hydroxy group, more preferably, a sulfonate anion, a phosphate anion, an ammonium cation or a phosphonium cation, and particularly preferably a sulfonate anion or an ammonium cation.

It is also preferred that the repeating unit (d1) has both of a sulfonate anion, a phosphate anion or a carboxylate anion and an ammonium cation or a phosphonium cation.

As the repeating unit (d1) for constituting the specific copolymer, a repeating unit (d1') derived from a monomer having a C log P value of -0.16 or less and containing a carbon-carbon unsaturated double bond through a covalent bond at its side chain is preferred, a repeating unit (d1") derived from a monomer having a C log P value of -1.0 or less and containing a carbon-carbon unsaturated double bond through a covalent bond at its side chain is more preferred, and a repeating unit (d1"') derived from a monomer having a C log P value of -1.5 or less and containing a carbon-carbon unsaturated double bond through a covalent bond at its side chain is particularly preferred.

As the repeating unit (d1) for constituting the specific copolymer, a repeating unit represented by any of formulae (I) to (VI) shown below is preferred.

(I)

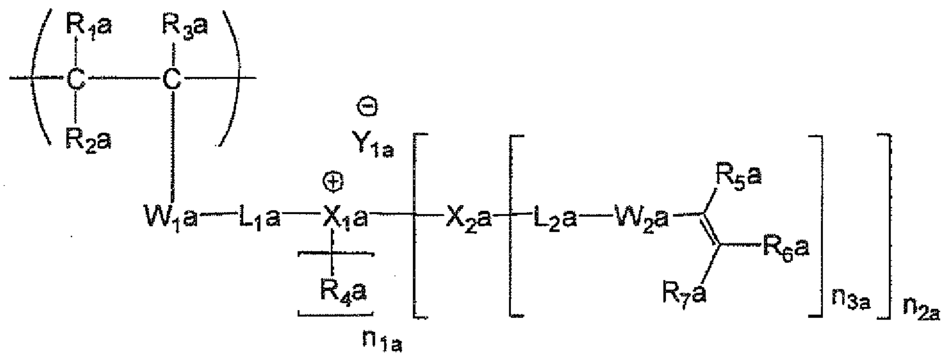

(II)

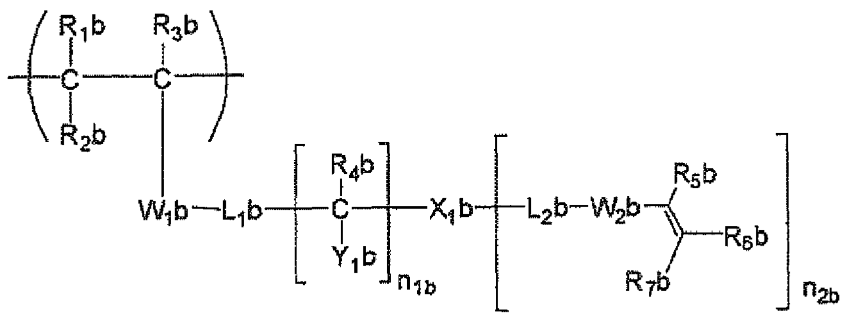

(III)

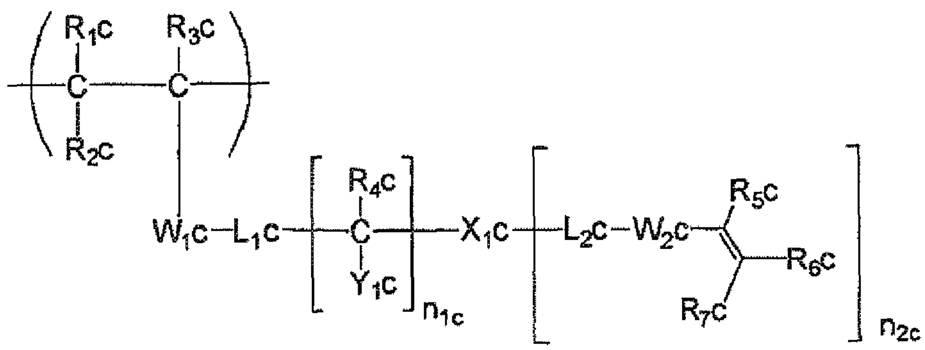

(IV)

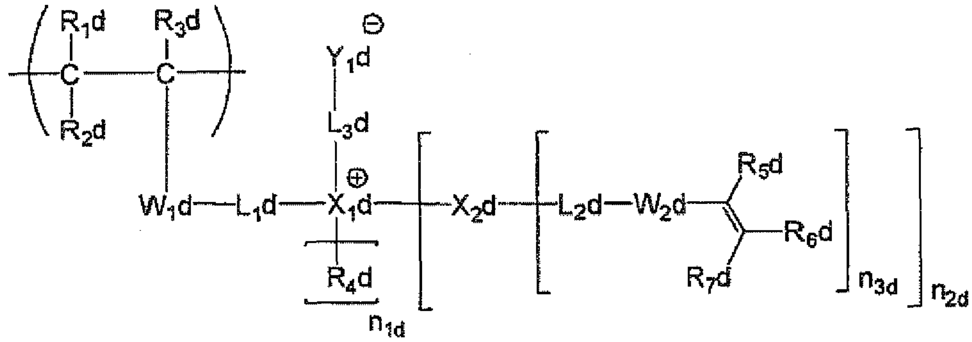

(V)

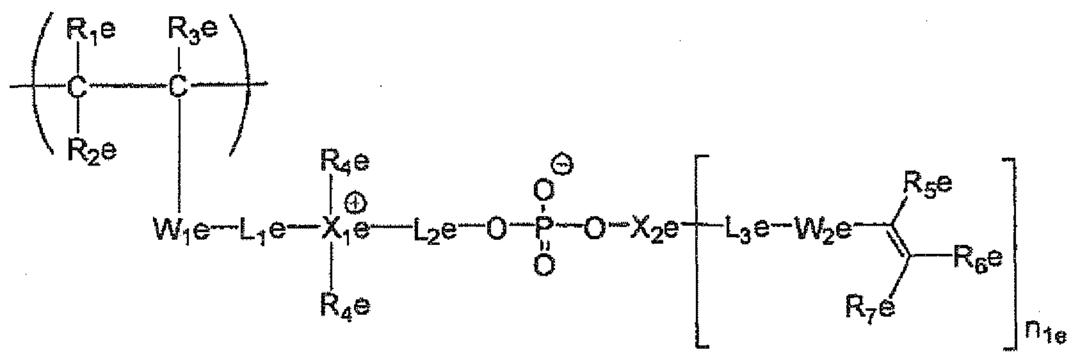

(VI)

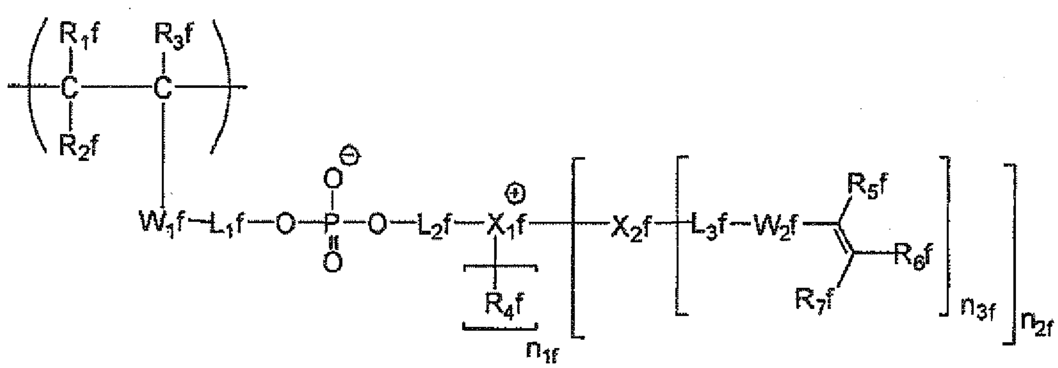

The definition of each symbol in formula (I) is described below.

$R_1$a to $R_3$a each represents a hydrogen atom, an alkyl group, a halogen atom or a cyano group. $R_4$a each represents a hydrogen atom or a substituent having from 1 to 30 carbon atoms. $R_5$a to $R_7$a each represents a hydrogen atom, an alkyl group, -CO-O-Rx or -CO-N(Ry)(Rz). Rx represents an alkyl group.

Ry and Rz each represents a hydrogen atom, an alkyl group or an aryl group.

$L_1$a and $L_2$a each represents a single bond or a divalent connecting group.

$W_1$a and $W_2$a each represents an alkylene group, an arylene group, -O-, -S-, -CO-, -N(Rw)-, $-SO_2-$ or a divalent

connecting group composed of an appropriate combination of these groups. Rw represents a hydrogen atom, an alkyl group or an aryl group.

$X_1a$ represents N or P.

$X_2a$ represents an ($n_3a$ + 1) valent connecting group, provided that when $n_3a$ is 1, $X_2a$ represents a single bond.

$Y_1a$ represents an organic or inorganic anion.

$n_1a$ represents an integer from 0 to 2.

$n_2a$ represents an integer from 1 to 3, provided that $n_1a + n_2a = 3$.

$n_3a$ represents an integer from 1 to 4.

The definition of each symbol in formula (II) is described below.

$R_1b$ to $R_3b$, $R_4b$, $R_5b$ to $R_7b$, $L_1b$, $L_2b$, $W_1b$ and $W_2b$ have the same meanings as $R_1a$ to $R_3a$, $R_4a$, $R_5a$ to $R_7a$, $L_1a$, $L_2a$, $W_1a$ and $W_2a$ in formula (I), respectively.

$X_1b$ represents an ($n_2b$ + 1) valent connecting group, provided that when $n_2b$ is 1, $X_1b$ represents a single bond.

$Y_1b$ each represents a hydrogen atom, a hydroxy group or an alkyl group, provided that at least one of $Y_1b$ represents a hydroxy group.

$n_1b$ represents an integer from 1 to 10.

$n_2b$ represents an integer from 1 to 4.

The definition of each symbol in formula (III) is described below.

$R_1c$ to $R_3c$, $R_4c$, $R_5c$ to $R_7c$, $L_1c$, $L_2c$, $W_1c$ and $W_2c$ have the same meanings as $R_1a$ to $R_3a$, $R_4a$, $R_5a$ to $R_7a$, $L_1a$, $L_2a$, $W_1z$ and $W_2a$ in formula (I), respectively.

$n_1c$ and $n_2c$ have the same meanings as $n_1b$ and $n_2b$ in formula (II), respectively.

$X_1c$ represent an ($n_2c$ + 1) valent connecting group, provided that when $n_2c$ is 1, $X_1c$ represents a single bond.

$Y_1c$ each represents a hydrogen atom, a hydroxy group, an alkyl group or a group represented by $L_3c$-Q, provided that at least one of $Y_1c$ represents a group represented by $L_3c$-Q.

$L_3c$ represents a single bond or a divalent connecting group.

Q represents $-CO_2M$, $-SO_3M$, $-OSO_3M$, $-OPO(OM_1)(OM_2)$ or $-PO(OM_3)(OM_4)$.

M, $M_1$ and $M_3$ each represents a monovalent metal ion or $N^+(R_0)_4$.

$M_2$ and $M_4$ each represents a hydrogen atom, a monovalent metal ion or $N^+(R_0)_4$.

$R_0$ represents a hydrogen atom or an alkyl group.

The definition of each symbol in formula (IV) is described below.

Rid to $R_3d$, $R_4d$, $R_5d$ to $R_7d$, $L_1d$, $L_2d$, $W_1d$, $W_2d$, $n_3d$ and $X_1d$ have the same meanings as $R_1a$ to $R_3a$, $R_4a$, $R_5a$ to $R_3a$, $L_1a$, $L_2a$, $W_1a$, $W_2a$, $n_3a$ and $X_1a$ in formula (I), respectively.

$L_3d$ represents a divalent connecting group.

$X_2d$ represents an ($n_3d$ + 1) valent connecting group, provided that when $n_3d$ is 1, $X_2d$ represents a single bond.

$Y_1d$ represents $-CO_2^-$, $-SO_3^-$ or $-OPO(O^-)(ORp)$.

Rp represents an alkyl group.

$n_1d$ represents 0 or 1.

$n_2d$ represents 1 or 2, provided that $n_1d + n_2d = 2$.

The definition of each symbol in formula (V) is described below.

$R_1e$ to $R_3e$, $R_4e$, $R_5e$ to $R_7e$, $W_1e$, $W_2e$ and $X_1e$ have the same meanings as $R_1a$ to $R_3a$, $R_4a$, $R_5a$ to $R_7a$, $W_1a$, $W_2a$ and $X_1a$ in formula (I), respectively.

$L_1e$ and $L_2e$ have the same meanings as $L_1a$ in formula (I), respectively.

$L_3e$ has the same meaning as $L_2a$ in formula (I).

$n_1e$ has the same meaning as $n_2b$ in formula (II)

$X_2e$ represents an ($n_1e$ + 1) valent connecting group, provided that when $n_1e$ is 1, $X_2e$ represents a single bond.

The definition of each symbol in formula (VI) is described below.

$R_1f$ to $R_3f$, $R_4f$, $R_5f$ to $R_7f$, $W_1f$, $W_2f$, $X_1f$, $X_2f$ and $n_1f$ to $n_3f$ have the same meanings as $R_1a$ to $R_3a$, $R_4a$, $R_5a$ to $R_7a$, $W_1a$, $W_2a$, $X_1a$, $X_2a$ and $n_1a$ to $n_3a$ in formula (I), respectively.

$L_1f$ and $L_2f$ have the same meanings as $L_1a$ in formula (I), respectively.

$L_3f$ has the same meaning as $L_2a$ in formula (I).

Formulae (I) to (VI) will be described in detail below.

In formula (I), the alkyl group for any one of $R_1a$ to $R_3a$ represents a straight-chain, branched or cyclic, substituted or unsubstituted alkyl group. A total number of carbon atoms of the alkyl group is preferably from 1 to 10. The alkyl group may have a substituent and examples of the substituent include a halogen atom, a hydroxy group, an alkoxy group, an alkoxycarbonyloxy group and an aryl group.

For any one of $R_1a$ and $R_2a$, a hydrogen atom or a methyl group is preferred, and a hydrogen atom is more preferred. For $R_3a$, a hydrogen atom, a methyl group, an ethyl group, a hydroxymethyl group, a methoxymethyl group or a methylcarbonyloxy group is preferred, and a hydrogen atom, a methyl group or a hydroxymethyl group is more preferred.

The substituent having from 1 to 30 carbon atoms for $R_4$a includes a straight-chain, branched or cyclic, substituted or unsubstituted alkyl group and a substituted or unsubstituted aryl group (preferably having from 6 to 30 carbon atoms). Among them, an alkyl group having a total number of carbon atoms of 20 or less is preferred, an alkyl group having a total number of carbon atoms of 10 or less is more preferred, and an alkyl group having a total number of carbon atoms of 5 or less is particularly preferred. Examples of the alkyl group include a methyl group, an ethyl group, an n-propyl group, an isopropyl group, an n-butyl group and an isobutyl group. The alkyl group may have a substituent and examples of the substituent include an aryl group, a halogen atom, a hydroxy group and an alkoxy group. Further, when $R_4$a represents an alkyl group, -O- or -S- may be introduced between the carbon-carbon bond thereof. The aryl group may have a substituent and the examples of the substituent include a halogen atom, a hydroxy group and an alkoxy group.

When plural $R_4$a are present, two $R_4$a may be combined with each other to form a ring structure.

$R_4$a is preferably a hydrogen atom, a methyl group, an ethyl group, an n-propyl group, an n-butyl group, a $-(CH_2CH_2O)_p$-Rt group (wherein p represents an integer from 1 to 4 and Rt represents a hydrogen atom or a methyl group) or an aralkyl group, more preferably a methyl group, an ethyl group, a $-(CH_2CH_2O)_p$-Rt group or a substituted or unsubstituted benzyl group, and particularly preferably a methyl group, an ethyl group, a hydroxyethyl group or a substituted or unsubstituted benzyl group.

The alkyl group for any one of $R_5$a to $R_7$a is same as the alkyl group for any one of $R_1$a to $R_3$a. Preferable examples thereof are also same as those for any one of $R_1$a to $R_3$a.

In the case where any one of $R_5$a to $R_7$a represents -CO-O-Rx or -CO-N(Ry)(Rz), the alkyl group for any one of Rx, Ry and Rz is same as the alkyl group for any one of $R_1$a to $R_3$a. The aryl group for any one of Ry and Rz may have a substituent and is preferably an aryl group having from 6 to 30 carbon atoms. Examples of the aryl group include a phenyl group and a naphthyl group.

Preferable examples of Rx include a methyl group, an ethyl group, an n-propyl group, an n-butyl group and a hydroxyethyl group. Preferable examples of Ry or Rz include a hydrogen atom, a methyl group, an ethyl group, an n-propyl group, an n-butyl group and a hydroxyethyl group.

Preferable examples of $R_5$a are same as those of $R_3$a, and preferable examples of $R_6$a and $R_7$a are same as those of $R_1$a and $R_2$a.

The divalent connecting group for $L_1$a or $L_2$a specifically includes an alkylene group, a cycloalkylene group, an arylene group, -O-, -S-, -CO-, -N(Rw)-, $-SO_2-$ and a divalent connecting group composed of an appropriate combination of these groups. $L_1$a or $L_2$a is preferably a single bond, an alkylene group having 10 or less carbon atoms, an arylene group, a cycloalkylene group having 10 or less carbon atoms, -O-, -CO-, -N(Rw)- or a divalent connecting group composed of an appropriate combination of these groups, and more preferably a single bond, an alkylene group having 6 or less carbon atoms, a 1,4-phenylene group, -O-, -CO-, -N(H)- or a divalent connecting group composed of an appropriate combination of these groups.

For $W_1$a and $W_2$a, $W_1$a is preferably an alkylene group having 5 or less carbon atoms, a phenylene group, -O-, -S-, -CO-, -N(Rw)- or a divalent connecting group composed of an appropriate combination of these groups, more preferably a 1,4-phenylene group, -O-, -CO-, -N(Rw)- or a divalent connecting group composed of an appropriate combination of these groups, still more preferably -CO-O- or -CO-N(Rw)-, and particularly preferably -CO-N(H)-.

$W_2$a is preferably an alkylene group having 5 or less carbon atoms, a phenylene group, -O-, -S-, -CO-, -N(Rw)- or a divalent connecting group composed of an appropriate combination of these groups, more preferably an alkylene group having 3 or less carbon atoms, a 1,4-phenylene group, -O-, -CO-, -N(Rw)- or a divalent connecting group composed of an appropriate combination of these groups, still more preferably $-O-CH_2-$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$, and particularly preferably -CO-O-, -CO-N(H)-, $-CO-O-CH_2-$ or $-CO-N(H)-CH_2-$.

The alkyl group and aryl group for Rw are same as the alkyl group and aryl group for Ry above respectively. Rw is preferably a hydrogen atom, a methyl group, an ethyl group, an n-propyl group, an n-butyl group or a hydroxyethyl group, and more preferably a hydrogen atom, a methyl group or an ethyl group.

$X_1$a is preferably N.

The ($n_3$a + 1) valent connecting group for $X_2$a is a residue formed by eliminating ($n_3$a + 1) hydrogen atoms from a hydrocarbon having a total number of carbon atoms of 30 or less. The hydrocarbon includes an aliphatic hydrocarbon, an aromatic hydrocarbon and a combination thereof. The aliphatic hydrocarbon may be any of straight-chain, branched, monocyclic and polycyclic. The aromatic hydrocarbon may be either monocyclic or polycyclic. Further, between an appropriate carbon-carbon bond of the hydrocarbon may be introduced -O-, -N(Rw)-, -S-, -CO-, $-SO_2-$ or a divalent connecting group composed of an appropriate combination of these groups. A total number of carbon atoms included in $X_2$a is preferably 20 or less, and more preferably 10 or less. $X_2$a is preferably a ($n_3$a + 1) valent connecting group having a total number of carbon atoms of 20 or less, more preferably a ($n_3$a + 1) valent connecting group having a total number of carbon atoms of 10 or less, and further more preferably a ($n_3$a + 1) valent connecting group having a total number of carbon atoms of 5 or less. In this regard, $X_2$a is a single bond in case $n_3$a is 1.

The organic anion for $Y_1a$ includes, for example, an anion of an organic acid, for example, a carboxylic acid, a sulfonic acid, a phosphoric acid or a phosphonic acid and a borate. A total number of carbon atoms included in the organic anion is preferably 20 or less, more preferably 15 or less, and still more preferably 10 or less. The inorganic anion for $Y_1a$ includes, for example, $PF_6^-$, $BF_4^-$, $AsF_6^-$, $SbF_6^-$, $Cl^-$, $Br^-$ or $I^-$. $Y_1a$ is preferably a sulfonate anion, $PF_6^-$, $BF_4^-$, $Cl^-$, $Br^-$ or $I^-$, more preferably an alkylsulfonate anion which may have a substituent, an aromatic sulfonate anion which may have a substituent, $PF_6^-$, $BF_4^-$, $Cl^-$, $Br^-$ or $I^-$, and still more preferably a fluorinated alkylsulfonate anion, a benzenesulfonate anion which may have a substituent, $Cl^-$ or $Br^-$. Examples of the substituent include a halogen atom, a hydroxy group, an alkyl group having 4 or less carbon atoms, a cyano group, a nitro group and a carboxyl group.

$n_1a$ and $n_2a$ are preferably (1, 2) or (2, 1), and more preferably (2, 1), indicated in terms of ($n_1a$, $n_2a$).

$n_3a$ is preferably 1 to 2, and more preferably 1.

With respect to the repeating unit represented by formula (I), preferable combinations of each partial stricture are set forth below.

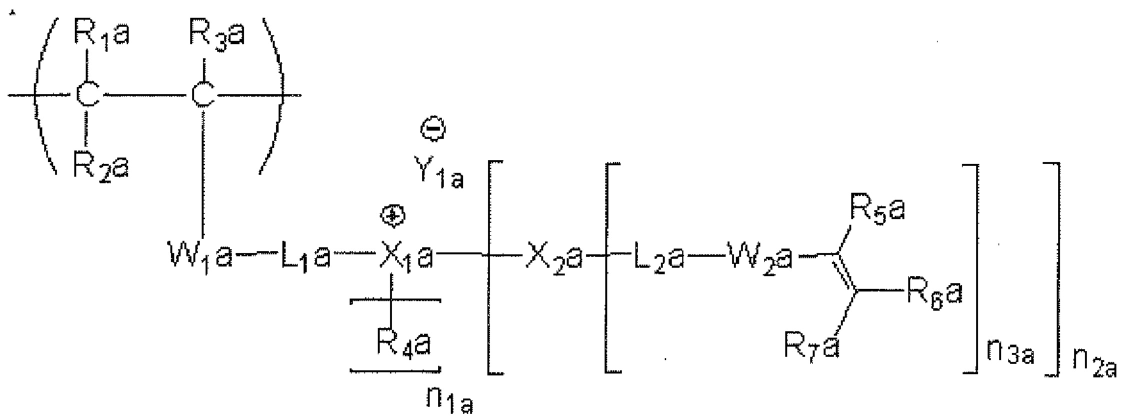

| | Preferable Combination | More Preferable Combination | Particularly Preferable Combination |
|---|---|---|---|
| $R_1a$, $R_2a$ | Hydrogen atom or Methyl group | Hydrogen atom | Hydrogen atom |
| $R_3a$ | Hydrogen atom, Methyl group, Ethyl group, Hydroxyethyl group, Methoxymethyl group or Methylcarbonyloxy group | Hydrogen atom, Methyl group or Hydroxymethyl group | Hydrogen atom or Methyl group |
| $R_4a$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5a$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6a$, $R_7a$ | Hydrogen atom or Methyl group | Hydrogen atom | Hydrogen atom |
| $W_1a$ | 1,4-Phenylene group, -O-, -CO-, -N(Rw)- or Divalent connecting group composed of appropriate combination of these groups | -CO-O- or -CO-N(Rw)- | -CO-O-,-CO-N(H)- |

(continued)

| | Preferable Combination | More Preferable Combination | Particularly Preferable Combination |
|---|---|---|---|
| $W_2a$ | Alkylene group having 3 or less carbon atoms, 1,4-Phenylene group, -O-, -CO-, -N(Rw)- or Divalent connecting group composed of appropriate combination of these groups | $-O-CH_2-$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$ | -CO-O-, -CO-N(H)-, $-CO-O-CH_2-$ or $-CO-N(H)-CH_2-$ |
| $L_1a$, $L_2a$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1a$ | N or P | N | N |
| $X_2a$ | ($n_3a$ + 1) Valent connecting group having total number of carbon atoms of 10 or less, provided that when $n_3a$ is 1, $X_2a$ represents single bond | Single bond | Single bond |
| $Y_1a$ | Sulfonate anion, $PF_6^-$, $BF_4^-$, $Cl^-$, $Br^-$ or $I^-$ | Alkylsulfonate anion which may have substituent, Aromatic sulfonate anion which may have substituent, $PF_6^-$, $BF_4^-$, $Cl^-$, $Br^-$ or $I^-$, | Fluorinated alkylsulfonate anion, Benzenesulfonate anion which may have substituent, $Cl^-$ or $Br^-$. |
| ($n_1a$, $n_2a$) | (1,2) or (2,1) | (2,1) | (2,1) |
| $n_3a$ | 1 to 2 | 1 | 1 |

In formula (II), the descriptions (including preferred embodiments) with respect to $R_1b$ to $R_3b$, $R_4b$, $R_5b$ to $R_7b$, $L_1b$, $L_2b$, $W_1b$ and $W_2b$ are same as the descriptions (including preferred embodiments) with respect to $R_1a$ to $R_3a$, $R_4a$, $R_5a$ to $R_7a$, $L_1a$, $L_2a$, $W_1a$ and $W_2a$ in formula (I), respectively.

The descriptions (including preferred embodiments) with respect to the ($n_2b$ + 1) valent connecting group for $X_1b$ are same as the descriptions (including preferred embodiments) with respect to the ($n_3a$ + 1) valent connecting group for $X_2a$ in formula (I) except for changing the ($n_3a$ + 1) valent to the ($n_2b$ + 1) valent.

The descriptions (including preferred embodiments) with respect to the alkyl group for $Y_1b$ are same as the descriptions (including preferred embodiments) with respect to the alkyl group for $R_4a$ in formula (I). A number of the hydroxy groups for $Y_1b$ in formula (II) is preferably from 1 to 3, and more preferably from 1 to 2. However, when $n_1b$ is 1, the number of the hydroxy groups for $Y_1b$ in formulae (II) is 1, and when $n_1b$ is 2, the number of the hydroxy groups for $Y_1b$ in formulae (II) is 1 or 2.

$n_1b$ is preferably from 1 to 5, more preferably from 1 to 3, and still more preferably from 1 to 2 $n_2b$ is preferably from 1 to 2, and more preferably 1.

With respect to the repeating unit represented by formula (II), preferable combinations of each partial stricture are set forth below.

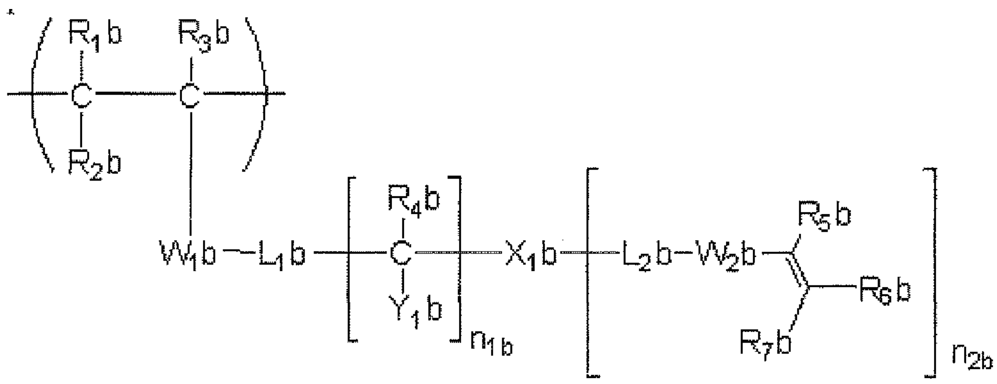

| | Preferable Combination | More Preferable Combination | Particularly Preferable Combination |
|---|---|---|---|
| $R_1b$, $R_2b$ | Hydrogen atom or Methyl group | Hydrogen atom | Hydrogen atom |
| $R_3b$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4b$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)$p-Rt group or Substituted or unsubstituted benzyl group | Methyl group, Ethyl group, Hydroxyethyl group or Substituted or unsubstituted benzyl group |
| $R_5b$ | Hydrogen atom, Methyl group, Hydroxymethyl group, Methoxymethyl group or Methylcarbonyloxy group | Hydrogen atom, Methyl group or Hydroxymethyl group | Hydrogen atom or Methyl group |
| $R_6b$, $R_7b$ | Hydrogen atom or Methyl group | Hydrogen atom | Hydrogen atom |
| $W_1b$ | 1,4-Phenylene group, -O-, -CO-, -N(Rw)- or Divalent connecting group composed of appropriate combination of these groups | -CO-O- or -CO-N(Rw)- | -CO-O-, -CO-N(H)- |
| $W_2b$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, -N(Rw)-CO-O-$CH_2$-, -N(Rw)-CO-N(Rw)-$CH_2$-, -CO-O-, -CO-N(Rw)-, -CO-O-$CH_2$-, -CO-N(Rw)-$CH_2$- or -O-CO-$CH_2$- | -CO-O-,-CO-N(H)-, -CO-O-$CH_2$- or -CO-N(H)-$CH_2$- |

(continued)

| | Preferable Combination | More Preferable Combination | Particularly Preferable Combination |
|---|---|---|---|
| $L_1b$, $L_2b$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(Rw)- or Divalent connecting group composed of appropriate combination of these groups | Single bond, Alkylene group having 6 or less carbon atoms, 1,4-Phenylene group, -O-, -CO-, -N(Rw)- or Divalent connecting group composed of appropriate combination of these groups |
| $X_1b$ | ($n_2b$ + 1) Valent connecting group having total number of carbon atoms of 10 or less, provided that when $n_2b$ is 1, $X_1b$ represents single bond | Single bond | Single bond |
| $Y_1b$ (other than hydroxy group) | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| Number of hydroxy group for $Y_1b$ in formula (II) | 1 to 3 (provided that when $n_1b$ is 1, the number of hydroxy group is I, and when $n_1b$ is 2, the number of hydroxy group is 1 or 2) | 1 to 2 (provided that when $n_1b$ is 1, the number of hydroxy group is 1, and when $n_1b$ is 2, the number of hydroxy group is 1 or 2) | 1 to 2 (provided that when $n_1b$ is 1, the number of hydroxy group is 1, and when $n_1b$ is 2, the number of hydroxy group is 1 or 2) |
| $n_1b$ | 1 to 5 | 1 to 3 | 1 to 2 |
| $N_2b$ | 1 to 2 | 1 | 1 |

In formula (III), the descriptions (including preferred embodiments) with respect to $R_1c$ to $R_3c$, $R_4c$, $R_5c$ to $R_7c$, $L_1c$, $L_2c$, $W_1c$ and $W_2c$ are same as the descriptions (including preferred embodiments) with respect to $R_1a$ to $R_3a$, $R_4m$ $R_5a$ to $R_7a$, $L_1a$, $L_2a$, $W_1a$ and $W_2a$ in formula (I), respectively. The descriptions (including preferred embodiments) with respect to $n_1c$ and $n_2c$ are same as the descriptions (including preferred embodiments) with respect to $n_1b$ and $n_2b$ in formula (II), respectively.

The descriptions (including preferred embodiments) with respect to the ($n_2c$ + 1) valent connecting group for $X_1c$ are same as the descriptions (including preferred embodiments) with respect to the ($n_2b$ + 1) valent connecting group for $X_1b$ in formulae (II) except for changing the ($n_2b$ + 1) valent to the ($n_2c$ + 1) valent.

The descriptions (including preferred embodiments) with respect to the alkyl group for $Y_1c$ are same as the descriptions (including preferred embodiments) with respect to the alkyl group for $R_4a$ in formula (I). A number of the group represented by $L_3c$-Q in formula (III) is preferably from 1 to 2, and more preferably 1.

The descriptions (including preferred embodiments) with respect to the divalent connecting group for $L_3c$ are same as the descriptions (including preferred embodiments) with respect to the divalent connecting group for $L_2a$ in formula (I).

Q is preferably -$SO_3M$, -$OPO(OM_1)(OM_2)$ or -$PO(OM_3)(OM_4)$, and more preferably $SO_3M$.

The monovalent metal ion for M includes elements in 1A group of the Periodic Table, preferably Li, Na or K, and more preferably, Na or K. $R_0$ each represents a hydrogen atom or an alkyl group. The descriptions (including preferred embodiments) with respect to the alkyl group are same as the descriptions (including preferred embodiments) with respect to the alkyl group for $R_4a$ in formula (I). $R_0$ is preferably a hydrogen atom, a methyl group, an ethyl group or a hydroxyethyl group.

M is preferably Na, K, $N^+H_4$, $N^+(CH_3)_4$, $N^+(H)(CH_3)_3$, $N^+(C_2H_5)_4$, $N^+(H)(C_2H_5)_3$, $N^+(H)_2(C_2H_5)_2$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$, more preferably Na, K, $N^+H_4$, $N^+(CH_3)_4$, $N^+(H)(CH_3)_3$, $N^+(C_2H_5)_4$, $N^+(H)(C_2H_5)_3$, $N^+(CH_2CH_2OH)_4$, $N^+(H)(CH_2CH_2OH)_3$, $N^+(H)_2(CH_2CH_2OH)_2$ or $N^+(H)_2(CH_2CH_2OH)$, and particularly preferably Na, K, $N^+H_4$, $N^+(CH_3)_4$, $N^+(C_2H_5)_4$, $N^+(H)(C_2H_5)_3$, $N^+(H)(CH_2CH_2OH)_3$ or $N^+(H)_2(CH_2CH_2OH)_2$.

The descriptions (including preferred embodiments) with respect to the monovalent metal ion for $M_1$ or $M_3$ and $N^+(R_0)_4$ are same as the descriptions (including preferred embodiments) with respect to the monovalent metal ion for M and $N^+(R_0)_4$, respectively.

The descriptions (including preferred embodiments) with respect to the monovalent metal ion for $M_2$ or $M_4$ and $N^+(R_0)_4$ are same as the descriptions (including preferred embodiments) with respect to the monovalent metal ion for M and $N^+(R_0)_4$, respectively.

With respect to the repeating unit represented by formula (III), preferable combinations of each partial stricture are set forth below.

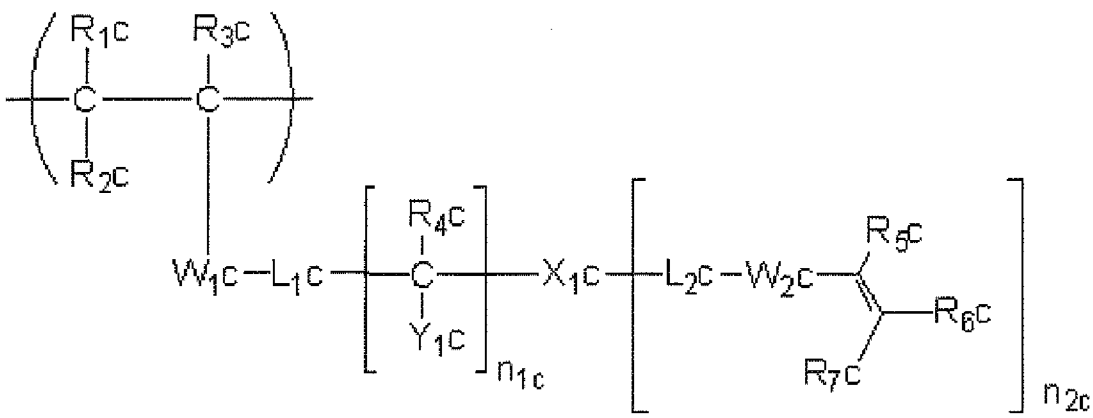

| | Preferable Combination | More Preferable Combination | Particularly Preferable Combination |
|---|---|---|---|
| $R_1c$, $R_2c$ | Hydrogen atom or Methyl group | Hydrogen atom | Hydrogen atom |
| $R_3c$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4c$ | Hydrogen atom, Methyl group, Ethyl group, n-Propyl group, n-Butyl group,-$(CH_2CH_2O)$p-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5c$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6c$, $R_7c$ | Hydrogen atom or Methyl group | Hydrogen atom | Hydrogen atom |

(continued)

| | Preferable Combination | More Preferable Combination | Particularly Preferable Combination |
|---|---|---|---|
| $W_1c$ | 1,4-Phenylene group, -O-, -CO-, -N(Rw)-or Divalent connecting group composed of appropriate combination of these groups | -CO-O- or -CO-N(Rw)- | -CO-O- or -CO-N(H)- |
| $W_2c$ | Alkylene group having 3 or less carbon atoms, 1,4-Phenylene group, -O-, -CO-, -N(Rw)- or Divalent connecting group composed of appropriate combination of these groups | $-O-CH_2-$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$ | -CO-O-, -CO-N(H)-, $-CO-O-CH_2-$or $-CO-N(H)-CH_2-$ |
| $L_1c$, $L_2c$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1c$ | ($n_2c$ + 1) Valent connecting group having total number of carbon atoms of 10 or less, provided that when $n_2c$ is 1, $X_1c$ represents single bond | Single bond | Single bond |
| $Y_1c$ (other than $L_3c$-Q) group | Hydrogen atom, Methyl group, Ethyl group, n-Propyl group, n-Butyl group,$-(CH_2CH_2O)_p-Rt$ group or Aralkyl group | Methyl group, Ethyl group, $-(CH_2CH_2O)_p-Rt$ group or Substituted or unsubstituted benzyl group | Methyl group, Ethyl group, Hydroxyethyl group or Substituted or unsubstituted benzyl group |
| $L_3c$-Q group in $Y_1c$ | $L_3$: Alkylene group having 10 or less carbon atoms, Arylene group, Cycloalkylene group having 10 or less carbon atoms, -O-, -CO-, -N(Rw)- or Divalent connecting group composed of appropriate combination of these groups Q: $-SO_3M$, $-OPO(OM_1)(OM_2)$ or $-PO(OM_3)(OM_4)$ | $L_3$: Alkylene group having 6 or less carbon atoms, 1,4-Phenylene group, -O-, -CO-, -N(H)- or Divalent connecting group composed of appropriate combination of these groups Q: $-SO_3M$ | $L_3$: Alkylene group having 6 or less carbon atoms, 1,4-Phenylene group, -O-, -CO-, -N(H)- or Divalent connecting group composed of appropriate combination of these groups Q: $-SO_3M$ |

(continued)

| | Preferable Combination | More Preferable Combination | Particularly Preferable Combination |
|---|---|---|---|
| M | Na, K, $N^+H_4$, $N^+(CH_3)_4$, $N^+(H)(CH_3)_3$, $N^+(C_2H_5)_4$, $N^+(H)(C_2H_5)_3$, $N^+(H)_2(C_2H_5)_2$, $N^+(CH_2CH_2OH_4)_4$, $N^+(H)(CH_2CH_2OH)_3$, $N^+(H)_2(CH_2CH_2OH)_2$ or $N^+(H)_3(CH_2CH_2OH)$ | Na, K, $N^+H_4$ $N^+(CH_3)_4$, $N^+(H)(CH_3)_3$, $N^+(C_2H_5)_4$, $N^+(H)(C_2H_5)_3$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$ | Na, K, $N^+H_4$, $N^+(CH_3)_4$, $N^+(C_2H_5)_4$, $N^+(H)(C_2H_5)3$, $N^+(H)(CH_2CH_2OH)_3$ or $N^+(H)_2(CH_2CH_2OH)_2$ |
| $M_1$, $M_3$ | ditto | ditto | ditto |
| $M_2$, $M_4$ | ditto | ditto | ditto |
| Number of | 1 to 2 (provided that when $n_1c$ is 1, the | 1 | 1 |
| $L_3c$-Q group in formula (III) | number of $L_3c$-Q group is 1) | | |
| $n_1c$ | 1 to 5 | 1 to 3 | 1 to 2 |
| $n_2c$ | 1 to 2 | 1 | 1 |

In formula (IV), the descriptions (including preferred embodiments) with respect $R_1d$ to $R_3d$, $R_4d$, $R_5d$ to $R_3d$, $L_1d$, $L_2d$, $W_1d$, $W_2d$, $n_3d$ and $X_1d$ are same as the descriptions (including preferred embodiments) with respect to $R_1a$ to $R_3a$, $R_4a$, $R_5a$ to $R_7a$, $L_1a$, $L_2a$, $W_1a$, $W_2a$, $n_3a$ and $X_1a$ in formula (I), respectively.

The descriptions (including preferred embodiments) with respect to the divalent connecting group for $L_3d$ are same as the descriptions (including preferred embodiments) with respect to the divalent connecting group for $L_3c$ in formula (III).

The descriptions (including preferred embodiments) with respect to the ($n_3d$ + 1) valent connecting group for $X_2d$ are same as the descriptions (including preferred embodiments) with respect to the ($n_2b$ + 1) valent connecting group for $X_1b$ in formula (II) except for changing the ($n_2b$ + 1) valent to the ($n_3d$ + 1) valent.

$Y_1d$ is preferably $-CO_2^-$, $-SO_3^-$ or $-OPO(O^-)(ORp)$, and more preferably $-CO_2^-$ or $-SO_3^-$.

The descriptions (including preferred embodiments) with respect to the alkyl group for Rp are same as the descriptions (including preferred embodiments) with respect to the alkyl group for $R_4a$ in formula (1). Rp is preferably a methyl group, an ethyl group, an n-propyl group, an n-butyl group or a $-(CH_2CH_2O)_v$-Rv group (wherein v represents an integer from 1 to 4 and Rv represents a methyl group or an ethyl group), and more preferably a methyl group, an ethyl group or a $-(CH_2CH_2O)_v$-Rv group. $n_1d$ and $n_2d$ are preferably that ($n_1d$, $n_2d$) is (0, 2) or (1,1).

With respect to the repeating unit represented by formula (IV), preferable combinations of each partial stricture are set forth below.

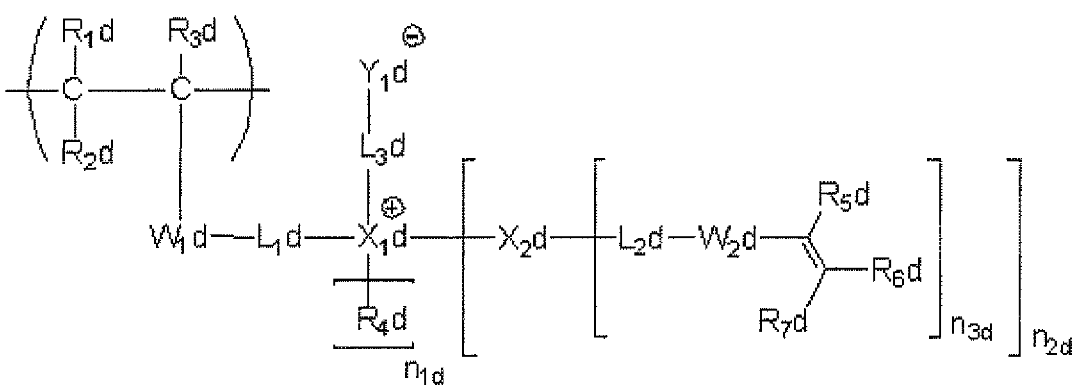

| | Preferably Combination | More Preferable Combination | Particularly Preferable Combination |
|---|---|---|---|
| $R_1d$, $R_2d$ | Hydrogen atom or Methyl group | Hydrogen atom | Hydrogen atom |
| $R_3d$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4d$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5d$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6d$, $R_7d$ | Hydrogen atom or Methyl group | Hydrogen atom | Hydrogen atom |
| $W_1d$ | 1,4-phenylene group, -O-, -CO-, -N(Rw)- or Divalent connecting group composed of appropriate combination of these groups | -CO-O-or-CO-N(Rw)- | -CO-O-or-CO-N(H)- |
| $W_2d$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, N (Rw)-CO-O-$CH_2$-, -N(Rw)-CO-N (Rw)-$CH_2$-, -CO-O-, -CO-N (Rw)-, -CO-O-$CH_2$-, -CO-N (Rw)-$CH_2$- or -O-CO-$CH_2$- | -CO-O-, -CO-N(H)-, -CO-O-$CH_2$- or -CO-N(H)-$CH_2$- |
| $L_1d$, $L_2d$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $L_3d$ | Alkylene group having 10 or less carbon atoms, Arylene group, Cycloalkylene group having 10 or less carbon atoms, -O-, -CO-, -N(Rw)- or Divalent connecting group composed of appropriate combination of these groups | Alkylene group having 6 or less carbon atoms, 1,4-Phenylene group, -O-, -CO-, -N(H)- or Divalent connecting group composed of appropriate combination of these groups | Alkylene group having 6 or less carbon atoms, 1,4-Phenylene group, -O-, -CO-, -N(H)- or Divalent connecting group composed of appropriate combination of these groups |
| $X_1d$ | N or P | N | N |
| $X_2d$ | ($n_3d$ + 1) Valent connecting group having total number of carbon atoms of 10 or less, provided that when $n_3d$ is 1, $X_2d$ represents single bond | Single bond | Single bond |
| $Y_1d^-$ | -$CO_2^-$, -$SO_3^-$ or -OPO($O^-$)(ORp) | -$CO_2^-$ or -$SO_3^-$ | -$CO_2^-$ or -$SO_3^-$ |
| ($n_1d$, $n_2d$) | (0,2) or (1,1) | (0,2) or (1,1) | (0,2) or (1,1) |

(continued)

| | Preferably Combination | More Preferable Combination | Particularly Preferable Combination |
|---|---|---|---|
| $n_3d$ | 1 our 2 | 1 | 1 |

In formula (V), the descriptions (including preferred embodiments) with respect to $R_1e$ to $R_3e$, $R_4e$, $R_5e$ to $R_7e$, $W_1e$, $W_2e$ and $X_1e$ are same as the descriptions (including preferred embodiments) with respect to $R_1a$ to $R_3a$, $R_4a$, $R_5a$ to $R_7a$, $W_1a$, $W_2a$ and $X_1a$ in formula (I), respectively. The descriptions (including preferred embodiments) with respect to $L_1e$ to $L_3e$ in the formula (V) are same as the descriptions (including preferred embodiments) with respect to $L_1a$ in formula (I).

The descriptions (including preferred embodiments) with respect to the ($n_1e$ + 1) valent connecting group for $X_2e$ are same as the descriptions (including preferred embodiments) with respect to the ($n_2b$ +1) valent connecting group for $X_1b$ in formula (II) except for changing the ($n_2b$ + 1) valent to the ($n_1e$+1) valent.

With respect to the repeating unit represented by formula (V), preferable combinations of each partial stricture are set forth below.

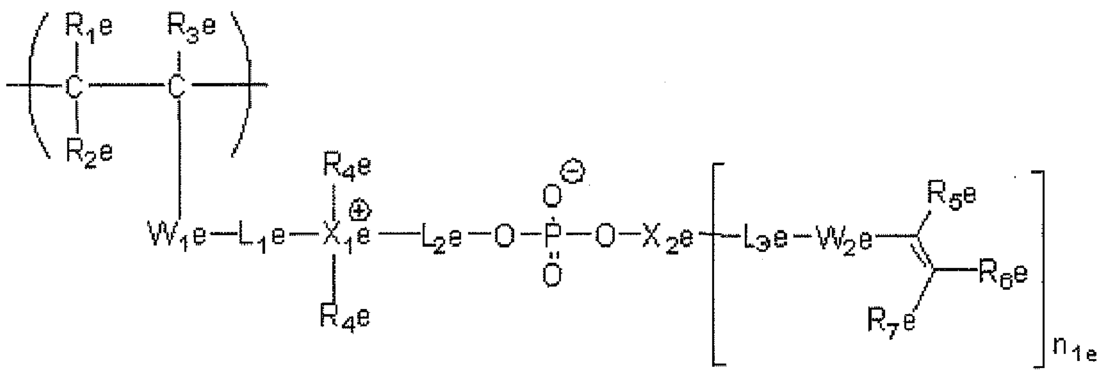

| | Preferable Combination | More Preferable Combination | Particularly Preferable Combination |
|---|---|---|---|
| $R_1e$, $R_2e$ | Hydrogen atom or Methyl group | Hydrogen atom | Hydrogen atom |
| $R_3e$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4e$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5e$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6e$, $R_7e$ | Hydrogen atom or Methyl group | Hydrogen atom | Hydrogen atom |

(continued)

| | Preferable Combination | More Preferable Combination | Particularly Preferable Combination |
|---|---|---|---|
| $W_1e$ | 1,4-Phenylene group, -O-, -CO-, -N(Rw)- or Divalent connecting group composed of appropriate combination of these groups | -CO-O- or -CO-N(Rw)- | -CO-O- or-CO-N(H)- |
| $W_2e$ | Alkylene group having 3 or less carbon atoms, 1,4-Phenylene group, -O-, -CO-, -N(Rw)- or Divalent connecting group composed of appropriate combination of these groups | $-O-CH_2$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$ | -CO-O-, -CO-N(H)-, $-CO-O-CH_2-$ or $-CO-N(H)-CH_2-$ |
| $L_1e$, $L_2e$, $L_3e$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1e$ | N or P | N | N |
| $X_2e$ | ($n_1e$ +1) Valent connecting group having total number of carbon atoms of 10 or less, provided that when $n_1e$ is 1, $X_2e$ represents single bond | ($n_1e$ + 1) Valent connecting group having total number of carbon atoms of 5 or less, provided that when $n_1e$ is 1, $X_2e$ represents single bond | ($n_1e$ + 1) Valent connecting group having total number of carbon atoms of 5 or less, provided that when $n_1e$ is 1, $X_2e$ represents single bond |
| $n_1e$ | 1 or 2 | 1 or 2 | 1 or 2 |

In formula (VI), the descriptions (including preferred embodiments) with respect to $R_1f$ to $R_3f$, $R_4f$, $R_5f$ to $R_7f$, $W_1f$, $W_2f$, $X_1f$, $X_2f$ and $n_3f$ are same as the descriptions (including preferred embodiments) with respect to $R_1a$ to $R_3a$, $R_4a$, $R_5a$ to $R_7a$, $W_1a$, $W_2a$, $X_1a$, $X_2a$ and $n_3a$ in formula (I), respectively. The descriptions (including preferred embodiments) with respect to $L_1f$ to $L_3f$ in formula (VI) are same as the descriptions (including preferred embodiments) with respect to $L_1a$ in formula (I). $n_1f$ and $n_2f$ are preferably that ($n_1f$, $n_2f$) is (0, 3), (1, 2) or (2,1).

The descriptions (including preferred embodiments) with respect to the ($n_3f$ + 1) valent connecting group for $X_2f$ are same as the descriptions (including preferred embodiments) with respect to the ($n_2b$ + 1) valent connecting group for $X_1b$ in formula (II) except for changing the ($n_2b$ + 1) valent to the ($n_3f$ + 1) valent.

With respect to the repeating unit represented by formula (VI), preferable combinations of each partial stricture are set forth below.

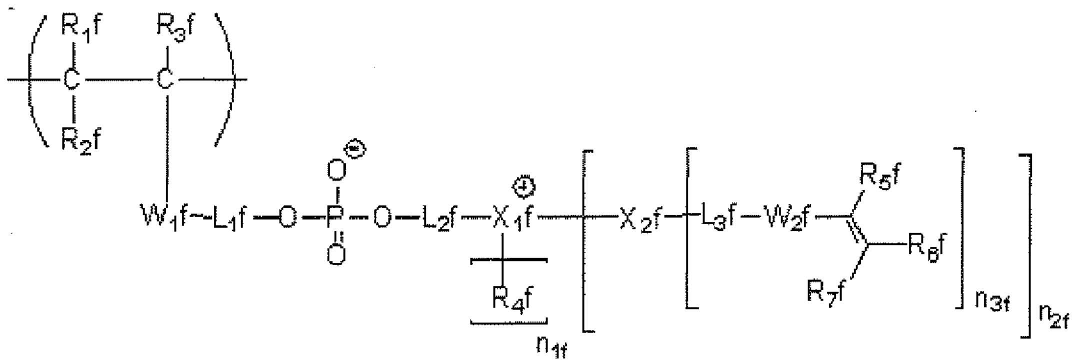

| | Preferable Combination | More Preferable Combination | Particularly Preferable Combination |
|---|---|---|---|
| $R_1f$, $R_2f$ | Hydrogen atom or Methyl group | Hydrogen atom | Hydrogen atom |
| $R_3f$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4f$ | Hydrogen atom, Methyl group, Ethyl group, n-Propyl group, n-Butyl group,-$(CH2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group, |
| $R_5f$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6f$, $R_7f$ | Hydrogen atom or Methyl group | Hydrogen atom | Hydrogen atom |
| $W_1f$ | 1,4-Phenylene group, -O-, -CO-, -N(Rw)- or Divalent connecting group composed of appropriate combination of these groups | -CO-O- or -CO-N(Rw)- | -CO-O- or -CO-N(H)- |
| $W_2f$ | Alkylene group having 3 or less carbon atoms, 1,4-Phenylene group, -O-, -CO-, -N(Rw)- or Divalent connecting group composed of appropriate combination of these groups | -4-$CH_2$-, -N(Rw)-$CH_2$-, -O-CO-O-$CH_2$-, -O-CO-N(Rw)-$CH_2$-, -N(Rw)-CO-O-$CH_2$, -N(Rw)-CO-N(Rw)-$CH_2$-, -CO-O-, -CO-N(Rw)-, -CC-O-$CH_2$-, -CO-N(Rw)-$CH_2$- or -O-CO-$CH_2$- | -CO-O-, -CO-N(H)-, -CO-O-$CH_2$- or -CO-N(H)-$CH_2$- |
| $L_1f$, $L_2f$, $L_3f$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1f$ | N or P | N | N |

(continued)

| | Preferable Combination | More Preferable Combination | Particularly Preferable Combination |
|---|---|---|---|
| $X_2f$ | ($n_3f$ + 1) Valent connecting group having total number of carbon atoms of 10 or less, provided that when $n_3f$ is 1, $X_2f$ represents single bond | Single bond | Single bond |
| ($n_1f$, $n_2f$) | (0,3), (1,2) or (2,1) | (0, 3), (1, 2) or (2, 1) | (0,3), (1, 2) or (2, 1) |
| $n_3f$ | 1 or 2 | 1 | 1 |

It is preferred in view of adjustment of hydrophilicity, ease of production or the like that $W_1a$ is -CO-O- or -CO-N(Rw)- and $X_1a$ is N in formula (I), $W_1b$ is -CO-O- or -CO-N(Rw)- in formula (I), $W_1c$ is -CO-O- or -CO-N(Rw)- and Q is $-SO_3M$, $-OPO(OM_1)(OM_2)$ or $-PO(OM_3)(OM_4)$in formula (III), $W_1d$ is -CO-O- or -CO-N(Rw)-, $X_1d$ is N and $Y_1d^-$ is $-CO_2^-$, $-SO_3^-$ or $-OPO(O^-)(ORp)$ in formula (VI), $W_1e$ is -CO-O- or -CO-N(Rw)- and $X_1e$ is N in formula (V), or $W_1f$ is -CO-O- or -CO-N(Rw)- and $X_1f$ is N in formula (VI).

Specific examples of the repeating unit represented by formula (I) are set forth below together with the C log P value of a monomer (only a cation component thereof) which is a precursor of each repeating unit. Hereinafter, "Ts" represents a tosyl group (p-toluenesulfonyl group: $p-CH_3C_6H_4SO_2-$).

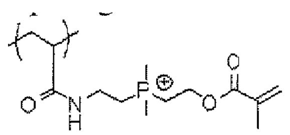 $Br^{\ominus}$ -0.41

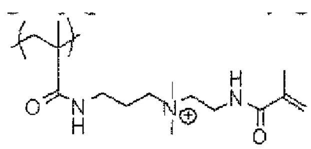 $Br^{\ominus}$ -2.22

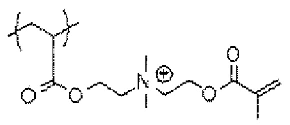 $TsO^{\ominus}$ -0.44

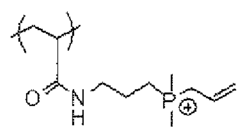 $Br^{\ominus}$ -2.22

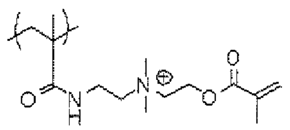 $TsO^{\ominus}$ -1.15

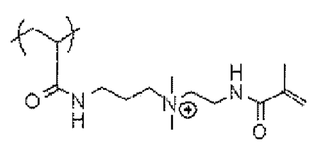 $Br^{\ominus}$ -2.53

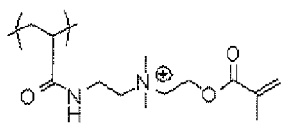 $TsO^{\ominus}$ -1.46

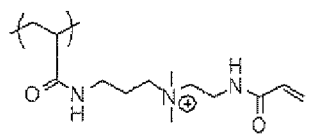 $Br^{\ominus}$ -2.84

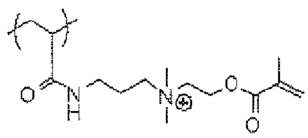 $TsO^{\ominus}$ -1.51

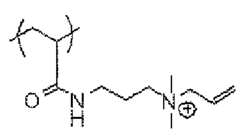 $Br^{\ominus}$ -3.33

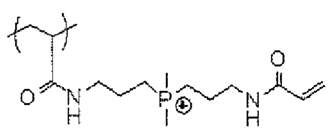 $Br^{\ominus}$ -1.83

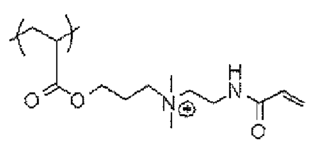 $Br^{\ominus}$ -1.73

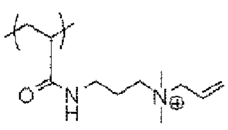

$CF_3SO_3^{\ominus}$ -3.33

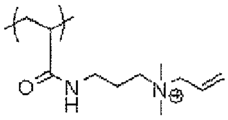

$TsO^{\ominus}$ -3.33

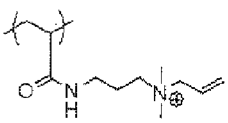

$PF_6^{\ominus}$ -3.33

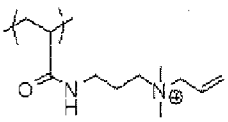

$Cl^{\ominus}$ -3.33

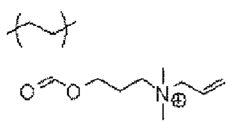

$Br^{\ominus}$ -2.19

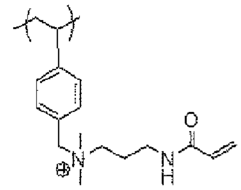

$Cl^{\ominus}$ -0.94

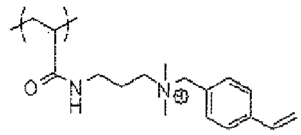

$Cl^{\ominus}$ -0.94

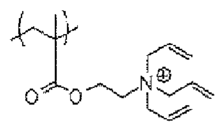

$Br^{\ominus}$ -0.37

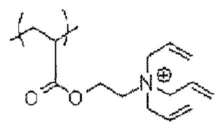

$Br^{\ominus}$ -0.68

Specific examples of the repeating unit represented by formula (II) are set forth below together with the C log P value of a monomer which is a precursor of each repeating unit.

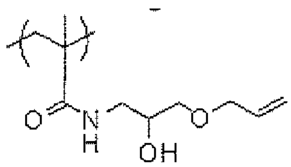

-0.15

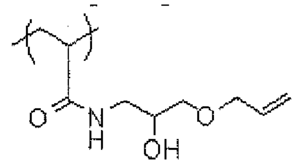

-0.46

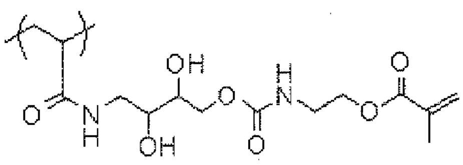

-0.15

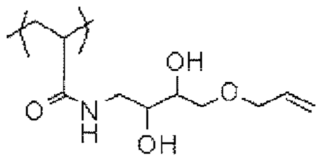

-0.50

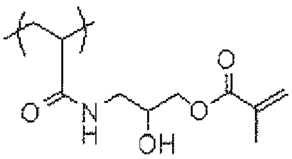

-0.18

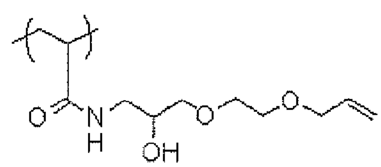

-0.59

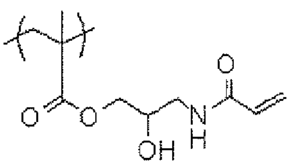

-0.18

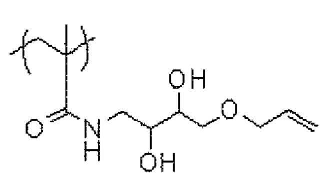

-0.19

Specific examples of the repeating unit represented by formula (III) are set forth below together with the C log P value of a monomer (only an anion component thereof) which is a precursor of each repeating unit.

| | | |
|---|---|---|
| 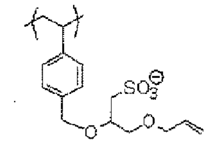 | $Na^{\oplus}$ | -1.80 |
| 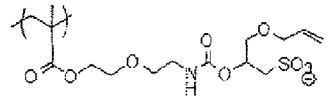 | $Na^{\oplus}$ | -2.91 |
| 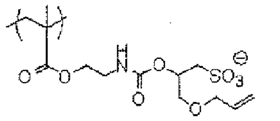 | $Na^{\oplus}$ | -2.97 |
| 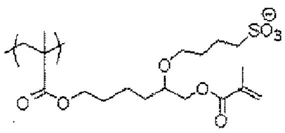 | $Na^{\oplus}$ | -3.06 |
| 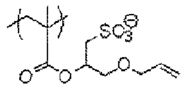 | $Na^{\oplus}$ | -3.29 |
| 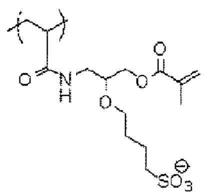 | $Na^{\oplus}$ | -5.27 |
| 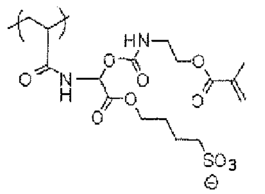 | $Na^{\oplus}$ | -5.55 |
| 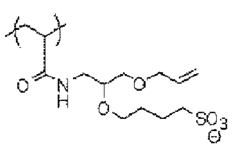 | $Na^{\oplus}$ | -5.75 |
| 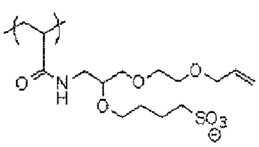 | $Na^{\oplus}$ | -5.88 |
| 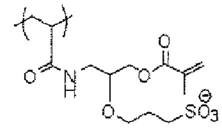 | $Na^{\oplus}$ | -4.0 |
| 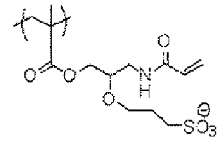 | $Na^{\oplus}$ | -4.0 |
| 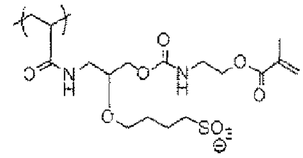 | $Na^{\oplus}$ | -5.19 |
| 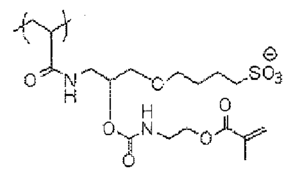 | $Na^{\oplus}$ | -5.20 |
| 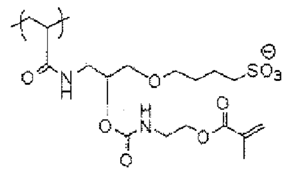 | $K^{\oplus}$ | -5.20 |
| 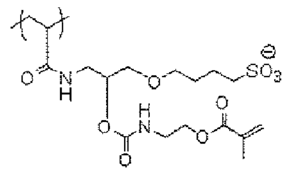 | $^{\oplus}NH_4$ | -5.20 |
| 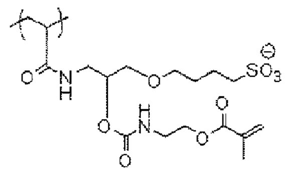 | $^{\oplus}N(CH_3)_4$ | -5.20 |
| 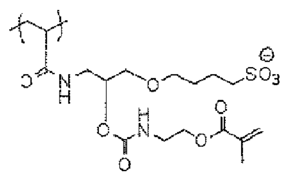 | $^{\oplus}HN(CH_2CH_2OH)_3$ | -5.20 |

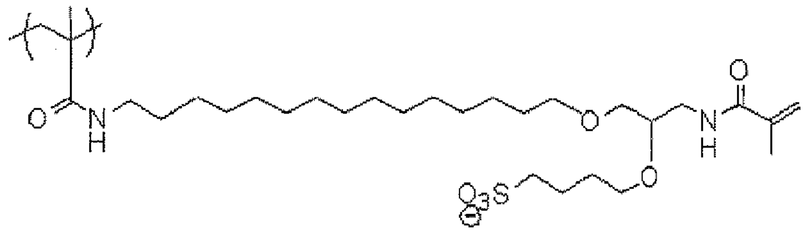

-0.30

Specific examples of the repeating unit represented by formula (IV) are set forth below together with the C log P value of a monomer which is a precursor of each repeating unit.

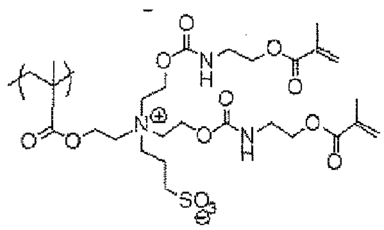

-0.81

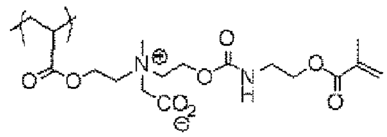

-1.47

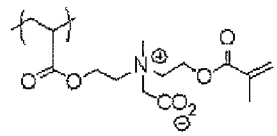

-1.55

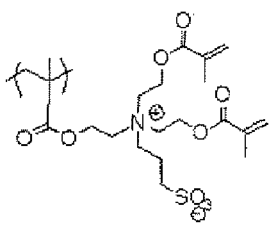

-0.97

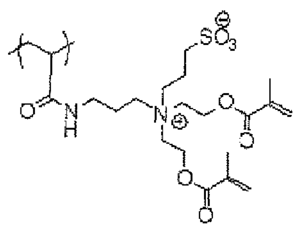

-2.35

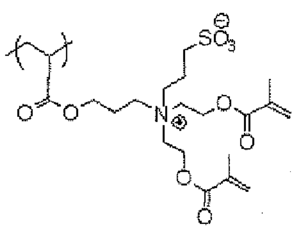

-1.25

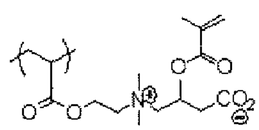

-3.69

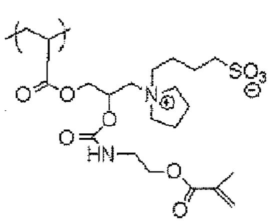

-6.32

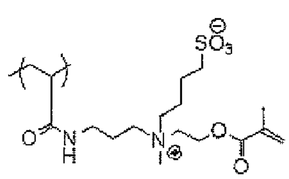

-7.27

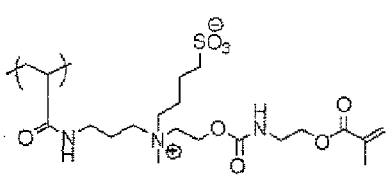

-7.19

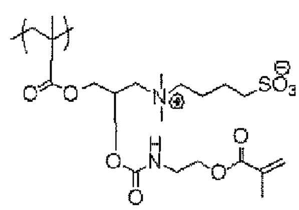

-7.49

Specific examples of the repeating unit represented by formula (V) are set forth below together with the C log

P value of a monomer which is a precursor of each repeating unit.

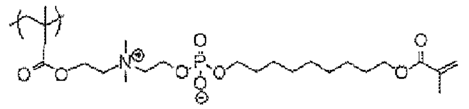
-3.64

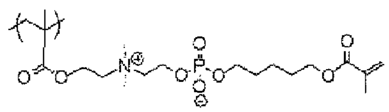
-6.76

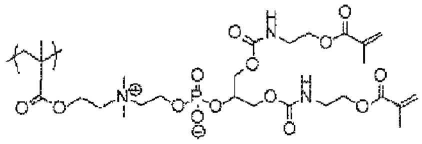
-6.75

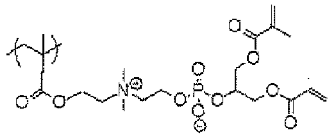
-6.80

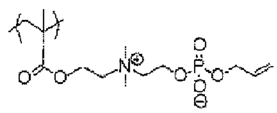
-7.18

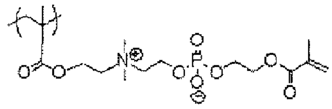
-7.34

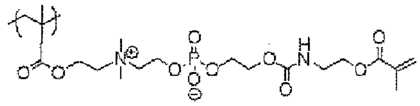
-7.50

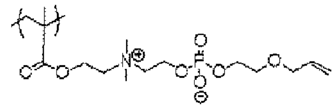
-7.86

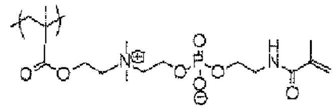
-8.72

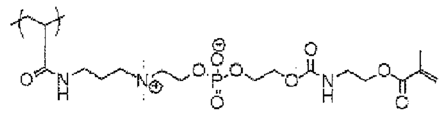
-8.88

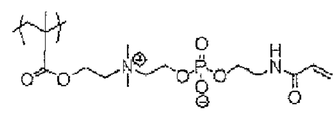
-9.03

Specific examples of the repeating unit represented by formula (VI) are set forth below together with the C log P value of a monomer which is a precursor of each repeating unit.

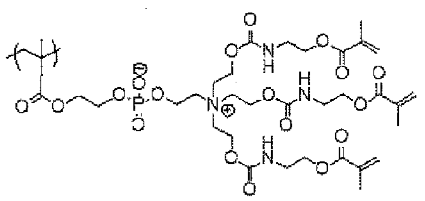
-1.88

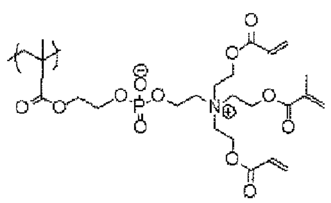
-2.21

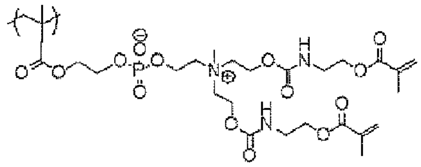
-4.62

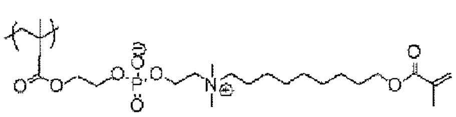
-5.79

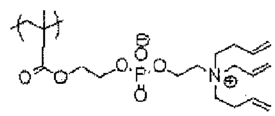
-6.93

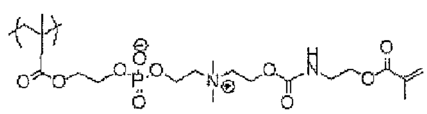
-7.26

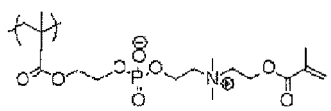
-7.34

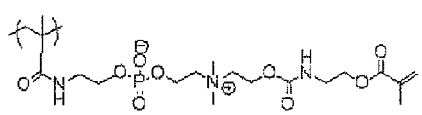
-8.64

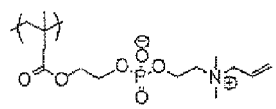
-9.13

The molar ratio of the repeating unit (d1) in the specific copolymer is ordinarily from 1 to 95% by mole, preferably from 2 to 90% by mole, and more preferably from 4 to 80% by mole. When the molar ratio is less than 1% by mole, the

effects of the invention are not sufficiently exhibited. When it exceeds 95% by mole, the printing durability, UV ink printing durability and chemical resistance are deteriorated although the stain resistance in the non-image area is good.

The specific copolymer according to the invention preferably contains (d2) a repeating unit having a functional group capable of interacting with a surface of support and (d3) a repeating unit having a hydrophilic group in addition to the repeating unit (d1). Further, the specific copolymer according to the invention may contain (d4) a repeating unit having at least one ethylenically unsaturated bond, which does not correspond to the repeating unit (d1).

(d2) Repeating unit having functional group capable of interacting with surface of support

The functional group capable of interacting with a surface of support in the repeating unit (hereinafter, also referred to as "repeating unit (d2)") having a functional group capable of interacting with a surface of support includes, for example, a group capable of forming a covalent bond, an ionic bond, a hydrogen bond or the like or a group capable of undergoing interaction, for example, polar interaction, with metal, a metal oxide, a hydroxy group or the like present on a support subjected to anodizing treatment or hydrophilizing treatment.

Specific examples of the functional group capable of interacting with a surface of support are set forth below.

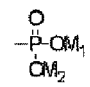
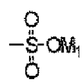
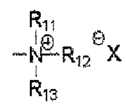
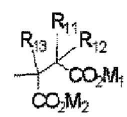
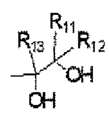
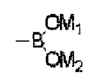
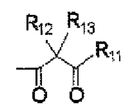

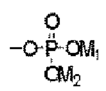
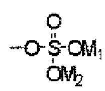
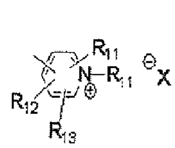
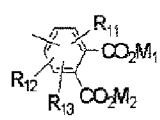
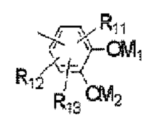
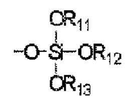
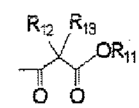

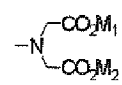

In the formulae above, $R_{11}$ to $R_{13}$ each independently represents a hydrogen atom, an alkyl group, an aryl group, an alkynyl group or an alkenyl group, $M_1$ and $M_2$ each independently represents a hydrogen atom, a metal atom or an ammonium group, and X" represents a counter anion.

As the functional group capable of interacting with a surface of support, for example, a sulfonic acid group or a salt thereof, a phosphoric acid ester group or a salt thereof, a phosphonic acid group or a salt thereof, a boric acid group, a β-diketone group, for example, an acetylacetone group, or an onium salt group, for example, an ammonium group and a pyridinium group is preferably used.

A sulfonic acid group or a salt thereof, a phosphoric acid ester group or a salt thereof, or a phosphonic acid group or a salt thereof is more preferred.

Of the repeating units (d2), repeating units represented by formula (d2a) or (d2b) shown below are preferred.

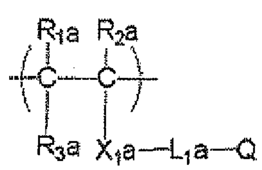
(d2a)

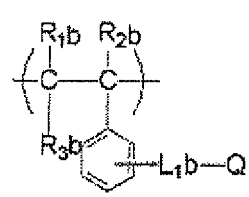
(d2b)

In formulae (d2a) and (d2b), $R_1a$ to $R_3a$ each independently represents a hydrogen atom, an alkyl group having from 1 to 6 carbon atoms, $-CH_2-OH$, $-CH_2-OR_{112}$, $-CH_2-O-CO-R_{112}$ or a halogen atom, in which $R_{112}$ represents an alkyl group having from 1 to 10 carbon atoms, an aryl group having from 6 to 10 carbon atoms or an aralkyl group having from 7 to 20 carbon atoms. $X_1a$ represents -O-, -CO-, -CO-O-, -O-CO-, $-NR_{500}-$, $-NR_{500}-CO-$ or $-CO-NR_{500}-$. $R_{500}$ represents a hydrogen atom, an alkyl group, an aryl group or an aralkyl group. $L_1a$ represents -CO-, -O-, $-NR_{500}-$, -S-, a divalent aliphatic group, a divalent aromatic group or a divalent connecting group composed of a combination of these groups. Q represents a functional group capable of interacting with a surface of support. $R_1b$ to $R_3b$ each independently represents a hydrogen atom, an alkyl group having from 1 to 6 carbon atoms, $-CH_2-OH$, $-CH_2-OH_{112}$, $-CH_2-O-CO-R_{112}$

or a halogen atom. $L_1b$ represents -CO-, -O-, $NR_{500}$-, -S-, a divalent aliphatic group, a divalent aromatic group or a divalent connecting group composed of a combination of these groups.

In formulae (d2a) and (d2b), $R_1a$, $R_2a$, $R_1b$, $R_2b$ each independently represents preferably a hydrogen atom, a methyl group or an ethyl group, and more preferably a hydrogen atom.

$R_3a$ and $R_3b$ each independently represents preferably a hydrogen atom, a methyl group, $-CH_2-OH$ or $-CH_2-O-CO-(C_1$- to $C_4$-alkyl), and more preferably a hydrogen atom, a methyl group, $-CH_2-OH$ or $-CH_2-O-CO-CH_3$.

$X_1a$ represents preferably -CO-O- or -CO-$NR_{500}$-, and more -CO-O- or -CO-NH-.

$L_1a$ and $L_1b$ each independently represents preferably -O-, -S-, -CO-O-, -O-CO-, -CO-$NR_{500}$-, -$NR_{500}$-CO-, a divalent aliphatic group or a divalent connecting group composed of a combination of these groups, and more preferably -CO-O-, -O-CO-, -CO-NH-, -NH-CO-, a divalent aliphatic group or a divalent connecting group composed of a combination of these groups.

Q represents preferably a phosphoric acid ester group or a salt thereof, a phosphonic acid group or a salt thereof, a sulfonic acid group or a salt thereof, a dicarboxylic acid (for example, imininodiacetic acid or phthalic acid) group or a salt thereof, or an ammonium group, and more preferably a phosphoric acid ester group or a salt thereof, a phosphonic acid group or a salt thereof, or an ammonium group.

Specific examples of the repeating unit represented by formula (d2a) or (d2b) are set forth below, but the invention should not be construed as being limited thereto. In the specific examples shown below, when a number of repeating unit of ethyleneoxy groups is indicated as "4.5"; the repeating unit means a mixture of repeating units wherein an average of the number of repeating unit of ethyleneoxy groups is 4.5.

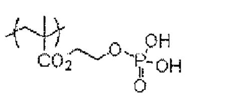
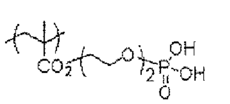
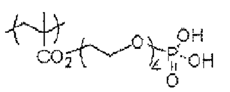
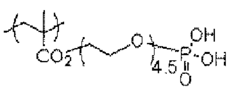
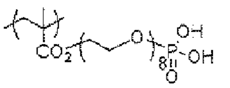
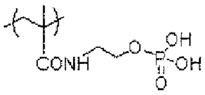
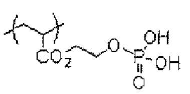
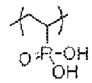
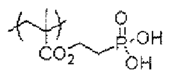
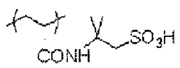
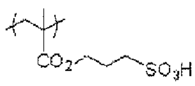
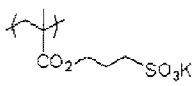
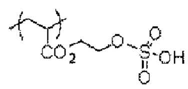
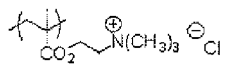
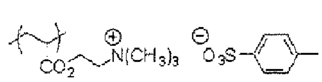
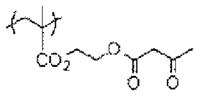
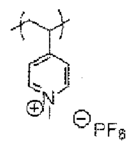
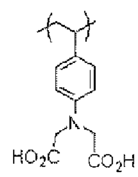
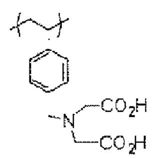
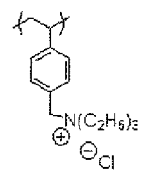
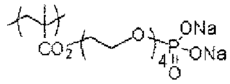
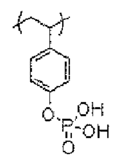
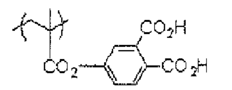
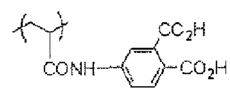

Of the repeating units (d2), in particular, those having as the functional group capable of interacting with a surface of support, a sulfonic acid group or a salt thereof, a phosphoric acid ester group or a salt thereof, or a phosphonic acid group or a salt thereof are preferred, and those having a phosphoric acid ester group or a salt thereof, or a phosphonic acid group or a salt thereof are more preferred.

The molar ratio of the repeating unit (d2) in the specific copolymer is ordinarily from 1 to 95% by mole, preferably from 5 to 90% by mole, and more preferably from 10 to 80% by mole.

(d3) Repeating unit having hydrophilic group

A hydrophilic group in the repeating unit (hereinafter, also referred to as "repeating unit (d3)") having a hydrophilic group includes, for example, a sulfonic acid group or a salt thereof, a carboxylic acid group or a salt thereof, an amido group, an ammonium group and a poly(ethyleneoxy) group.

Of the repeating units (d3), repeating units represented by formula (d3a) or (d3b) shown below are preferred.

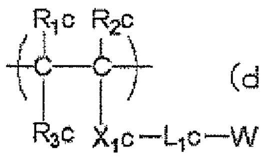 (d3a) 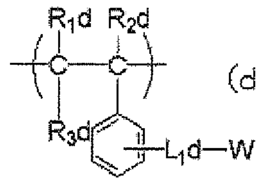 (d3b)

In formulae (d3a) and (d3b), $R_1$c to $R_3$c have the same meanings as $R_1$a to $R_3$a defined in formula (d2a) respectively. $X_1$c has the same meaning as $X_1$a defined in formula (d2a). $L_1$c has the same meaning as $L_1$a defined in formula (d2a). $R_1$d to $R_3$d have the same meanings as $R_1$b to $R_3$b defined in formula (d2b) respectively. $L_l$d has the same meaning as $L_1$b defined in formula (d2b). W represents a sulfonic acid group or a salt thereof, a carboxylic acid group or a salt thereof, an amido group, an ammonium group or a poly(ethyleneoxy) group.

In formulae (d3a) and (d3b), $R_1$c, $R_2$c, $R_1$d, $R_2$d each independently represents preferably a hydrogen atom, a methyl group or an ethyl group, and more preferably a hydrogen atom.

$R_3$c and $R_3$d each independently represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$X_1$c represents preferably -CO-O- or-CO-$NR_{500}$-, and more -CO-O- or-CO-NH-.

$L_1$c and $L_1$d each independently represents preferably -O-, -S-, -CO-O-, -O-CO-, -CO-$NR_{500}$-, -$NR_{500}$-CO-, a divalent aliphatic group or a divalent connecting group composed of a combination of these groups, and more preferably -CO-O-, -O-CO-, -CO-NH-, -NH-CO-, a divalent aliphatic group or a divalent connecting group composed of a combination of these groups.

W represents preferably a sulfonic acid group or a salt thereof, a carboxylic acid group or a salt thereof, an amido group or an ammonium group, and more preferably a sulfonic acid group or a salt thereof, a carboxylic acid salt group, an amido group or an ammonium group.

Specific examples of the repeating unit represented by formula (d3a) or (d3b) are set forth below, but the invention should not be construed as being limited thereto. In the specific examples shown below, when a number of repeating unit of ethyleneoxy groups is indicated as "4.5", the repeating unit means a mixture of repeating units wherein an average of the number of repeating unit of ethyleneoxy groups is 4.5.

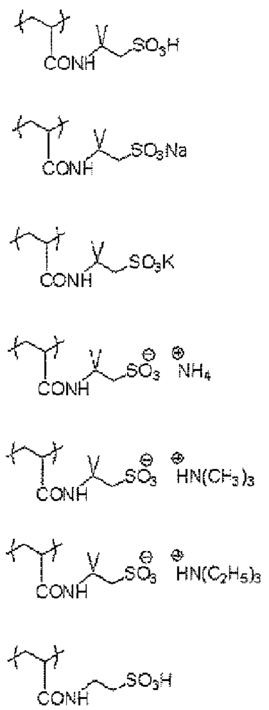
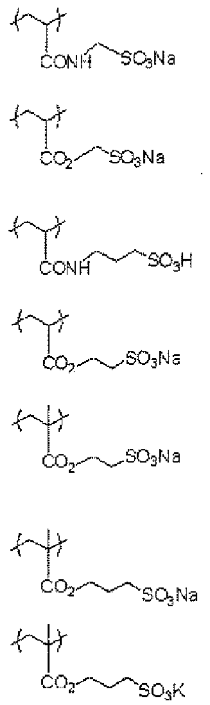
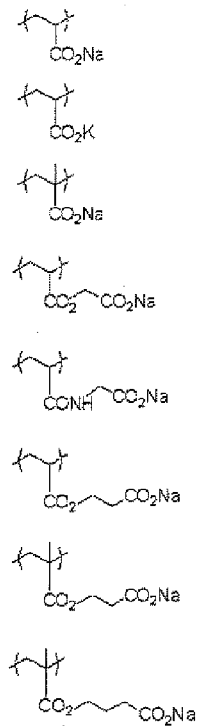
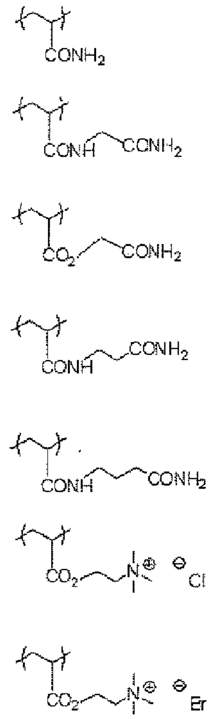
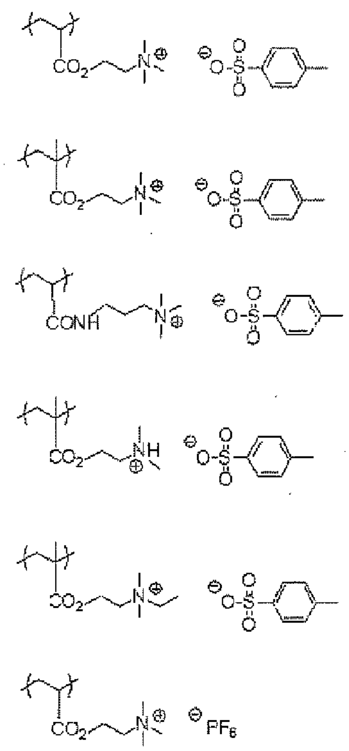
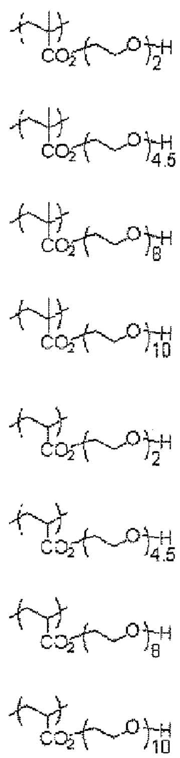
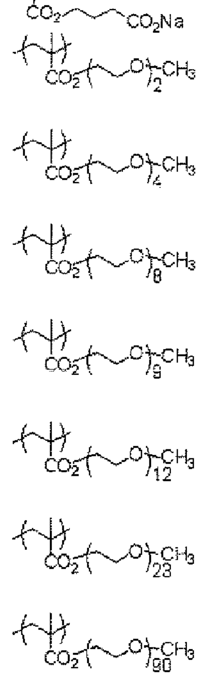
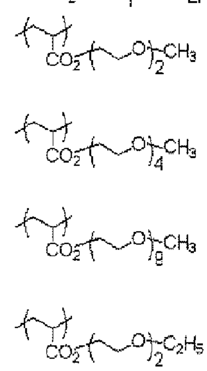
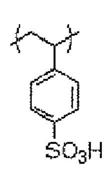
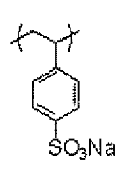
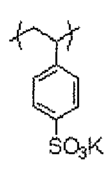
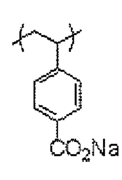
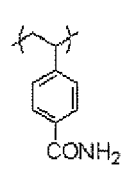
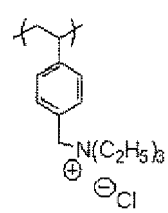

Moreover, as the repeating unit having a hydrophilic group, a repeating unit having a zwitterionic group is also

preferred.

The zwitterionic group means a group which has a positive charge and a negative charge and is neutral on the whole. The zwitterionic group preferably includes a group represented by formula (i) or (ii) shown below. From the standpoint of printing durability, the zwitterionic group is more preferably the group represented by formulae (i). In formula (i) or (ii), the left side indicates a site connecting to a main chain or side chain of the polymer.

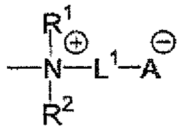

(i)

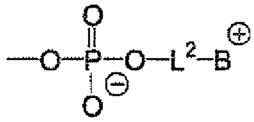

(ii)

In formulae (i) and (ii), $R^1$ and $R^2$ each independently represents a hydrogen atom or a substituent having from 1 to 30 carbon atoms, $L^1$ and $L^2$ each independently represents an organic connecting group, A represents a carboxylate or a sulfonate, and B represents a substituent having a positive charge.

In formula (i), $R^1$ and $R^2$ each independently represents a hydrogen atom or a substituent having from 1 to 30 carbon atoms. The substituent having from 1 to 30 carbon atoms is preferably a substituent having from 1 to 20 carbon atoms, more preferably a substituent having from 1 to 15 carbon atoms, and particularly preferably a substituent having from 1 to 8 carbon atoms. More specifically, $R^1$ and $R^2$ each includes, for example, a straight-chain, branched or cyclic alkyl group, an aryl group or a heterocyclic group. $R^1$ and $R^2$ may be combined with each other to form a cyclic structure.

Examples of the alkyl group include a methyl group, an ethyl group, a propyl group, an octyl group, an isopropyl group, a tert-butyl group, an isopentyl group, a 2-ethylhexyl group, a 2-methylhexyl group and a cyclopentyl group. Examples of the aryl group include a phenyl group, a 1-naphtyl group and a 2-naphthyl group. Examples of the heterocyclic group include a furanyl group, a thiophenyl group and a pyridinyl group.

These groups may have a substituent. Examples of the substituent include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

$R^1$ and $R^2$ each particularly preferably represents a hydrogen atom, a methyl group or an ethyl group in view of the effect and ready availability.

$L^1$ and $L^2$ each independently represents an organic connecting group. Specific examples of the organic connecting group include an alkylene group having from 1 to 20 carbon atoms and an arylene group, for example, a phenylene group or a xylylene group. Specifically, the organic connecting groups shown below are exemplified. The organic connecting group may have a substituent, for example, a hydroxy group.

$-CH_2-$ 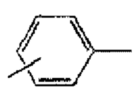 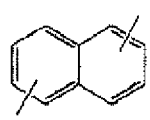 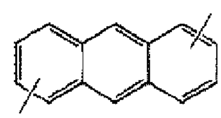

In formula (i), A represents a carboxylate or a sulfonate. Specifically, The anions shown below are exemplified.

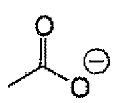 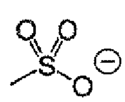

In formula (ii), B represents a substituent having a positive charge, for example, an ammonium, a phosphonium, an iodonium or a sulfonium. The ammonium or phosphonium is preferred and the ammonium is particularly preferred. Examples of the substituent having a positive charge include a trimethylammonio group, a triethylammonio group, a tributylammonio group, a benzyldimethylammonio group, a diethylhexylammonio group, a (2-hydroxyethyl)dimethylammonio group, a pyridinio group, an N-methylimidazolio group, an N-acridinio group, a trimethylphosphonio group, a triethylphosphonio group and a triphenylphosphonio group.

In particular, it is preferred that in the repeating unit a positive charge and a negative charge of the zwitterionic

group be present in the position corresponding to a side chain of the polymer.

In the invention, specifically, the repeating unit having a zwitterionic group is preferably represented by formula (A1) shown below.

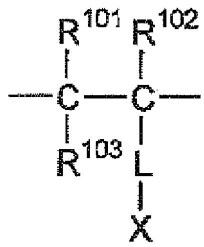

(A1)

In formula (A1), $R^{101}$ to $R^{103}$ each independently represents a hydrogen atom, an alkyl group having from 1 to 6 carbon atoms or a halogen atom. L represents a single bond or a divalent connecting group selected from the group consisting of -CO-, -O-, -NH-, a divalent aliphatic group, a divalent aromatic group and a combination thereof.

Specific examples of the combination of groups represented by L are set forth below. In each of the specific examples shown below, the left side connects to the main chain and the right side connects to X.

L1 : -CO-O-divalent aliphatic group- L2: -CO-O-divalent aromatic group- L3: -CO-NH-divalent aliphatic group- L4: -CO-NH-divalent aromatic group- L5: -CO-divalent aliphatic group- L6: -CO-divalent aromatic group- L7: -CO-divalent aliphatic group-CO-O-divalent aliphatic group- L8: -CO-divalent aliphatic group-O-CO-divalent aliphatic group- L9: -CO-divalent aromatic group-CO-O-divalent aliphatic group- L10: -CO-divalent aromatic group-O-CO-divalent aliphatic group- L11: -CO-divalent aliphatic group-CO-O-divalent aromatic group- L12: -CO-divalent aliphatic group-O-CO-divalent aromatic group- L13: -CO-divalent aromatic group-CO-O-divalent aromatic group- L14: -CO-divalent aromatic group-O-CO-divalent aromatic group- L15: -CO-O-divalent aromatic group-O-CO-NH-divalent aliphatic group- L16: -CO-O-divalent aliphatic group-O-CO-NH-divalent aliphatic group-

The divalent aliphatic group includes an alkylene group, a substituted alkylene group, an alkenylene group, a substituted alkenylene group, an alkinylene group, a substituted alkinylene group and a polyalkyleneoxy group. Among them, an alkylene group, a substituted alkylene group, an alkenylene group and a substituted alkenylene group are preferable, and an alkylene group and a substituted alkylene group are more preferred.

Of the divalent aliphatic groups, a chain structure is preferable than a cyclic structure, and further a straight-chain structure is more preferable than a branched structure. A number of carbon atoms included in the divalent aliphatic group is preferably from 1 to 20, more preferably from 1 to 15, still more preferably from 1 to 12, yet still more preferably from 1 to 10, and most preferably from 1 to 8.

Examples of the substituent for the divalent aliphatic group include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

The divalent aromatic group includes an arylene group and a substituted arylene group. It preferably includes a phenylene group, a substituted phenylene group, a naphthylene group and a substituted naphthylene group.

Examples of the substituent for the divalent aromatic group include an alkyl group in addition to the substituents described for the divalent aliphatic group described above.

Of L1 to L16 described above, L1 to L4 are preferred.

L is preferably a single bond, -CO-, a divalent aliphatic group, a divalent aromatic group or any one of L1 to L4.

In formula (A1), X represents a zwitterionic group. X is preferably the group represented by formula (i) or (ii) and preferred embodiments thereof are also same as those described in formulae (i) and (ii).

Of the repeating units (d3), in particular, those having as the hydrophilic group, a sulfonic acid group or a salt thereof, a carboxylic acid group or a salt thereof, an amido group, an ammonium group or a zwitterionic group are preferred, and those having a sulfonic acid group or a salt thereof, an amido group or a zwitterionic group are more preferred.

The molar ratio of the repeating unit (d3) in the specific copolymer is ordinarily from 1 to 90% by mole, preferably from 5 to 80% by mole, and more preferably from 10 to 70% by mole.

(d4) Repeating unit having at least one ethylenically unsaturated bond which does not correspond to the repeating unit (d1)

As the repeating unit (hereinafter, also referred to as "repeating unit (d4)") having at least one ethylenically

unsaturated bond which does not correspond to the repeating unit (d1) the repeating unit (d1), repeating units represented by formulae (d4a) to (d4c) shown below are preferred.

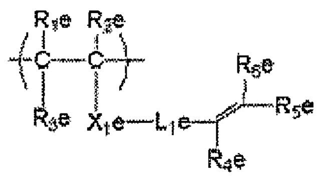
(d4a)

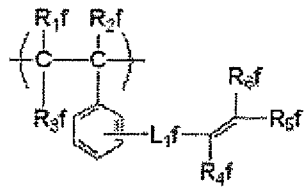
(d4b)

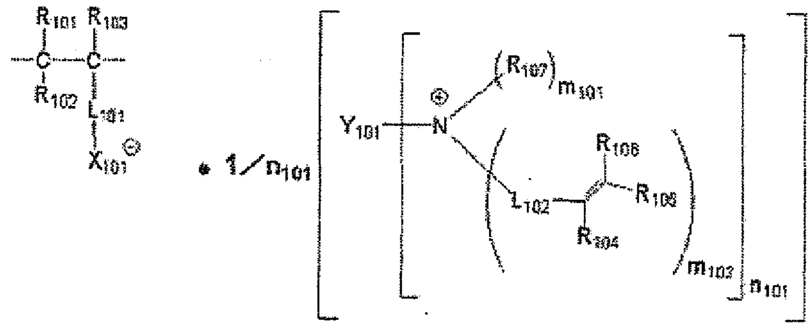
(d4c)

In formulae (d4a) to (d4c), $R_1e$ to $R_3e$ have the same meanings as $R_1a$ to $R_3a$ defined in formula (d2a) respectively. $X_1e$ has the same meanings as $X_1a$ defined in formula (d1a). $L_1e$ has the same meaning as $L_1a$ defined in formula (d2a). $R_4e$ to $R_6e$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ or $-CO-N(R_{109})-R_{108}$, or $R_4e$ and $R_5e$ or $R_5e$ and $R_6e$ may be combined with each other to form a ring.

$R_1f$ to $R_3f$ have the same meanings as $R_1a$ to $R_3a$ defined in formula (d2a) respectively. $L_1f$ has the same meaning as $L_1a$ defined in formula (d2a). $R_4f$ to $R_6f$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ or $-CO-N(R_{109})-R_{108}$, or $R_4f$ and $R_5f$ or $R_5f$ and $R_6f$ may be combined with each other to form a ring.

$R_{101}$ to $R_{103}$ each independently represents a hydrogen atom, an alkyl group having from 1 to 6 carbon atoms, $-CH_2-OH$, $-CH_2-OR_{112}$, $-CH_2-O-CO-R_{112}$ or a halogen atom. $R_{104}$ to $R_{106}$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ or $-CO-N(R_{109})-R_{108}$, or $R_{104}$ and $R_{105}$ or $R_{105}$ and $R_{106}$ may be combined with each other to form a ring. $R_{107}$ represents a hydrogen atom, an alkyl group having from 1 to 10 carbon atoms, an aryl group having from 6 to 10 carbon atoms or an aralkyl group having from 7 to 20 carbon atoms. $R_{108}$ represents an alkyl group having from 1 to 10 carbon atoms or an aryl group having from 6 to 10 carbon atoms. $R_{109}$ represents a hydrogen atom, an alkyl group having from 1 to 10 carbon atoms or an aryl group having from 6 to 10 carbon atoms. $R_{112}$ represents an alkyl group having from 1 to 10 carbon atoms, an aryl group having from 6 to 10 carbon atoms or an aralkyl group having from 7 to 20 carbon atoms. $L_{101}$ represents -CO-, -O-, -S-, $-N(R_{109})-$, $-SO_2-$, a divalent aliphatic group, a divalent aromatic group or a divalent connecting group composed of a combination of these groups. $L_{102}$ represents -CO-, -0-, $-N(R_{109})-$, a divalent aliphatic group, a divalent aromatic group or a divalent connecting group composed of a combination of these groups, $m_{101}$ represents an integer from 0 to 3. $m_{102}$ represents an integer from 1 to 3, provided that $m_{101} + m_{102} = 3$. When $m_{101}$ is 2 or more, plural $R_{107}$ may be the same or different. When $m_{102}$ is 2 or more, plural $R_{104}$ to $R_{106}$ and $L_{102}$ may be the same or different. $X_{101}$ represents $-CO_2^-$, $-PO_3H^-$, $-O-PO_3H^-$, $-SO_3^-$ or $-O-SO_3^-$. $Y_{101}$ represents an $n_{101}$ valent connecting group, provided that it may be a hydrogen atom when $n_{101}$ is 1. $n_{101}$ represents an integer from 1 to 10, provided that a value of $m_{102}$ x $n_{101}$ is not zero.

In formulae (d4a) to (d4c), $R_1e$, $R_2e$, $R_1f$, $R_2f$ each independently represents preferably a hydrogen atom, a methyl group or an ethyl group, and more preferably a hydrogen atom.

$R_3e$ and $R_3f$ each independently represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$X_1e$ represents preferably -CO-O- or $-CO-NR_{500}-$, and more preferably -CO-O- or -CO-NH-.

$L_1$e and $L_1$f each independently represents preferably -O-, -S-, -CO-O-, -O-CO-, -CO-$NR_{500}$-, -$NR_{500}$-CO-, a divalent aliphatic group or a divalent connecting group composed of a combination of these groups, more preferably -CO-O-, -O-CO-, -CO-NH-, -NH-CO-, a divalent aliphatic group or a divalent connecting group composed of a combination of these groups.

$R_4$e and $R_4$f each independently represents preferably a hydrogen atom, a methyl group, -$CH_2$-OH, -$CH_2$-O-CO-($C_1$- to $C_4$-alkyl), -CO-O-($C_1$- to $C_4$-alkyl) or -CO-NH-($C_1$- to $C_4$-alkyl), and more preferably a hydrogen atom, a methyl group, -$CH_2$-OH, -$CH_2$-O-CO-$CH_3$, -CO-O-($C_1$- to $C_2$-alkyl) or -CO-NH-($C_1$- to $C_2$-alkyl).

$R_5$e, $R_6$e, $R_5$f and $R_6$f each independently represents preferably a hydrogen atom, a methyl group or an ethyl group, and more preferably a hydrogen atom.

$R_{101}$ and $R_{102}$ each independently represents preferably a hydrogen atom, a methyl group or an ethyl group, and more preferably a hydrogen atom.

$R_{103}$ represents preferably a hydrogen atom, a methyl group, -$CH_2$-OH or -$CH_2$-O-CO-($C_1$- to $C_4$-alkyl), and more preferably a hydrogen atom, a methyl group, -$CH_2$-OH or -$CH_2$-O-CO-$CH_3$.

$R_{104}$ represents preferably a hydrogen atom, a methyl group, -$CH_2$-OH, -$CH_2$-O-CO-($C_1$- to $C_4$-alkyl), -CO-O-($C_1$- to $C_4$-alkyl) or -CO-NH-($C_1$- to $C_4$-alkyl), and more preferably a hydrogen atom, a methyl group, -$CH_2$-OH, -$CH_2$-O-CO-$CH_3$, -CO-O-($C_1$- to $C_2$-alkyl) or -CO-NH-($C_1$- to $C_2$-alkyl).

$R_{105}$ and $R_{106}$ each independently represents preferably a hydrogen atom, a methyl group or an ethyl group, and more preferably a hydrogen atom.

$R_{107}$ represents preferably a hydrogen atom, a $C_1$- to $C_4$-alkyl group, a benzyl group, a ($C_1$- to $C_4$-alkyl substituted) phenylmethyl group, a ($C_1$- to $C_4$-alkoxy substituted) phenylmethyl group, a ($C_1$- to $C_4$-acyloxy substituted) phenylmethyl group or a ($C_1$- to $C_4$-alkoxycarbonyl substituted) phenylmethyl group, and more preferably a hydrogen atom, a methyl group, an ethyl group or a benzyl group.

$R_{108}$ represents preferably a methyl group, an ethyl group, a n-propyl group, an iso-propyl group, a n-butyl group or a phenyl group, and more preferably a methyl group, an ethyl group or a n-propyl group.

$R_{109}$ represents preferably a hydrogen atom, a methyl group, an ethyl group, a n-propyl group, an iso-propyl group, a n-butyl group or a phenyl group, and more preferably a hydrogen atom, a methyl group, an ethyl group or a n-propyl group.

$L_{101}$ represents preferably -CO-O-L0-, -CO-NH-L0-, -divalent aromatic group- or -divalent aromatic group-L0-, and more preferably -CO-O-L0- or -CO-NH-L0-. L0 represents a divalent aliphatic group, a divalent aromatic group or a combination of these groups.

$L_{102}$ represents preferably any one of La to Lr shown below, and more preferably La, Lb, Lf, Lg, Lh, Li, Lo, Lp or Lr. In La to Lr, L0 has the same meaning as L0 defined above.

La: -L0-O-CO- Lb: -L0-NH-CO- Lc: -L0-O- Ld: -L0-CO-O- Le: -L0-O-CO-O- Lf -L0-O-$CH_2$- Lg: -L0-CO-O-$CH_2$- Lh: -L0-O-CO-O-$CH_2$- Li: -L0-O-CO-NH-L0-O-CO- Lj: -L0-O-CO-L0-O-CO- Lk: -L0-O-CO-L0-NH-CO- L1: -L0-CO-O-L0-O-CO- Lm: -L0-CO-O-L0-NH-CO- Ln: -L0-divalent aromatic group- Lo: -O-CO-divalent aromatic group- Lp: -O-CO-L0-divalent aromatic group- Lq: -CO-O-divalent aromatic group- Lr: -CO-O-L0-divalent aromatic group-

With respect to $m_{101}$, $m_{102}$ and $n_{101}$, a value of $m_{102}$ x $n_{101}$, is preferably from 1 to 6, and more preferably from 1 to 4.

$X_{101}^-$ represents preferably -$CO_2^-$, -$PO_3H^-$, -O-$PO_3H^-$ or -$SO_3^-$, and more preferably -$CO_2^-$,-O-$PO_3H^-$ or -$SO_3^-$.

$Y_{101}$ ordinarily represents an $n_{101}$ valent hydrocarbon residue, may include any of aliphatic and aromatic structures and may include any of straight-chain, branched and cyclic structures. The cyclic structure may be any of monocyclic and polycyclic structures. The carbon-carbon bond constituting the hydrocarbon residue may be interrupted with -CO-, -O-, -S-, -N($R_{109}$)-, -$SO_2$- or a structure composed of a combination of these groups. However, $Y_{101}$ may be a hydrogen atom, when $n_{101}$ is 1.

Specific examples of the repeating unit represented by any one of formulae (d4a) to (d4c) are set forth below, but the invention should not be construed as being limited thereto.

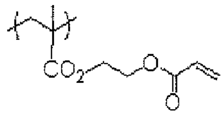

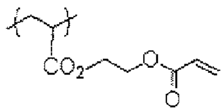

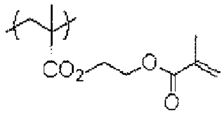

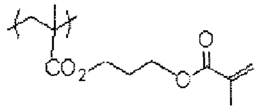

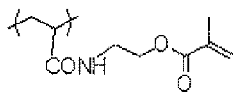

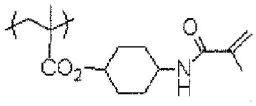

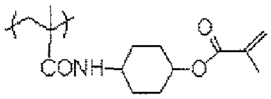

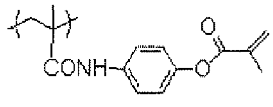

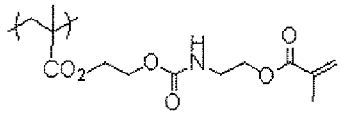

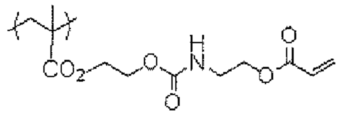

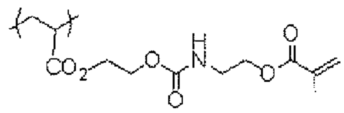

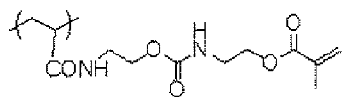

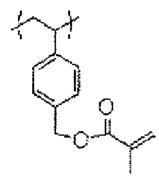

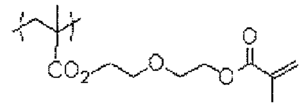

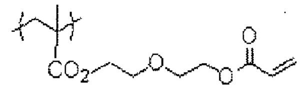

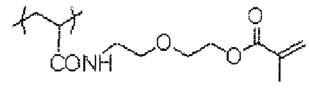

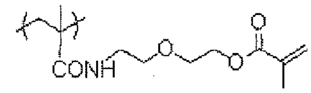

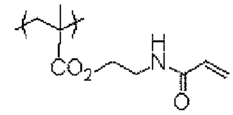

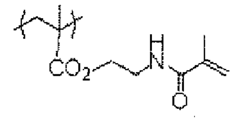

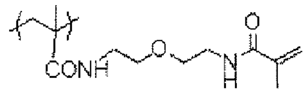

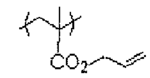
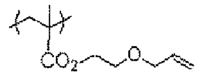
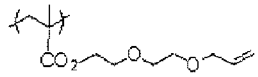
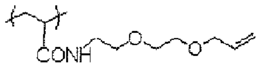
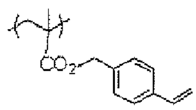
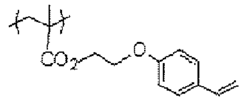
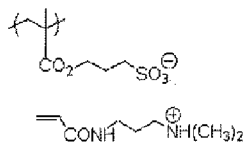
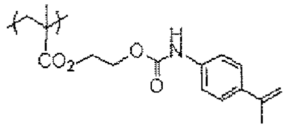
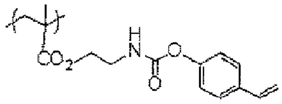
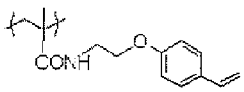
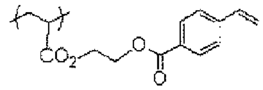
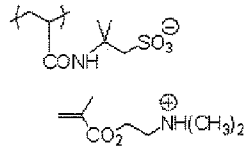
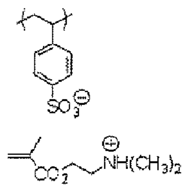
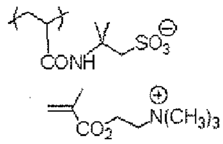
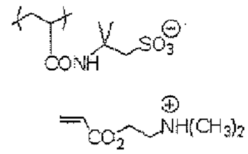
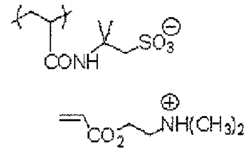
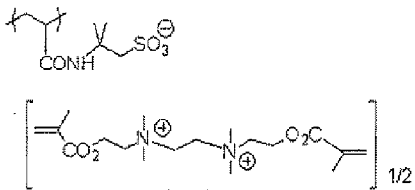
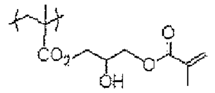
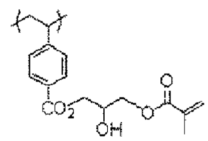
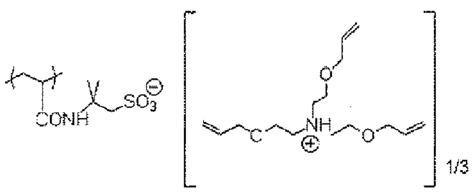
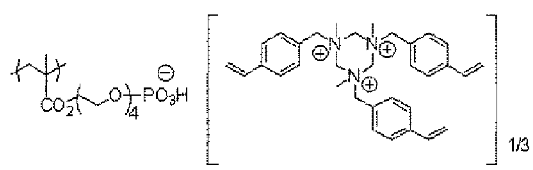

Of the repeating units (d4), in particular, those having as the ethylenically unsaturated group, a (meth)acryloyl group, an aromatic group-substituted vinyl group or an allyl group are preferred, and those having a (meth)acryloyloxy group, a (meth)acryloylamido group or a phenyl group-substituted vinyl group (styryl group) are more preferred.

The molar ratio of the repeating unit (d4) in the specific copolymer is ordinarily from 0.5 to 80% by mole, preferably from 2 to 65% by mole, and more preferably from 5 to 50% by mole.

With respect to the specific copolymer according to the invention, two or more kinds of the copolymers having different structures may be used as a mixture. In the case of using as a mixture, a weight ratio of the specific copolymer which is used in the smallest amount is preferably 1% by weight or more, more preferably 3% by weight or more, particularly preferably 5% by weight or more, based on the total weight of the specific copolymer.

Further, in the intermediate layer, a polymer other than the specific copolymer according to the invention, that is, a polymer which does not contain the repeating unit (d1) may be used as a mixture with the specific copolymer according to the invention. The polymer other than the specific copolymer includes, for example, polymer compounds having a crosslinkable group (preferably, an ethylenically unsaturated bond group), a functional group capable of interacting with a surface of support and a hydrophilic group described in JP-A-2005-125749, JP-A-2006-239867 and JP-A-2006-215263 are exemplified. In such a case, the total weight of the specific copolymer is preferably 3% by weight or more, more preferably 5% by weight or more, particularly preferably 10% by weight or more, based on the total weight of the components used in the intermediate layer.

A weight average molecular weight of the specific copolymer according to the invention or the polymer other

than the specific copolymer used in the intermediate layer is ordinarily from 2,000 to 1,000,000, preferably from 4,000 to 700,000, more preferably from 6,000 to 500,000, and most preferably from 7,000 to 400,000. When the weight average molecular weight thereof is less than 2,000, good printing durability is not obtained. On the other hand, when the weight average molecular weight thereof exceeds 1,000,000, a problem may arise in time-lapse stability, for example, occurrence of deposition or phase separation in a solution of the polymer with a lapse of time, or a problem, for example, degradation of the stain resistance may arise.

Although the specific copolymer according to the invention is able to synthesize by any hitherto known method, a radical polymerization method is preferably used for the synthesis thereof Ordinary radical polymerization methods are described, for example, in Shin Kobunshi Jikkengaku 3, Kobunshi no Gosei to Hanno 1, (New Polymer Experimentation 3, Synthesis and Reaction of Polymer 1), edited by The Society of Polymer Science, Japan, (Kyoritsu Shuppan Co., Ltd.), Shin Jikken Kagaku Koza 19, Kobunshi Kagaku (I), (New Experimental Chemistry Course 19, Polymer Chemistry (I)), edited by The Chemical Society of Japan, (Maruzen Co., Ltd.) and Busshitsu Kogaku Koza, Kabunshi Gosei Kagaku, (Material Engineering Course, Polymer Synthesis Chemistry), (Tokyo Denki University Press) and these methods can be applied.

A method for introduction of the carbon-carbon unsaturated double bond into the repeating unit (d1) in the specific copolymer according to the invention is not particularly restricted and specifically includes the following three methods: (1) Method where the carbon-carbon unsaturated double bond is introduced into a monomer and the monomer is polymerized to obtain a polymer, (2) Method where the carbon-carbon unsaturated double bond is introduced into a monomer as a precursor structure, the monomer is polymerized to obtain a polymer and then a conversion reaction is performed to generate the carbon-carbon unsaturated double bond, and (3) Method where a reactive functional group, for example, an active hydrogen is introduced into a monomer, the monomer is polymerized to obtain a polymer and then the reactive functional group is reacted with a compound having a functional group capable of forming a bond with the reactive functional group and a carbon-carbon unsaturated double bond to introduce the carbon-carbon unsaturated double bond. The method (1) is particularly effective in the case where polymerizability of the carbon-carbon unsaturated double bond is lower than that of the polymerizable group which reacts in the synthesis of polymer. The conversion reaction in the method (2) includes, for example, a release reaction with a base. The method of introducing the carbon-carbon unsaturated double bond in the method (3) includes, for example, a reaction of the active hydrogen in the polymer with (meth)acryloyl chloride, 2-isocyanatoethyl (meth)acrylate or the like. In the case where the specific copolymer according to the invention is obtained by the method (2) or (3), the by-product salt can be removed by passing through an ion-exchange resin, if desire.

Specific examples of the specific copolymer according to the invention are set forth below, but the invention should not be construed as being limited thereto. In each of the specific examples, the rightmost repeating unit corresponds to the repeating unit (d1) according to the invention.

| | | Composition Ratio (% by mole) (in a left-to -right order) | Molecular We ight (x $10^{+}$) |
|---|---|---|---|
| 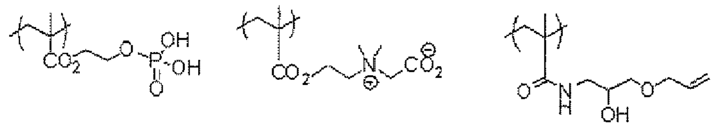 -0 15 | D-1 | 45/50/5 | 8 |
| 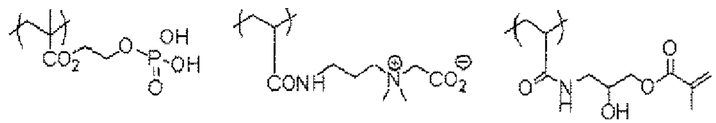 -0 18 | D-2 | 80/15/5 | 10 |
| 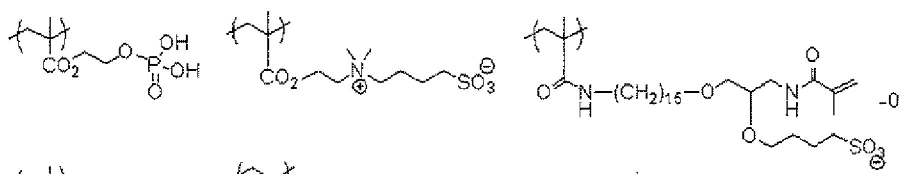 -0 30 | D-3 | 40/50/10 | 12 |
| 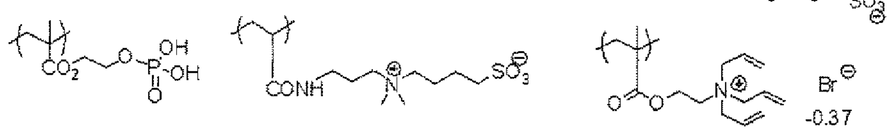 -0.37 | D-4 | 45/45/ 10 | 7 |
| 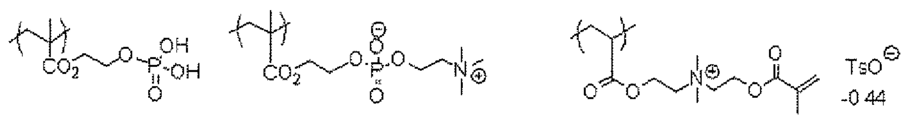 -0 44 | D-5 | 30/60/10 | 9 |
| 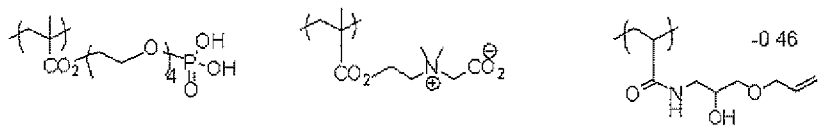 -0 46 | D-6 | 50/40/10 | 13 |

(continued)

| | | | | Composition Ratio (% by mole) (in a left-to -right order) | Molecular We ight (x 10+) |
|---|---|---|---|---|---|
| 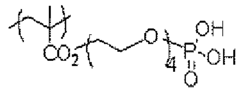 | 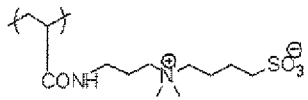 | 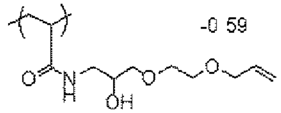 -0 59 | D-7 | 40/45/15 | 10 |
| 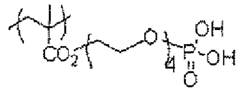 | 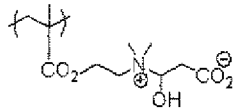 | 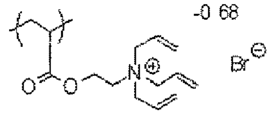 -0 68 | D-8 | 50/45/5 | 13 |
| 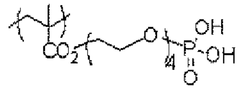 | 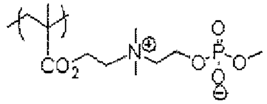 | 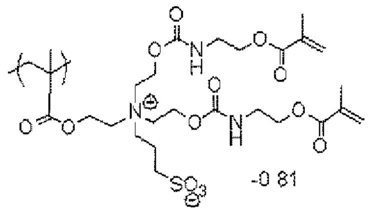 -0 81 | D-9 | 50/40/10 | 10 |
| 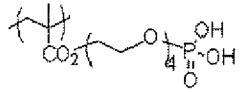 | 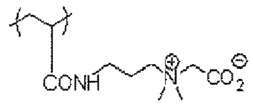 | 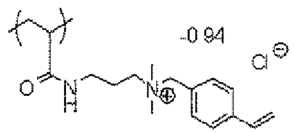 -0 94 | D-10 | 45/45/10 | 8 |
| 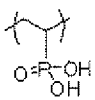 | 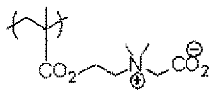 | 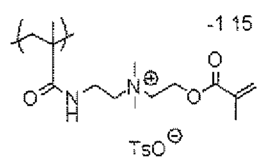 -1 15 | D-11 | 60/25/15 | 2 |

(continued)

| | | Composition Ratio (% by mole) (in a left-to -right order) | Molecular We ight (x 10⁺) |
|---|---|---|---|
| 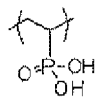 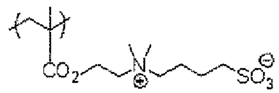 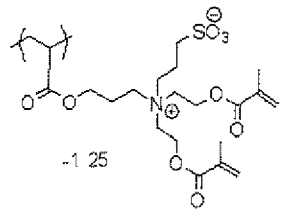 -1 25 | D-12 | 55/30/15 | 3 |
| 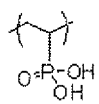 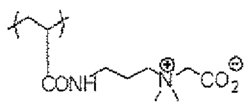 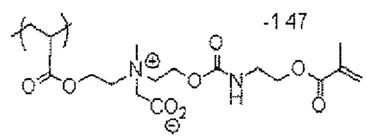 -1 47 | D-13 | 60/20/20 | 25 |
| 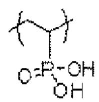 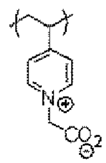 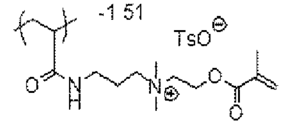 -1 51 | D-14 | 45/40/15 | 35 |
| 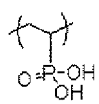 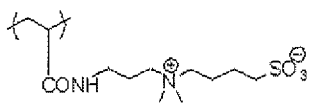 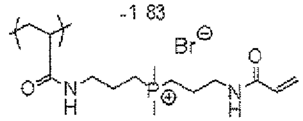 -1 83 | D-15 | 40/40/20 | 4,5 |

(continued)

| | | Composition Ratio (% by mole) (in a left-to -right order) | Molecular We ight (x $10^{+}$) |
|---|---|---|---|
| 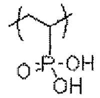 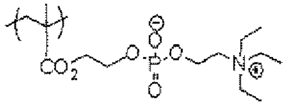 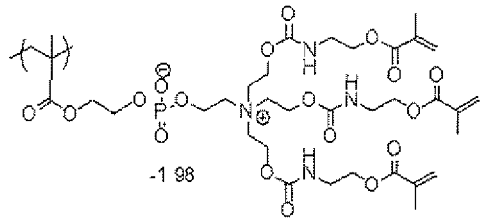 -1 98 | D-16 | 45/35/20 | 5 |
| 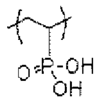 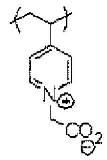 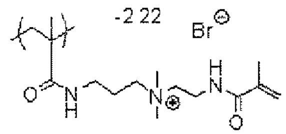 -2 22 | D-17 | 55/20/25 | 15 |
| 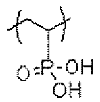 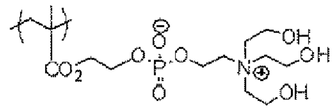 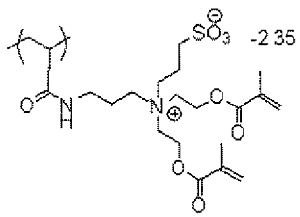 -2 35 | D-18 | 45/30/25 | 25 |
| 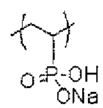 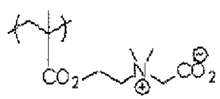 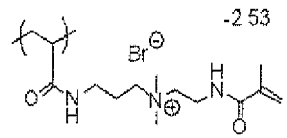 -2 53 | D-19 | 50/25/25 | 15 |
| 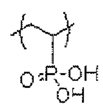 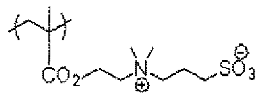 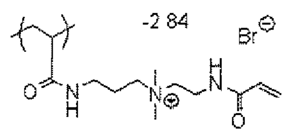 -2 84 | D-20 | 40/40/20 | 35 |

(continued)

| | | | | Composition Ratio (% by mole) (in a left-to -right order) | Molecular We ight (x $10^{+}$) |
|---|---|---|---|---|---|
| D-21 | 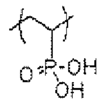 | 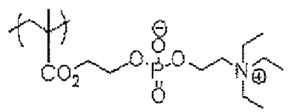 | 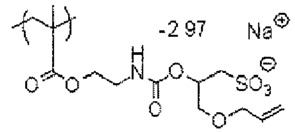 -2 97 | 45/25/30 | 2 |
| D-22 | 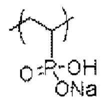 | 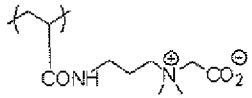 | 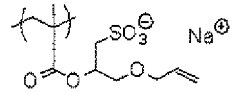 -3 29 | 40/35/25 | 2 |
| D-23 | 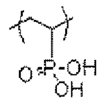 | 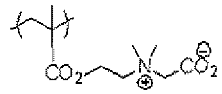 | 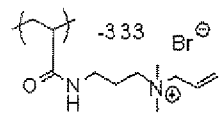 -3 33 | 40/35/25 | 25 |
| D-24 | 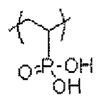 | 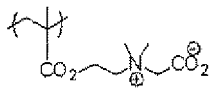 | 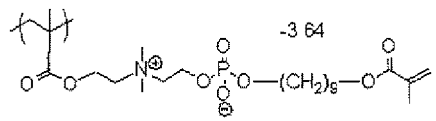 -3 64 | 40/25/35 | 35 |
| D-25 | 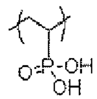 | 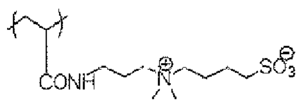 | 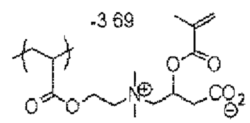 -3 69 | 35/35/30 | 1.5 |

(continued)

| | | Composition Ratio (% by mole) (in a left-to -right order) | Molecular We ight (x 10⁺) |
|---|---|---|---|
| 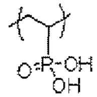 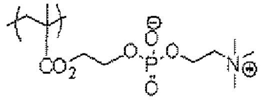 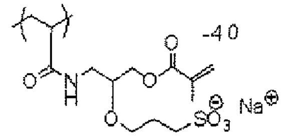 -4 0 | D-26 | 35/30/35 | 2 |
| 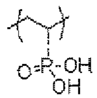 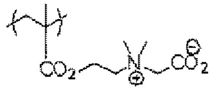 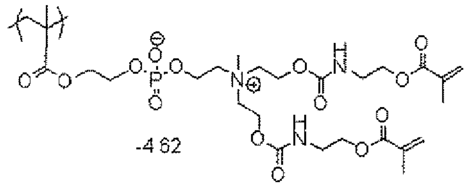 -4 62 | D-27 | 35/30/35 | 1 |
| 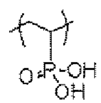 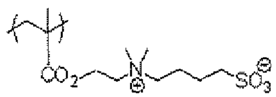 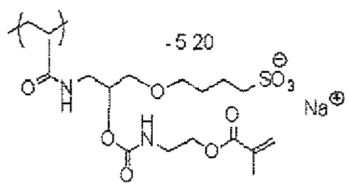 -5 20 | D-28 | 40/25/35 | 25 |
| 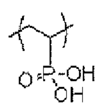 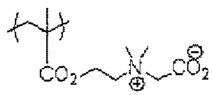 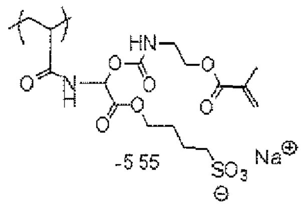 -5 55 | D-29 | 35/30/36 | 15 |

(continued)

| | | | | Composition Ratio (% by mole) (in a left-to -right order) | Molecular We ight (x 10+) |
|---|---|---|---|---|---|
| D-30 | 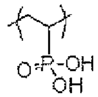 | 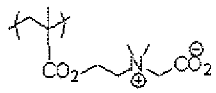 | 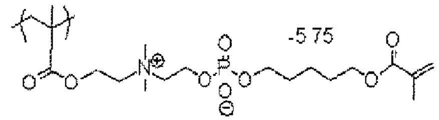 -5 75 | 40/30/30 | 2 |
| D-31 | 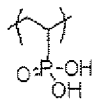 | 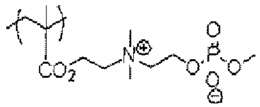 | 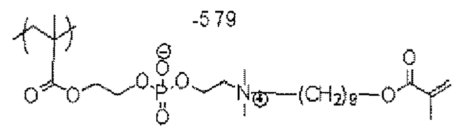 -5 79 | 40/25/35 | 0.8 |
| D-32 | 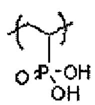 | 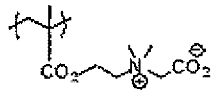 | 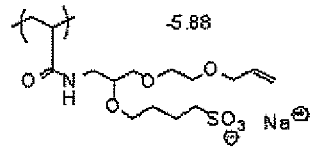 -5.88 | 30/30/40 | 06 |
| D-34 | 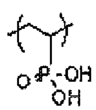 | 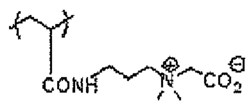 | 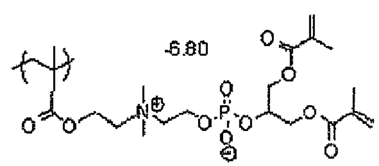 -6.80 | 40/30/30 | 2 |
| D-35 | 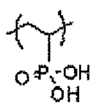 | 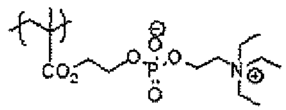 | 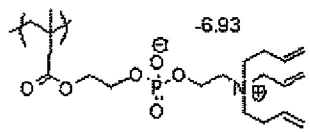 -6.93 | 50/15/35 | 2.5 |

(continued)

| | | Composition Ratio (% by mole) (in a left-to -right order) | Molecular We ight (x 10⁺) |
|---|---|---|---|
| 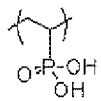 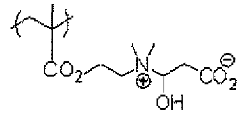 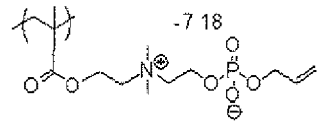 -7 18 | D-36 | 45/25/30 | 2 |
| 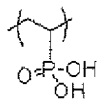 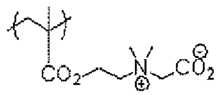 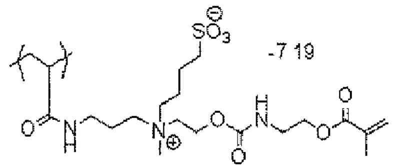 -7 19 | D-37 | 45/15/40 | 3 5 |
| 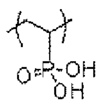 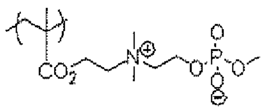 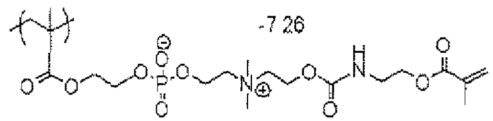 -7 26 | D-38 | 45/20/35 | 2 |
| 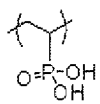 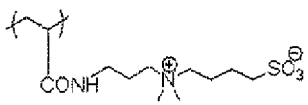 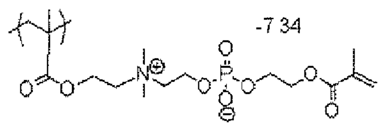 -7 34 | D-39 | 50/20/30 | 1 5 |
| 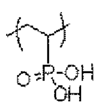 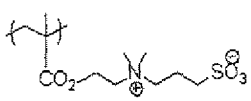 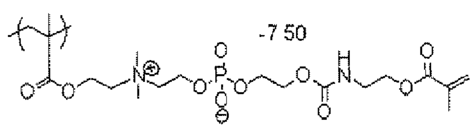 -7 50 | D-40 | 40/15/45 | 35 |

(continued)

| | | | | Composition Ratio (% by mole) (in a left-to -right order) | Molecular We ight (x 10+) |
|---|---|---|---|---|---|
| 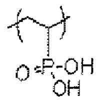 | 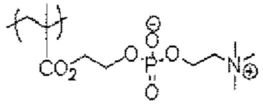 | 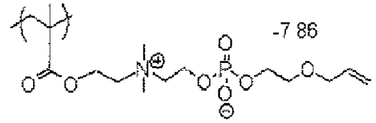 -7 86 | D-41 | 50/15/35 | 4 5 |
| 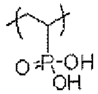 | 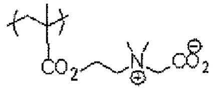 | 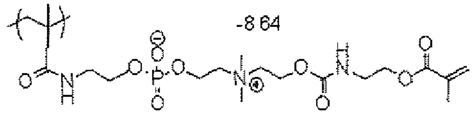 -8 64 | D-42 | 45/15/40 | 5 |
| 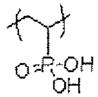 | 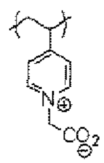 | 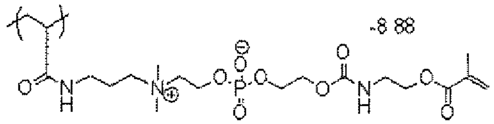 -8 88 | D-43 | 45/15/40 | 3 |
| 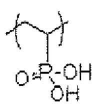 | 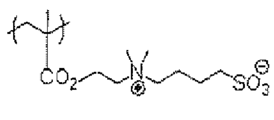 | 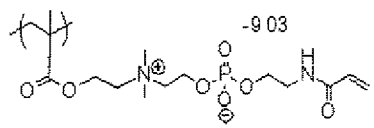 -9 03 | D-44 | 40/15/45 | 3 |
| 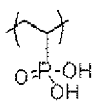 | 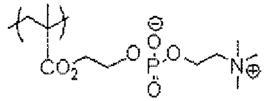 | 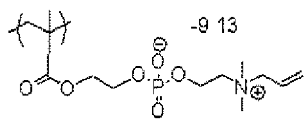 -9 13 | D-45 | 30/25/45 | 5 5 |

(continued)

| | | Composition Ratio (% by mole) (in a left-to -right order) | Molecular We ight (x 10⁺) |
|---|---|---|---|
| 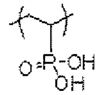 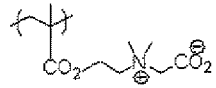 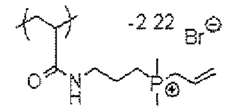 | D-46 | 45/35/20 | 5 5 |
| 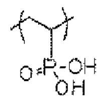 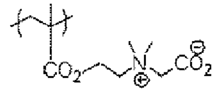 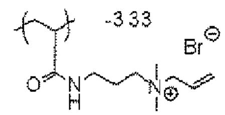 | D-47 | 45/35/20 | 5 |
| 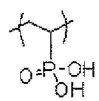 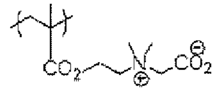 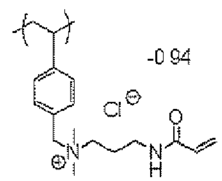 | D-48 | 55/35/10 | 2 5 |
| 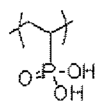 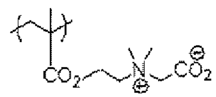 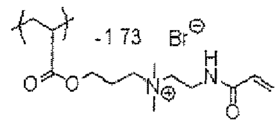 | D-49 | 55/35/10 | 2 5 |
| 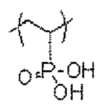 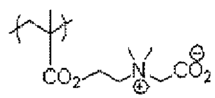 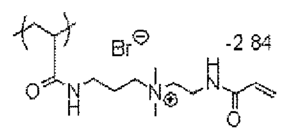 | D-50 | 55/35/10 | 3 |

(continued)

| | | Composition Ratio (% by mole) (in a left-to -right order) | Molecular We ight (x 10+) |
|---|---|---|---|
| 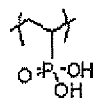 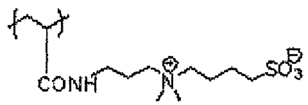 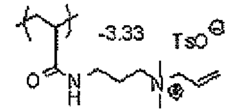 | D-51 | 55/25/20 | 1 |
| 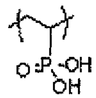 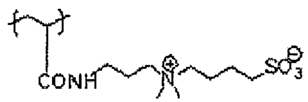 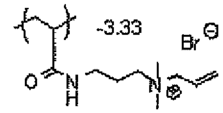 | D-52 | 55/25/20 | 1 |
| 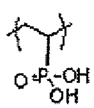 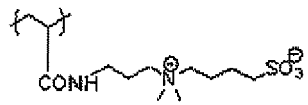 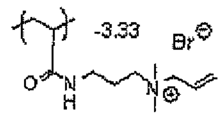 | D-53 | 50/20/30 | 2.5 |
| 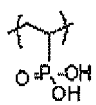 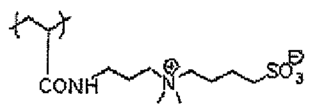 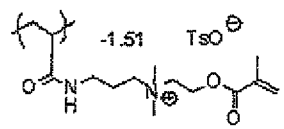 | D-54 | 50/20/30 | 2.5 |
| 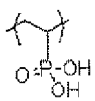 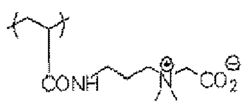 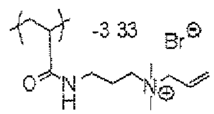 | D-55 | 50/25/25 | 5 5 |

(continued)

| | | Composition Ratio (% by mole) (in a left-to -right order) | Molecular We ight (x 10⁺) |
|---|---|---|---|
| 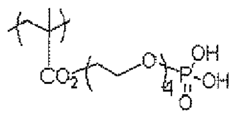 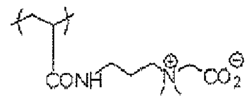 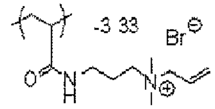 | D-56 | 50/25/25 | 6 |
| 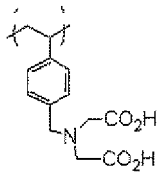 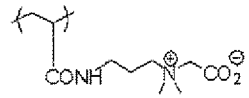 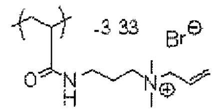 | D-57 | 50/25/25 | 6 5 |
| 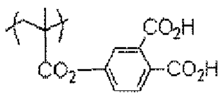 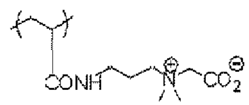 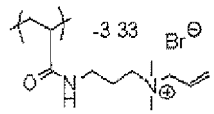 | D-58 | 50/25/25 | 6 |
| 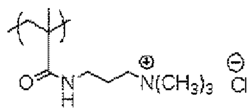 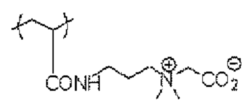 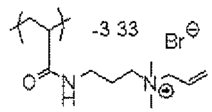 | D-59 | 50/25/25 | 45 |
| 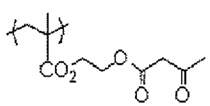 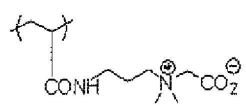 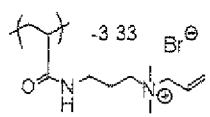 | D-60 | 50/25/25 | 55 |

(continued)

| | | Composition Ratio (% by mole) (in a left-to -right order) | Molecular We ight (x 10⁺) |
|---|---|---|---|
| 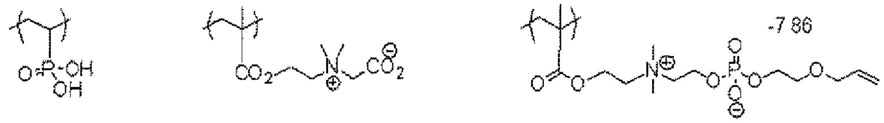 | D-61 | 40/20/40 | 15 |
| 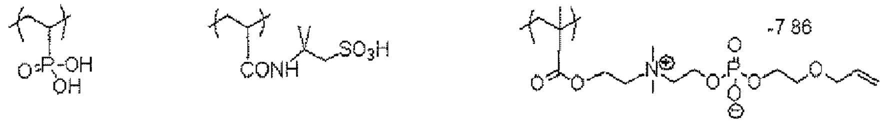 | D-62 | 40/20/40 | 2 |
| 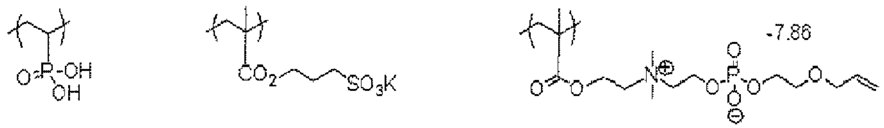 | D-63 | 40/20/40 | 2.5 |
| 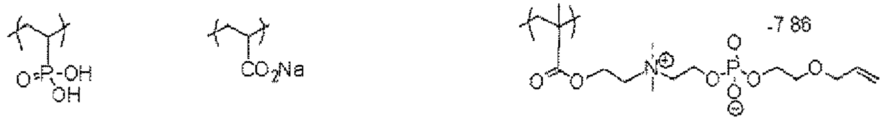 | D-64 | 40/20/40 | 2 |
| 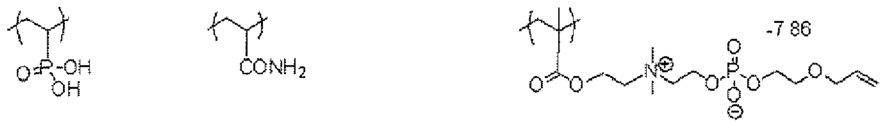 | D-65 | 40/20/40 | 1.5 |

(continued)

| | | Composition Ratio (% by mole) (in a left-to -right order) | Molecular We ight (x 10⁺) |
|---|---|---|---|
| 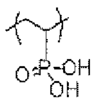 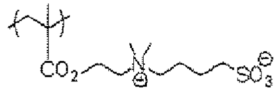 -1 51 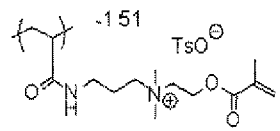 | D-66 | 50/25/25 | **0.35** |
| 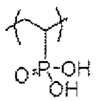 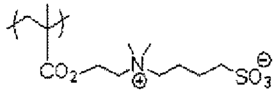 -1 51 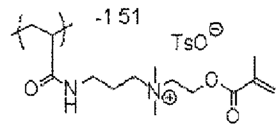 | D-67 | 50/25/25 | **0.65** |
| 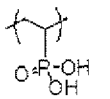 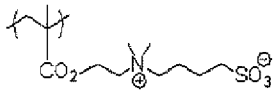 -1 51 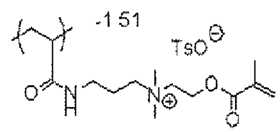 | D-68 | 50/25/25 | **4** |
| 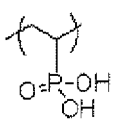 -5 20 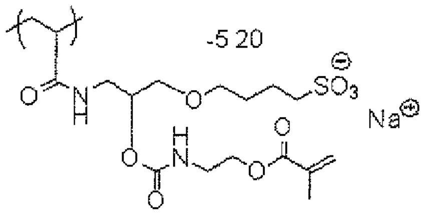 | D-69 | 60/40 | 25 |

(continued)

| | | Composition Ratio (% by mole) (in a left-to -right order) | Molecular We ight (x $10^{+}$) |
|---|---|---|---|
| 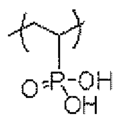 -8.64 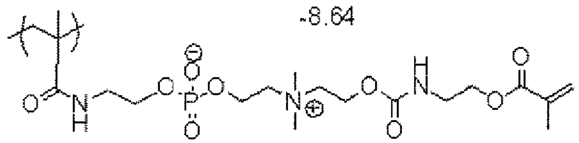 | D-70 | 55/45 | 15 |

The intermediate layer may further contain a silane coupling agent having an addition polymerizable ethylenically unsaturated bond group described in JP-A-10-282679, a phosphorus compound having an ethylenically unsaturated bond group described in JP-A-2-304441, a compound having an ethylenically unsaturated bond group and a support adsorbing group described in JP-A-2005-238816 or the like. Moreover, if desired, the intermediate layer may contain the surfactant described hereinafter with respect to the image-forming layer.

In order to form the intermediate layer on a support, a coating solution prepared by dissolving the component for the intermediate layer in a solvent is used. As the solvent, water and an organic solvent, for example, methanol, ethanol, propanol, isopropanol, ethylene glycol, hexylene glycol, tetrahydrofuran, dimethylformamide, 1-methyoxy-2-propanol, dimethylacetamide, dimethylsulfoxide, N-methylpyrrolidone or N-ethylpyrrolidone are exemplified and water and an alcohol are particularly preferred. The solvents may be used as a mixture.

The concentration of the coating solution for intermediate layer is preferably from 0.001 to 10% by weight, more preferably from 0.01 to 5% by weight, and still more preferably from 0.05 to 1% by weight. In order to coat the coating solution for intermediate layer on a support, known various methods can be used. For example, bar coater coating, spin coating, spray coating, curtain coating, dip coating, air knife coating, blade coating and roll coating are exemplified.

The coating amount (solid content) of the intermediate layer is preferably from 0.1 to 100 mg/$m^2$, and more preferably from 1 to 30 mg/$m^2$.

[Image-forming layer]

The image-forming layer (hereinafter, also referred to as a photosensitive layer) of the lithographic printing plate precursor according to the invention contains (A) a polymerization initiator,

(B) a polymerizable compound and (C) a binder polymer.
(A) Polymerization initiator

The photosensitive layer according to the invention contains a polymerization initiator (hereinafter, also referred to as an initiator compound). In the invention, a radical polymerization initiator is preferably used.

As the initiator compound, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt and a iron arene complex. Among them, at least one compound selected from the hexaarylbiimidazole compound, onium salt, trihalomethyl compound and metallocene compound is preferred, and the hexaarylbiimidazole compound is particularly preferred.

The hexaarylbiimidazole compound includes, for example, lophine dimers described in European Patents 24,629 and 107,792 and U.S. Patent 4,410,621, specifically, 2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole.

The hexaarylbiimidazole compound is particularly preferably used together with a sensitizing dye having an absorption maximum in a wavelength range from 300 to 450 nm.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with an infrared absorbing agent having an absorption maximum in a wavelength range from 750 to 1,400 nm.

In addition, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the photosensitive layer according to the invention is preferably from 0.01 to 20% by weight, more preferably from 0.1 to 15% by weight, still more preferably from 1.0 to 10% by weight, based on the total solid content of the photosensitive layer.

(B) Polymerizable compound

The polymerizable compound for use in the photosensitive layer according to the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.
These polymerizable compounds are described, for example, in JP-T-2006-508380 (the term "JP-T" as used herein means a published Japanese translation of a PCT patent application), JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, P-A-2003-64130, JP-A-2003-280187 and JP-A-10-333321.
Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a Methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.
Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708 (the term "JP-B" as used herein means an "examined Japanese patent publication").

$$CH_2=C(R_4)COOCH_2CH(R_5)OH \qquad (A)$$

wherein $R_4$ and $R_5$ each independently represents H or $CH_3$.
Also, urethane acrylates described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.
Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the photosensitive layer.

(C) Binder polymer

The photosensitive layer according to the invention contains a binder polymer. As the binder polymer, a polymer

capable of holding the components of photosensitive layer on a support and capable of being removed by a developer is used. The binder polymer used includes, for example, a (meth)acrylic polymer, a polyurethane resin, a polyvinyl alcohol resin, a polyvinyl butyral resin, a polyvinyl formal resin, a polyamide resin, a polyester resin and an epoxy resin. In particular, a (meth)acrylic polymer, a polyurethane resin and a polyvinyl butyral resin are preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups. The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group in the polymer with a compound having the acid group or the like.

One preferred example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

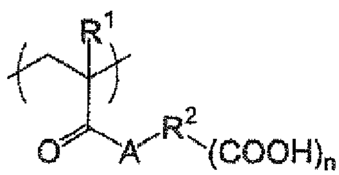

(I)

In formula (I), $R^1$ represents a hydrogen atom or a methyl group, $R^2$ represents a single bond or an n+1 valent connecting group, A represents an oxygen atom or $-NR^3-$, wherein $R^3$ represents a hydrogen atom or a monovalent hydrocarbon group having from 1 to 10 carbon atoms, and n represents an integer from 1 to 5.

The connecting group represented by $R^2$ in formula (1) is constructed from a hydrogen atom, a carbon atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. $R^2$ is preferably a single bond, an alkylene group, a substituted alkylene group or a group having a structure wherein a plurality of alkylene groups and/or substituted alkylene groups is connected to each other via any of an amido bond, an ether bond, a urethane bond, a urea bond and an ester bond, particularly preferably a single bond, an alkylene group having from 1 to 5 carbon atoms, a substituted alkylene group having from 1 to 5 carbon atoms or a group having a structure wherein a plurality of alkylene groups each having from 1 to 5 carbon atoms and/or substituted alkylene groups each having from 1 to 5 carbon atoms is connected to each other via any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a group having a structure wherein a plurality of alkylene groups each having from 1 to 3 carbon atoms and/or substituted alkylene groups each having from 1 to 3 carbon atoms is connected to each other via any of an amido bond, an ether bond, a urethane bond, a urea bond and an ester bond.

Examples of the substituent include a monovalent non-metallic atomic group exclusive of a hydrogen atom, for example, a halogen atom (e.g., -F, -Br, -Cl or -1), a hydroxy group, a cyano group, an alkoxy group, an aryloxy group, a mercapto group, an alkylthio group, an arylthio group, an alkylcarbonyl group, an arylcarbonyl group, a carboxyl group and a conjugate base group thereof, an alkoxycarbonyl group, an aryloxycarbonyl group, a carbamoyl group, an aryl group, an alkenyl group and an alkynyl group.

$R^3$ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group. n is preferably from 1 to 3, more preferably 1 or 2, and particularly preferably 1.

A ratio (% by mole) of the copolymerization component having a carboxylic acid group in the total copolymerization components of the binder polymer is preferably from 1 to 70% in view of developing property. Considering good compatibility between the developing property and printing durability, it is more preferably from 1 to 50%, and particularly preferably from 1 to 30%.

It is preferred that the binder polymer for use in the invention further contain a crosslinkable group. The term

"crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bonding group is preferred. The ethylenically unsaturated bonding group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, and particularly preferably from 0.1 to 2.0 mmol, per g of the binder polymer.

The binder polymer for use in the invention may contain a polymerization unit of an alkyl (meth)acrylate or aralkyl (meth)acrylate, a polymerization unit of (meth)acrylamide or a derivative thereof, a polymerization unit of an $\alpha$-hydroxymethylacrylate or a polymerization unit of a styrene derivative, in addition to the polymerization unit having an acid group and the polymerization unit having a crosslinkable group described above. The alkyl group in the alkyl (meth) acrylate is preferably an alkyl group having from 1 to 5 carbon atoms and more preferably a methyl group. The aralkyl (meth)acrylate includes, for example, benzyl (meth)acrylate. The (meth)acrylamide derivative includes, for example, N-isopropylacrylamide, N-phenylmethacrylamide, N-(4-methoxycarbonylphenyl)methacrylamide, N.N-dimethylacrylamide and morpholinoacrylamide. The $\alpha$-hydroxymethylacrylate includes, for example, ethyl $\alpha$-hydroxymethylacrylate and cyclohexyl $\alpha$-hydroxymethylacrylate. The styrene derivative includes, for example, styrene and 4-tert-butylstyrene.

Preferable examples of the polyurethane resin according to the invention include polyurethane resins described in Paragraph Nos. [0099] to [0210] of JP-A-2007-187836, Paragraph Nos. [0019] to [0100] of JP-A-2008-276155, Paragraph Nos. [0018] to [0107] of JP-A-2005-250438, Paragraph Nos. [0021] to [0083] of JP-A-2005-250158.

Preferable examples of the polyvinyl butyral resin according to the invention include polyvinyl butyral resins described in Paragraph Nos. [0006] to [0013] of JP-A-2001-75279.

A part of the acidic groups in the binder polymer may be neutralized with a basic compound. The basic compound includes, for example, a basic nitrogen-containing compound, an alkali metal hydroxide or a quaternary ammonium hydroxide.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer, from the standpoint of good strength of the image area and good image-forming property.

The total content of the polymerizable compound and the binder polymer is preferably 90% by weight or less based on the total solid content of the photosensitive layer. When it exceeds 90% by weight, decrease in the sensitivity and deterioration in the developing property may be caused sometimes. The total content thereof is more preferably from 35 to 80% by weight.

(Other components of photosensitive layer)

It is preferred that the photosensitive layer according to the invention contain a sensitizing dye. The sensitizing dye can be used without particular limitation as far as it absorbs light at the image exposure to form the excited state and provides energy to the polymerization initiator described hereinbefore with electron transfer, energy transfer or heat generation thereby increasing the polymerization initiation function. In particular, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanine dyes, benzopyranes, coumarins, aromatic ketones, anthracenes, styryls and oxazoles.

Of the sensitizing dyes having an absorption maximum in a wavelength range from 300 to 450 nm, a dye represented by formula (IX) shown below is more preferred in view of high sensitivity.

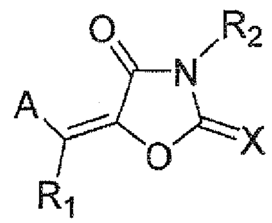

(IX)

In formula (IX), A represents an aryl group which may have a substituent or a heteroaryl group which may have a substituent, X represents an oxygen atom, a sulfur atom or $=N(R_3)$, and $R_1$, $R_2$ and $R_3$ each independently represents a monovalent non-metallic atomic group, or A and $R_1$ or $R_2$ and $R_3$ may be combined with each other to form an aliphatic or aromatic ring.

The monovalent non-metallic atomic group represented by any one of $R_1$, $R_2$ and $R_3$ in formula (IX) preferably includes a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group and a halogen atom.

The aryl group and heteroaryl group represented by A in formula (IX) are same as the substituted or unsubstituted aryl group and substituted or unsubstituted heteroaryl group described for any one of $R_1$, $R_2$ and $R_3$, respectively.

As specific examples of the sensitizing dye, compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816 are preferably used.

Further, sensitizing dyes described in JP-A-2006-189604, JP-A-2007-171406, JP-A-2007-206216, JP-A-2007-206217, JP-A-2007-225701, JP-A-2007-225702, JP-A-2007-316582 and JP-A-2007-328243 are also preferably used.

The sensitizing dye having an absorption maximum in a wavelength range from 750 to 1,400 (hereinafter, also referred to as an "infrared absorbing agent") is described below. The infrared absorbing agent used is preferably a dye or pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

(a)

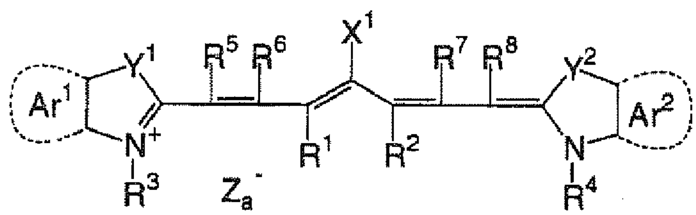

In formulae (a), $X^1$ represents a hydrogen atom, a halogen atom, $-NPh_2$, $X^2-L^1$ or a group shown below. $X^2$ represents an oxygen atom, a nitrogen atom or a sulfur atom, $L^1$ represents a hydrocarbon group having from 1 to 12 carbon atoms, an aryl group containing a hetero atom (a nitrogen atom, a sulfur atom, an oxygen atom, a halogen atom or a selenium atom) or a hydrocarbon group having from 1 to 12 carbon atoms and containing a hetero atom. $Xa^-$ has the same meaning as $Za^-$ defmed hereinafter. $R^a$ represents a hydrogen atom or a substituent selected from an alkyl group, an aryl group, a substituted or unsubstituted amino group and a halogen atom.

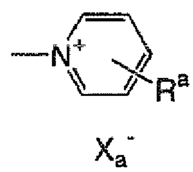

$R^1$ and $R^2$ each independently represents a hydrocarbon group having from 1 to 12 carbon atoms. In view of the preservation stability of a coating solution for photosensitive layer, it is preferred that $R^1$ and $R^2$ each represent a hydrocarbon group having two or more carbon atoms. It is also preferred that $R^1$ and $R^2$ be combined with each other to form a ring. When the ring is formed, a 5-membered or 6-membered ring is particularly preferred.

$Ar^1$ and $Ar^2$, which may be the same or different, each represents an aryl group which may have a substituent. Preferable examples of the aryl group include groups derived from a benzene ring group and a naphthalene ring group. Preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. Preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a), which can be suitably used in the invention, include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638. Preferably, compounds described in Paragraph Nos. [0034] to [0041] of JP-A-2002-278057 and Paragraph Nos. [0080] to [0086] of JP-A-2008-195018 are exemplified. Particularly preferably, compounds described in Paragraph Nos. [0035] to [0043] of JP-A-2007-90850 are exemplified.

Further, compounds described in Paragraph Nos. [0008] to [0009] of JP-A-5-5005 and Paragraph Nos. [0022] to [0025] of JP-A-2001-222101 are also preferably used.

The infrared absorbing dyes may be used only one kind or two or more kinds in combination. Also, the infrared absorbing dye may be used together with an infrared absorbing agent other than the infrared absorbing dye, for example, a pigment. As the pigment, compounds described in Paragraph Nos. [0072] to [0076] of JP-A-2008-195018 are preferably used.

As the pigment, commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink.Technology), CMC Publishing Co., Ltd. (1984) can be utilized.

The amount of the sensitizing dye added is preferably from 0.05 to 30 parts by weight, more preferably from 0.1 to 20 parts by weight, particularly preferably from 0.2 to 10 parts by weight, per 100 parts by weight of the total solid content of the photosensitive layer.

The photosensitive layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the photosensitive layer according to the invention, a thiol compound (for example, a 2-mereaptobenzimidazole, a 2-mercaptobenzothiazole, a 2-mercaptobenzoxazole, a 3-mercaptotriazole or a 5-mercaptotetrazole) is preferably used.

The amount of the chain transfer agent added is preferably from 0.01 to 20 parts by weight, more preferably from 1 to 10 parts by weight, particularly preferably from 1 to 5 parts by weight, per 100 parts by weight of the total solid content of the photosensitive layer.

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for

improving the developing property and dispersion stability of microcapsule, a coloring agent or print-out agent for visually distinguishing the image area from the non-image area, a polymerization inhibitor for preventing undesirable thermal polymerization of the polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity, and a plasticizer for improving plasticity. As the additives, known compounds, for example, compounds described in Paragraph Nos. [0161] to [0215] of JP-A-2007-20&217, Paragraph No. [0067] of JP-T-2005-509192 and Paragraph Nos. [0023] to [0026] and [0059] to [0066] of JP-A-2004-310000 are used. With respect to the surfactant, surfactants which may be added to the developer described hereinafter may be used.

Further, hydrophobilizing precursors described in Paragraph Nos. [0093] to [0105] of JP-A-2009-172790 and microcapsules or microgels described in Paragraph Nos. [0196] to [0275] of JP-A-2009-29124 may be used.

<Formation of photosensitive layer>

The photosensitive layer according to the invention is formed by dispersing or dissolving each of the necessary constituting components described above in a solvent to prepare a coating solution and coating the solution. The solvent used include, for example, methyl ethyl ketone, ethylene glycol monoethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying is preferably from 0.3 to 3.0 g/$m^2$. Various methods can be used for the coating. Examples of the method include bar coater coating, spin coating, spray coating, curtain coating, dip coating, air knife coating, blade coating and roll coating.

[Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. As a material for use in the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Among them, a water-soluble polymer compound relatively excellent in crystallizability is preferably used. Specifically, when polyvinyl alcohol is used as a main component, the particularly preferred results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As the polyvinyl alcohol, those having a hydrolysis degree of 69.0 to 100% by mole and a polymerization repeating unit number of 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. The content of polyvinyl alcohol in the protective layer is preferably from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. Specifically, modified polyvinyl alcohols described in JP-A-2005-250216 and 3P-A-2006-25913 are preferably exemplified.

When the polyvinyl alcohol is used as a mixture with other material, as the other materials mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

As other component of the protective layer, glycerin, dipropylene glycol or the like can be added in an amount corresponding to several % by weight of the material for the protective layer, for example, polyvinyl alcohol to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by weight of the material for the protective layer, for example, polyvinyl alcohol.

Further, it is also preferred to incorporate an inorganic stratiform compound into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful. Specifically, inorganic stratiform compounds described in JP-A-2005-119273 are preferably exemplified.
The coating amount of the protective layer is preferably in a range from 0.05 to 10 $glm^2$ in terms of the coating amount after drying. When the protective layer contains the inorganic stratiform compound, it is more preferably in a range from 0.1 to 5 $g/m^2$, and when the protective layer does not contain the inorganic stratiform compound, it is more preferably in a range from 0.5 to 5 $g/m^2$.

[Support]

The support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.
The center line average roughness of the support is preferably from 0.10 to 1.2 μm. In the range described above, good adhesion property to a layer provided on the support, good printing durability and good satin resistance are achieved.
The color density of the support is preferably from 0.15 to 0.65 in terms of the reflection density value. In the range described above, good image-forming property by preventing halation at the image exposure and good aptitude for plate inspection after development are achieved.
The thickness of the support is preferably from 0.1 to 0.6 mm, more preferably from 0.15 to 0.4 mm, and still more preferably from 0.2 to 0.3 mm.

[Hydrophilizing treatment of support]

As for the lithographic printing plate precursor according to the invention, in order to increase hydrophilicity of the non-image area and to prevent printing stain, it is preferred to conduct hydrophilizing treatment of the surface of support.
The hydrophilizing treatment of the surface of support includes an alkali metal silicate treatment wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

[Backcoat layer]

A backcoat layer can be provided on the back surface of the support, if desired. The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

[Method of preparing lithographic printing plate]

The lithographic printing plate precursor according to the invention is exposed imagewise and then subjected to development processing to prepare a lithographic printing plate.

<Image exposure>

The lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in the wavelength range is used. In case of exposing with light of 750 to 1,440 nm, the lithographic printing plate precursor containing an infrared absorbing agent which is a sensitizing dye having an absorption maximum in the wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

<Development processing>

The development processing ordinarily includes (1) a method of developing with an alkali developer (having pH higher than 11), (2) a method of developing with a developer having pH of 2 to 11, and (3) a method of developing (on-press development) by supplying dampening water and ink on a printing machine.

In the method of preparing a lithographic printing plate according to the invention, the method of developing with a developer having pH of 2 to 11 or the on-press development method is preferably used.

First, the method of developing with a developer having pH of 2 to 11 is described in detail below. According to a conventional developing process using the alkali developer as in the method (I), it is necessary that a protective layer is removed in a pre-water washing step, the alkali development is conducted, the alkali is removed by washing with water in a post-water washing step, gum solution treatment is conducted and drying is conducted in a drying step. On the contrary, according to the method of developing using the developer having pH of 2 to 11, it is possible to conduct the development and gum solution treatment at the same time by incorporating a surfactant or a water-soluble polymer compound into the developer. Thus, the post-water washing step is not particularly necessary, and after conducting the development and gum solution treatment with one solution, the drying step can be performed. Moreover, the pre-water washing step is also not particularly necessary and the removal of protective layer can also be conducted simultaneously with the development and gum solution treatment. It is preferred that after the development and gum treatment, the excess developer be removed using a squeeze roller, followed by conducting drying.

The development processing of the lithographic printing plate precursor according to the invention is performed at temperature from 0 to 60˚C, preferably from about 15 to about 40˚C in a conventional manner, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The development processing with the developer having pH of 2 to 11 is preferably performed by an automatic development processor equipped with a supplying means for the developer and a rubbing member. An automatic development processor using a rotating brush roller as the rubbing member is particularly preferred. The number of the rotating brush rollers is preferably two or more. Further, the automatic development processor is preferably provided with a means for removing the excess developer, for example, a squeeze roller or a drying means, for example, a hot air apparatus, subsequently to the development processing means. Further, the automatic development processor may be provided with a pre-heating means for conducting pre-heating treatment of dire lithographic printing plate precursor after image exposure prior to the development processing means.

The developer which is an aqueous solution having pH of 2 to 11 for use in the development processing is preferably an aqueous solution containing water as the main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 5 to 10.7, more preferably from 6 to 10.5, and particularly preferably from 7.5 to 10.3.

The anionic surfactant for use in the developer is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene alkylsulfonic acid salts, polyoxyethylene alkylsulfophenyl ether salts, N-akl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and conventionally known cationic surfactants can be used. Examples of the cationic surfactant include alkylamine salts, alkylimidazolinium salts, quaternary ammonium salts, polyoxyethylene alkyl amine salts and polyethylene polyamine derivatives.

The nonionic surfactant for use in the developer is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant for use in the developer is not particularly limited and includes, for example, amine oxide type, for example, alkyldimethylamine oxide, betaine type, for example, alkyl betaine, and amino acid type, for example, sodium salt of alkylamino fatty acid. In particular, alkyldimethylamine oxide which may have a substituent, alkyl carboxy betaine which may have a substituent and alkyl sulfo betaine which may have a substituent are preferably used. Specific examples of the amphoteric surfactant include compounds represented by formula (2) in Paragraph No. [0256] of JP-A-2008-203359, compounds represented by fonnulae (I), (II) and (VI) in Paragraph Nos. [0028] to [0030] of JP-A-2008-276166 and compounds described in Paragraph Nos. [0022] to [0029] of JP-A-2009-47927.

Two or more of the surfactants may be used in combination. The content of the surfactant in the developer is preferably from 0.01 to 20% by weight, and more preferably from 0.1 to 10% by weight.

The water-soluble polymer compound for use in the developer includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof polyvinyl pyrrolidone, polyvinylsulfonic acid or a salt thereof, polystyrenesulfonic acid or a salt thereof, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer, a pH buffer agent may further be incorporated. As the pH buffer agent, a pH buffer agent exhibiting a pH buffer function at pH of 2 to 11 is used without particular restriction. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. By the function of the pH buffer agent, fluctuation of the pH of developer is prevented even when the developer is used for a long period of time. As a result, for example, the deterioration of developing property resulting from the fluctuation of pH and the occurrence of development scum can be restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

The total amount of the carbonate ion and hydrogen carbonate ion is preferably from 0.05 to 5 mole/l, more preferably from 0.07 to 2 mole/l, particularly preferably from 0.1 to 1 mole/l, in the developer.

The developer may contain an organic solvent. As the organic solvent, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-l-hexanol, 1-nonanol; 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone). Two or more organic solvents may be used in combination in the developer

When the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer can be used as a developer and a development replenisher for the exposed lithographic printing plate precursor. It is preferably applied to the automatic development processor as described above. In the case of conducting the development processing using an automatic development processor, the developer becomes fatigued in accordance with the processing amount, and hence the processing ability may be restored using a replenisher or a fish developer.

Next, the on-press development method is described in detail below. According to the on-press development method, an imagewise exposed lithographic printing plate precursor is supplied with oily ink and an aqueous component on a printing machine without undergoing any development processing, thereby removing an unexposed area of the photosensitive layer to conduct development. The imagewise exposure may be conducted on a printing machine. In order to prevent that the aqueous component is contaminated with the components of the photosensitive layer removed, it is preferred to supply an oily ink first For the oily ink and aqueous component, printing ink and dampening water for conventional lithographic printing are used respectively.

In me method of preparing a lithographic printing plate according to the invention, the lithographic printing plate precursor may be heated its entire surface before the exposure, during the exposure or between the exposure and the development, if desired. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire surface after-heating or entire surface exposure to the image after the development. Ordinarily, the heating before the development is preferably performed under a mild condition of 150˚C or lower. When the temperature is too high, a problem may arise sometimes in that the unexposed area is also cured. On the other hand, the heating after the development can be performed using very strong conditions and is ordinarily carried out in a temperature range from 100 to 500˚C. When the temperature is too low, a sufficient effect of strengthening the image may not be obtained, whereas when it is excessively high, problems of deterioration of the support and thermal decomposition of the image area may occur sometimes.

## EXAMPLES

The present invention will be described in more detail with reference to the following examples, but the invention should not be construed as being limited thereto.

### Examples 1 to 50 and Comparative Examples 1 to 3

[Preparation of Lithographic printing plate precursor 1]

(Preparation of Support 1)

An aluminum plate (material: JIS A 1050) having a thickness of 0.3 mm was subjected to a decreasing treatment at 50˚C for 30 seconds using a 10% by weight aqueous sodium aluminate solution in order to remove rolling oil on the surface thereof and then grained the surface thereof using three nylon brushes embedded with bundles of nylon bristle

having a diameter of 0.3 mm and an aqueous suspension (specific gravity: 1.1 g/$m^3$) of pumice having a median size of 25 μm, followed by thorough washing with water, The plate was subjected to etching by immersing in a 25% by weight aqueous sodium hydroxide solution of 45˚C for 9 seconds, washed with water, then immersed in a 20% by weight aqueous nitric acid solution at 60˚C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50˚C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50˚C and under the condition that the quantity of electricity was 50 C/$dm^2$ in terms of the quantity of electricity when the aluminum plate functioned as an anode. The plate was then washed with water by spraying. The plate was then subjected to an anodizing treatment using as an electrolytic solution, a 15% by weight aqueous sulfuric acid solution (containing 0.5% by weight of aluminum ion) at a current density of 15 A/$dm^2$ to form a direct current anodized film of 2.5 g/$m^2$, washed with water and dried. The center line average roughness (Ra indication according to JIS B0601) of the surface of Support 1 thus-obtained was measured using a stylus having a diameter of 2 μm and found to be 0.51 μm.

(Formation of Intermediate layer)

Coating solution (1) for intermediate layer having the composition shown below was coated using a bar on Support 1 described above and dried in an oven at 80˚C for 10 seconds to form an intermediate layer having a dry coating amount of 10 mg/$m^2$.

<Coating solution (1) for intermediate layer>

| | |
|---|---|
| Polymer shown in Table A below | 0.017 g |
| Methanol | 9.00 g |
| Water | 1.00 g |

(Formation of Photosensitive layer and Protective layer)

On the intermediate layer described above, Coating solution (1) for photosensitive layer having the composition shown below was coated using a bar and dried in an oven at 70˚C for 60 seconds to form a photosensitive layer having a dry coating amount of 1.1 g/$m^2$. On the photosensitive layer, Coating solution (1) for protective layer having the composition shown below was coated using a bar so as to have a dry coating amount of 0.75 g/$m^2$ and dried at 125˚C for 70 seconds to form a protective layer, thereby preparing Lithographic printing plate precursor 1.

<Coating solution (1) for photosensitive layer>

| | |
|---|---|
| Binder Polymer (1) | 0.48 g |
| Methacrylic acid/methyl methacrylate copolymer (weight average molecular weight: 40,000, molar ratio: 30/70) | |
| Polymerizable Compound (1) shown below | 0.54 g |
| Sensitizing Dye (1) shown below | 0.06 g |

(continued)

| | |
|---|---|
| Polymerization Initiator (1) shown below | 0.08 g |
| Co-Sensitizer (1) shown below | 0.47 g |
| Dispersion of ε-phthalocyanine pigment [pigment: 15 parts by weight; dispersing agent (Binder Polymer (1)): 10 parts by weight; solvent: (cyclohexanone/methoxypropyl acetate/1-methoxy-2-propanol =15 parts by weight/20 parts by weight/40 parts by weight)] | 0.40 g |
| Thermal polymerization inhibitor N-Nitrosophenylhydroxylamine aluminum salt | 0.01 g |
| Fluorine-Based Surfactant (1) shown below (weight average molecular weight: 11,000) | 0.001 g |
| Polyoxyethylene-polyoxypropylene condensate (PLURONIC L44, produced by ADEKA Corp.) | 0.04 g |
| Tetraethylamine hydrochloride | 0.01 g |
| 1-Methoxy-2-propanol | 3.5 g |
| Methyl ethyl ketone | 8.0 g |

Sensitizing Dye (1):

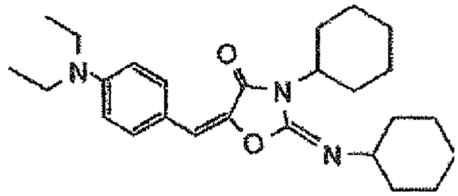

Polymerization Initiator (1):

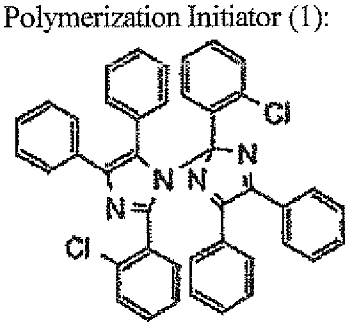

Co-Sensitizer (1):

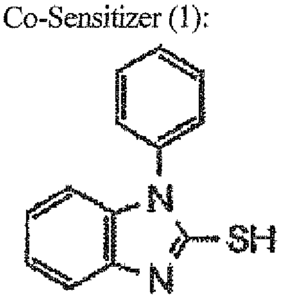

Fluorine-Based Surfactant (1):

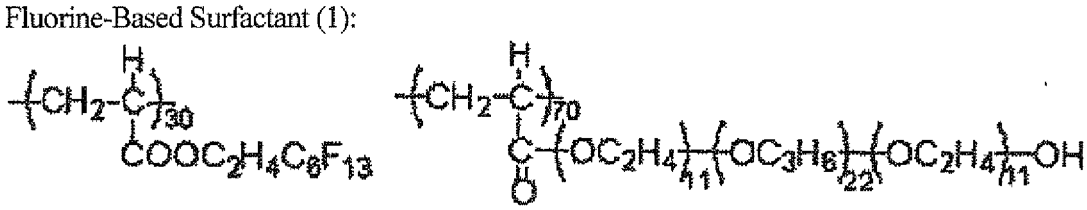

Polymerizable Compound (1):

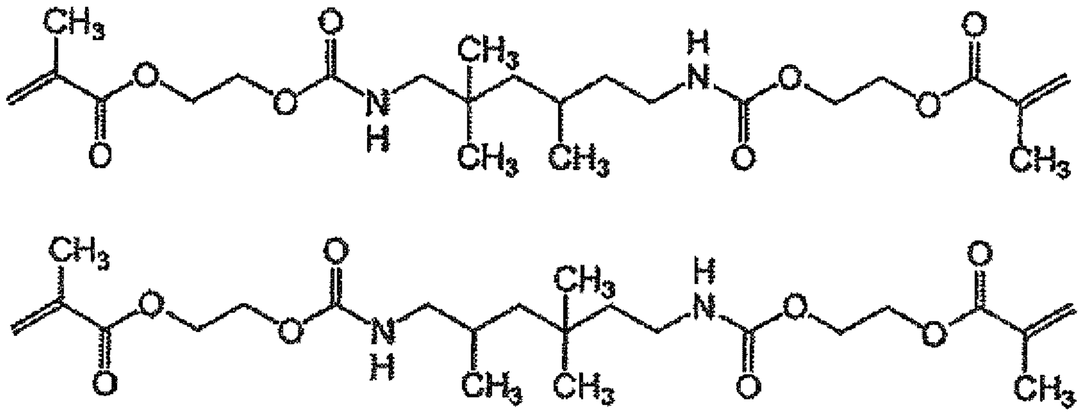

(Mixture of the isomers shown above)

<Coating solution (1) for protective layer>

| | |
|---|---|
| Polyvinyl alcohol (saponification degree: 98% by mole; polymerization degree: 500) | 40 g |
| Polyvinyl pyrrolidone (weight average molecular weight 50,000) | 5 g |
| Vinyl pyrrolidone/ vinyl acetate (1/1) copolymer (weight average molecular weight: 70,000) | 0.5 g |
| Surfactant (EMALEX 710, produced by Nihon- Emulsion Co., Ltd.) | 0.5 g |
| Water | 950 g |

[Preparation of Lithographic printing plate precursors 2 to 50 and Comparative lithographic printing plate precursors 1 to 3]

Lithographic printing plate precursors 2 to 50 and Comparative lithographic printing plate precursors 1 to 3 were prepared in the same manner as in the preparation of Lithographic printing plate precursor 1 except for changing the components used to those shown in Table A below, respectively. The respective components used are described below.

Binder Polymer (2)

Polyvinyl alcohol (weight average molecular weight: 50,000; saponification degree: 55%) Binder Polymer (3)
Polyvinyl butyral (weight average molecular weight: 80,000; butyral ratio: 65% by mole; acetate ratio: less than 1% by mole)

Binder Polymer (4)

Methacrylic acid/methyl methacrylate copolymer (weight average molecular weight: 50,000; molar ratio: 15/85)

Binder Polymer (5) (weight average molecular weight: 80,000):

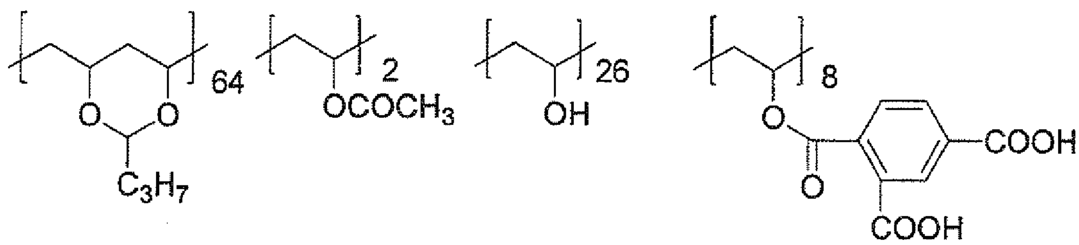

Binder Polymer (6) (weight average molecular weight: 70,000):

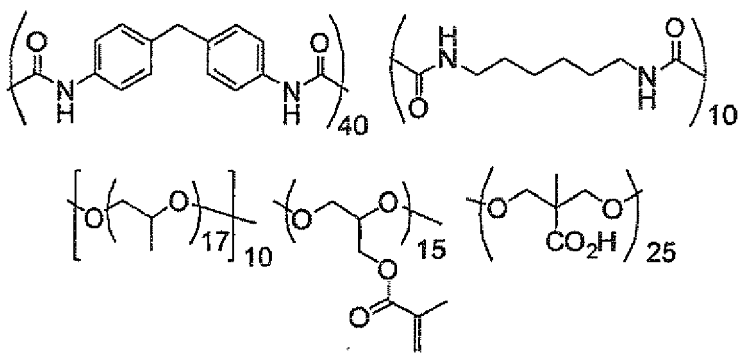

Polymerizable Compound (2):

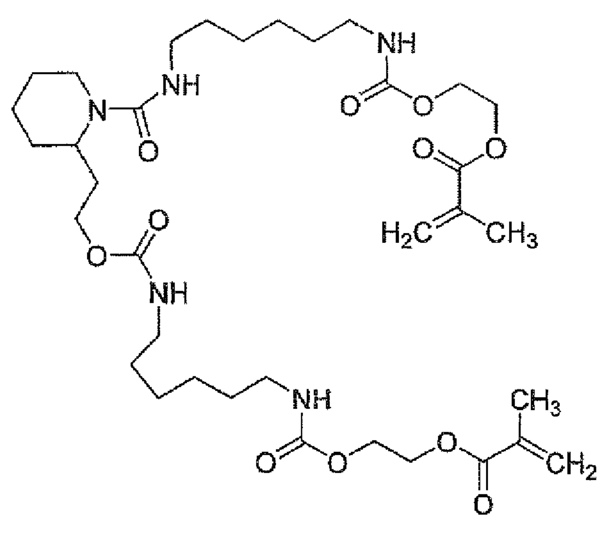

Polymerizable Compound (3):

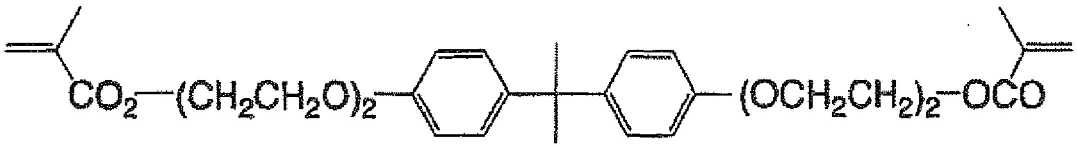

Sensitizing Dye (2):

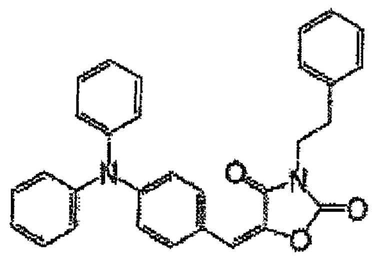

Sensitizing Dye (3)

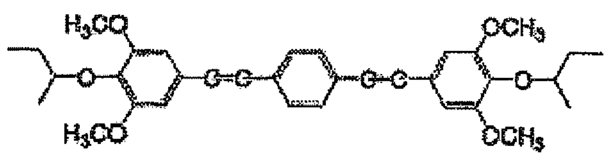

Polymerization Initiator (2)

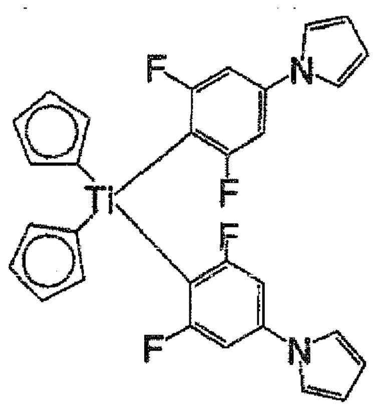

Co-Sensitizer (2)

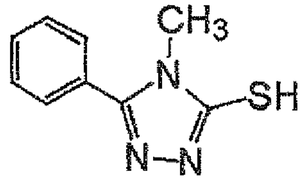

Co-Sensitizer (3)

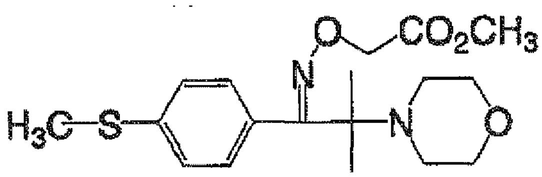

Co-Sensitizer (4):

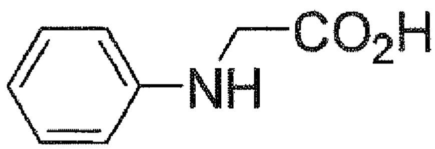

Comparative Polymers (DH-1), (DH-2), (DH-3), (DH-4) and (DH-5)

| | Composition Ratio (% by mole) (in a left-to-right order) | Molecular Weight (x$10^4$) |
|---|---|---|
| DH-1 | 65/25/10 | 2 |
| 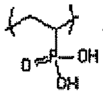 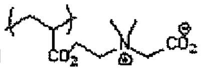 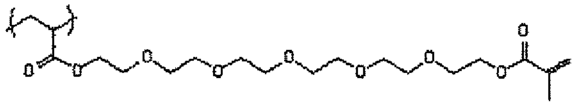 1.50 | | |
| DH-2 | 65/25/10 | 2 |
| 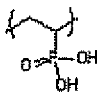 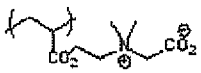 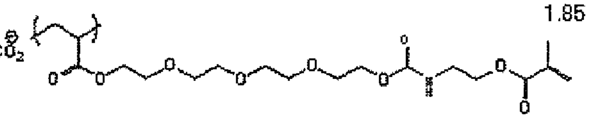 1.85 | | |
| DH-3 | 45/40/15 | 4 |
| 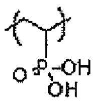 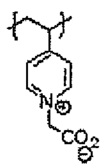 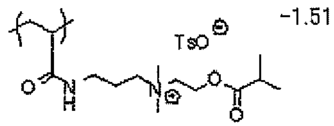 −1.51 | | |
| DH-4 | 45/50/5 | 7 |
| 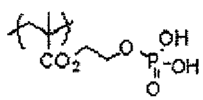 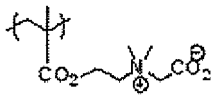 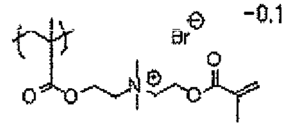 −0.13 | | |

(continued)

| | | Composition Ratio (% by mole) (in a left-to-right order) | Molecular Weight (x$10^4$) |
|---|---|---|---|
| | DH-5 | 45/50/5 | 8.5 |
| 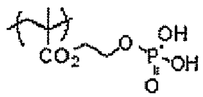 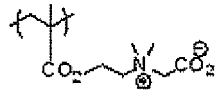 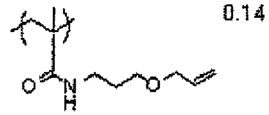 0.14 | | | |

[Exposure, Development and Printing]

Each of Lithographic printing plate precursors 1 to 50 and Comparative lithographic printing plate precursors 1 to 3 was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image exposure was conducted at a resolution of 2,438 dpi with halftone dots of 50% using an FM screen (TAFFETA 20, produced by FUJIFILM Corp.) under condition of a plate surface exposure amount of 0.05 mJ/cm$^2$.

Then, the exposed lithographic printing plate precursor was subjected to development processing in an automatic development processor having a structure as shown in Fig. 1 using each of Developers 1 to 3 having the composition shown below to prepare a lithographic printing plate (without heating). The automatic development processor had two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of the lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of the lithographic printing plate precursor. The transportation of the lithographic printing plate precursor was conducted at a transporting speed so as to regulate the immersion time (developing time) in the developer of 20 seconds.

The developer was supplied on the surface of the lithographic printing plate precursor by showering from a spray pipe using a circulation pump. The tank volume for the developer was 10 liters.

| | |
|---|---|
| Developer (1) (pH: 9.7) | |
| Water | 8329.8 g |
| Sodium carbonate | 130 g |
| Sodium hydrogen carbonate | 70 g |
| Surfactant (NEWCOL B 13, produced by Nippon Nyukazai Co., Ltd. (naphthol ethyleneoxide adduct)) | 500 g |
| Gum arabic (Mw: 200,000) | 250 g |
| Hydroxy-alkylated starch (PENON JE66, produced by Nippon Starch Chemical Co., Ltd.) | 700 g |
| Ammonium primary phosphate | 20 g |
| 2-Bromo-2-nitropropane-1,3-diol | 0.1 g |
| 2-Methyl-4-isothiazolin-3 -one | 0.1 g |
| Developer (2) (pH: 9.7) | |
| Water | 8260 g |
| Potassium carbonate | 150 g |
| Potassium hydrogen carbonate | 80 g |
| Surfactant (ELEMINOL MON, produced by Sanyo Chemical Industries, Ltd. (sodium alkyldiphenyl ether disulfonate) (calculated in terms of 100%)) | 350 g |
| Yellow dextrin (AKADAMA DEXTRIN 102, produced by Nippon Starch Chemical Co., Ltd.) | 800 g |
| Ammonium primary phosphate | 180 g |
| Sodium hexametaphosphate | 180 g |

| | |
|---|---|
| Developer (3) (pH: 7.0) | |
| Water | 88.6 g |
| Nonionic Surfactant (W-1) shown below | 2.4 g |
| Nonionic Surfactant (W-2) shown below | 2.4 g |
| Nonionic surfactant (EMALEX 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |

(continued)

| | |
|---|---|
| Developer (3) (pH: 7.0) | |
| Polystyrenesulfonic acid (VERSA TL77 (30% solution) produced by Alco Chemical Inc.) | 1.0 g |
| (pH was adjusted to 7.0 by adding phosphoric acid) | |

Nonionic Surfactant (W-1):

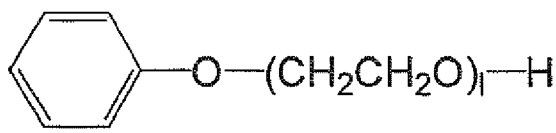

l=13-28

Nonionic Surfactant (W-2):

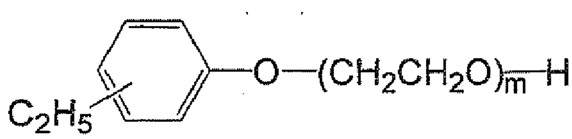

m=12-26

The lithographic printing plate thus-obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dai-Nippon Ink & Chemicals, Inc.).

[Evaluation]

With each lithographic printing plate precursor, stain resistance, stain resistance after preservation, printing durability and chemical resistance were evaluated in the manner described below. The results obtained are shown in Table A.

<Stain resistance>

The 500th sheet of the printed material from the initiation of printing was picked up and the density of ink adhered on the non-image area was measured to relatively evaluate the stain resistance. Specifically, the stain resistance was calculated according to the formula shown below using Comparative Example 1 as the criterion (100). When the value is larger, it is meant that the density of ink adhered on the non-image area is lower, that is, the stain resistance is better.

Stain resistance = (Ink density of non-image area on printed material from criterion lithographic printing plate) /(Ink density of non-image area on printed material from subject lithographic printing plate) x 100

<Stain resistance after preservation>

The lithographic printing plate precursor was preserved at 60°C for 3 days and then subjected to the exposure, development, printing and evaluation of stain resistance in the same manner as described above. As the criterion (100), the stain resistance of Comparative Example 1 without preservation was used.

<Printing durability>

As increase in the number of printing sheets according to the printing described above, the photosensitive layer was gradually abraded to cause decrease in the ink receptivity, resulting in decrease of ink density on a printed material. A number of printed materials obtained until the ink density (reflection density) decreased by 0.1 from that at the initiation of printing was determined to evaluate the printing durability. Specifically, the printing durability was relatively evaluated by calculating according to the formula shown below using the number of printing sheets (10,000 sheets) of Comparative Example 1 as the criterion (100). When the value is larger, it is meant that the printing durability is higher.
Printing durability = (Number of printed materials of subject lithographic printing plate)/(Number of printed materials of criterion lithographic printing plate) x 100

<Chemical resistance>

On the lithographic printing plate obtained by the exposure and development described above was dropped a stock solution of dampening water (VEGRA E794/858, produced by Vegra GmbH) and after 30 minutes the lithographic printing plate was washed with water. A Scotch brand tape (produced by 3M) was stuck on the dropped area of the lithographic printing plate and then the tape was peeled off. The dropped area of the lithographic printing plate was visually observed to evaluate the chemical resistance according to the following criteria. The symbol "A" indicates that the chemical resistance is best.
A: The trace of the dropped area was not found.
B: Although the trace of the dropped area was found, the halftone dots were not changed.
C: The trace of the dropped area was found to be thin due to the decrease in density and the halftone dots also became thin.
D: The dropped area itself became white.

TABLE A

| | Lithographic Printing Plate Precursor | Polymerin Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
|---|---|---|---|---|---|---|---|---|---|---|---|---|
| Example 1 | 1 | D-1 | 1 | 1 | 1 | 1 | 1 | 1 | 170 | 150 | 120 | A |
| Comparative Example 1 | Comparative Precursor 1 | DH-1 | 1 | 1 | 1 | 1 | 1 | 1 | 100 | 10 | 100 | C |
| Comparative Example 2 | Comparative Precursor 2 | DH-2 | 1 | 1 | 1 | 1 | 1 | 1 | 100 | 20 | 80 | D |
| Example 2 | 2 | D-3 | 1 | 1 | 6 | 1 | 3 | 1 | 170 | 160 | 140 | A |
| Example 3 | 3 | D-6 | 1 | 1 | 4 | 3 | 1 | 1 | 180 | 170 | 120 | A |
| Example 4 | 4 | D-8 | 2 | 1 | 1 | 2 | 1 | 1 | 180 | 170 | 130 | A |
| Example 5 | 5 | D-9 | 1 | 1 | 2 | 1 | 2 | 2 | 170 | 160 | 150 | A |
| Example 6 | 6 | D-11 | 1 | 1 | 1 | 1 | 1 | 1 | 190 | 180 | 150 | A |
| Example 7 | 7 | D-12 | 1 | 1 | 6 | 1 | 1 | 2 | 180 | 170 | 150 | A |
| Example 8 | 8 | D-13 | 1 | 2 | 5 | 3 | 4 | 1 | 180 | 170 | 140 | A |
| Example 9 | 9 | D-14 | 1 | 1 | 1 | 1 | 1 | 1 | 180 | 170 | 140 | A |
| Example 10 | 10 | D-15 | 2 | 1 | 3 | 2 | 1 | 1 | 190 | 180 | 140 | A |
| Example 11 | 11 | D-18 | 1 | 1 | 1 | 1 | 1 | 1 | 180 | 170 | 150 | A |
| Example 12 | 12 | D-21 | 1 | 1 | 1 | 1 | 3 | 1 | 180 | 170 | 120 | A |
| Example 13 | 13 | D-23 | 1 | 3 | 5 | 3 | 1 | 1 | 190 | 180 | 120 | A |

(continued)

| | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
|---|---|---|---|---|---|---|---|---|---|---|---|---|
| Example 14 | 14 | D-24 | 1 | 1 | 1 | 1 | 1 | 1 | 180 | 170 | 150 | A |
| Comparative Example 2 | Comparative Precursor 3 | DH-3 | 1 | 1 | 1 | 1 | 1 | 1 | 180 | 170 | 70 | C |
| Example 15 | 15 | D-27 | 1 | 1 | 1 | 1 | 2 | 1 | 190 | 180 | 150 | A |
| Example 16 | 16 | D-29 | 1 | 1 | 4 | 3 | 1 | 2 | 200 | 190 | 140 | A |
| Example 17 | 17 | D-31 | 2 | 1 | 1 | 2 | 1 | 1 | 200 | 190 | 140 | A |
| Example 18 | 18 | D-32 | 1 | 1 | 1 | 1 | 1 | 1 | 200 | 190 | 150 | A |
| Example 20 | 20 | D-35 | 2 | 1 | 1 | 2 | 1 | 1 | 200 | 190 | 130 | A |
| Example 21 | 21 | D-36 | 1 | 1 | 1 | 1 | 1 | 1 | 210 | 200 | 140 | A |
| Example 22 | 22 | D-39 | 1 | 2 | 4 | 3 | 1 | 2 | 210 | 200 | 140 | A |
| Example 23 | 23 | D-41 | 1 | 1 | 1 | 1 | 3 | 1 | 210 | 190 | 120 | A |
| Example 24 | 24 | D-43 | 1 | 1 | 1 | 1 | 1 | 2 | 210 | 200 | 140 | A |
| Example 25 | 25 | D-45 | 1 | 1 | 1 | 1 | 1 | 1 | 210 | 200 | 120 | A |

(continued)

| | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
|---|---|---|---|---|---|---|---|---|---|---|---|---|
| Example 26 | 26 | D-46 | 1 | 1 | 1 | 1 | 1 | 1 | 170 | 170 | 120 | A |
| Example 27 | 27 | D-47 | 1 | 1 | 1 | 1 | 1 | 1 | 170 | 160 | 120 | A |
| Example 28 | 28 | D-48 | 1 | 1 | 1 | 1 | 1 | 1 | 170 | 160 | 140 | A |
| Example 29 | 29 | D-49 | 1 | 1 | 1 | 1 | 1 | 1 | 180 | 170 | 140 | A |
| Example 30 | 30 | D-50 | 1 | 1 | 1 | 1 | 1 | 1 | 190 | 180 | 140 | A |
| Example 31 | 31 | D-51 | 1 | 1 | 1 | 1 | 1 | 1 | 180 | 170 | 120 | A |
| Example 32 | 32 | D-52 | 1 | 1 | 1 | 1 | 1 | 1 | 180 | 170 | 120 | A |
| Example 33 | 33 | D-53 | 1 | 1 | 1 | 1 | 1 | 1 | 180 | 170 | 120 | A |
| Example 34 | 34 | D-54 | 1 | 1 | 1 | 1 | 1 | 1 | 180 | 170 | 140 | A |
| Example 35 | 35 | D-55 | 1 | 1 | 1 | 1 | 1 | 1 | 180 | 170 | 130 | A |
| Example 36 | 36 | D-56 | 1 | 1 | 1 | 1 | 1 | 1 | 180 | 170 | 130 | A |
| Example 37 | 37 | D-57 | 1 | 1 | 1 | 1 | 1 | 1 | 180 | 170 | 120 | A |
| Example 38 | 38 | D-58 | 1 | 1 | 1 | 1 | 1 | 1 | 180 | 170 | 120 | A |

(continued)

| | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
|---|---|---|---|---|---|---|---|---|---|---|---|---|
| Example 39 | 39 | D-59 | 1 | 1 | 1 | 1 | 1 | 1 | 180 | 170 | 120 | C |
| Example 40 | 40 | D-60 | 1 | 1 | 1 | 1 | 1 | 1 | 180 | 170 | 130 | A |
| Example 41 | 41 | D-61 | 1 | 1 | 1 | 1 | 1 | 1 | 210 | 200 | 130 | A |
| Example 42 | 42 | D-62 | 1 | 1 | 1 | 1 | 1 | 1 | 200 | 190 | 130 | A |
| Example 43 | 43 | D-63 | 1 | 1 | 1 | 1 | 1 | 1 | 200 | 190 | 130 | A |
| Example 44 | 44 | D-64 | 1 | 1 | 1 | 1 | 1 | 1 | 180 | 170 | 130 | A |
| Example 45 | 45 | D-65 | 1 | 1 | 1 | 1 | 1 | 1 | 190 | 180 | 130 | A |
| Example 46 | 46 | D-66 | 1 | 1 | 1 | 1 | 1 | 1 | 160 | 150 | 130 | A |
| Example 47 | 47 | D-67 | 1 | 1 | 1 | 1 | 1 | 1 | 170 | 160 | 140 | A |
| Example 48 | 48 | D-68 | 1 | 1 | 1 | 1 | 1 | 1 | 180 | 170 | 150 | A |
| Example 49 | 49 | D-69 | 1 | 1 | 1 | 1 | 1 | 1 | 190 | 180 | 160 | A |
| Example 50 | 50 | D-70 | 1 | 1 | 1 | 1 | 1 | 1 | 210 | 200 | 160 | A |

As is apparent from the results shown in Table A, the lithographic printing plate precursor according to the invention can provide a lithographic printing plate excellent in the stain resistance, stain resistance after preservation, printing durability and chemical resistance in spite of one solution processing using the neutral to weak alkaline developer.

Examples 51 to 100 and Comparative Examples 4 to 6

Each of Lithographic printing plate precursors 1 to 50 and Comparative lithographic printing plate precursors 1 to 3 was subjected to the laser imagewise exposure in the same manner as in Example 1. Within 30 seconds after the laser imagewise exposure, the exposed lithographic printing plate precursor was put in an oven, heated the entire surface of the lithographic printing plate precursor by blowing hot air to maintain at 110˚C for 15 seconds and then subjected to the development processing within 30 seconds in the same manner as in Example 1 to prepare a lithographic printing plate (with heating). The resulting lithographic printing plate was subjected to the evaluation of stain resistance, stain resistance after preservation, printing durability and chemical resistance in the same manner as in Example 1. The results obtained are shown in Table B.

TABLE B

| | Lithographic Printing Plate Precursor | Polymer in Intermediate Layer | Stain Resistance | Stain Resistance after Preservation | Printing Durability | Chemical Resistance |
|---|---|---|---|---|---|---|
| Example 51 | 1 | D-1 | 160 | 150 | 130 | A |
| Comparative Example 4 | Comparative Precursor 1 | DH-1 | 95 | 10 | 110 | C |
| Comparative Example 5 | Comparative Precursor 2 | DH-2 | 95 | 20 | 90 | C |
| Example 52 | 2 | D-3 | 160 | 150 | 150 | A |
| Example 53 | 3 | D-6 | 170 | 160 | 130 | A |
| Example 54 | 4 | D-8 | 170 | 160 | 140 | A |
| Example 55 | 5 | D-9 | 160 | 150 | 160 | A |
| Example 56 | 6 | D-11 | 180 | 170 | 160 | A |
| Example 57 | 7 | D-12 | 170 | 160 | 160 | A |
| Example 58 | 8 | D-13 | 170 | 160 | 150 | A |
| Example 59 | 9 | D-14 | 170 | 160 | 150 | A |
| Example 60 | 10 | D-15 | 180 | 170 | 150 | A |
| Example 61 | 11 | D-18 | 170 | 160 | 160 | A |
| Example 62 | 12 | D-21 | 170 | 160 | 130 | A |
| Example 63 | 13 | D-23 | 180 | 170 | 130 | A |
| Example 64 | 14 | D-24 | 170 | 160 | 160 | A |
| Comparative Example 6 | Comparative Precursor 3 | DH-3 | 170 | 160 | 80 | C |
| Example 65 | 15 | D-27 | 180 | 170 | 160 | A |
| Example 66 | 16 | D-29 | 190 | 180 | 150 | A |
| Example 67 | 17 | D-31 | 190 | 180 | 150 | A |
| Example 68 | 18 | D-32 | 190 | 180 | 160 | A |
| Example 70 | 20 | D-35 | 190 | 180 | 140 | A |
| Example 71 | 21 | D-36 | 200 | 190 | 150 | A |

(continued)

| | Lithographic Printing Plate Precursor | Polymer in Intermediate Layer | Stain Resistance | Stain Resistance after Preservation | Printing Durability | Chemical Resistance |
|---|---|---|---|---|---|---|
| Example 72 | 22 | D-39 | 200 | 190 | 150 | A |
| Example 73 | 23 | D-41 | 200 | 180 | 130 | A |
| Example 74 | 24 | D-43 | 200 | 190 | 150 | A |
| Example 75 | 25 | D-45 | 200 | 190 | 130 | A |
| Example 76 | 26 | D-46 | 160 | 160 | 130 | A |
| Example 77 | 27 | D-47 | 160 | 150 | 130 | A |
| Example 78 | 28 | D-48 | 160 | 150 | 150 | A |
| Example 79 | 29 | D-49 | 170 | 160 | 150 | A |
| Example 80 | 30 | D-50 | 180 | 170 | 150 | A |
| Example 81 | 31 | D-51 | 170 | 160 | 130 | A |
| Example 82 | 32 | D-52 | 170 | 160 | 130 | A |
| Example 83 | 33 | D-53 | 170 | 160 | 130 | A |
| Example 84 | 34 | D-54 | 170 | 160 | 150 | A |
| Example 85 | 35 | D-55 | 170 | 160 | 140 | A |
| Example 86 | 36 | D-56 | 170 | 160 | 140 | A |
| Example 87 | 37 | D-57 | 170 | 160 | 130 | A |
| Example 88 | 38 | D-58 | 170 | 160 | 130 | A |
| Example 89 | 39 | D-59 | 170 | 160 | 130 | A |
| Example 90 | 40 | D-60 | 170 | 160 | 140 | A |
| Example 91 | 41 | D-61 | 200 | 190 | 140 | A |
| Example 92 | 42 | D-62 | 190 | 180 | 140 | A |
| Example 93 | 43 | D-63 | 190 | 180 | 140 | A |
| Example 94 | 44 | D-64 | 170 | 160 | 140 | A |
| Example 95 | 45 | D-65 | 180 | 170 | 140 | A |
| Example 96 | 46 | D-66 | 150 | 140 | 140 | A |
| Example 97 | 47 | D-67 | 160 | 150 | 150 | A |
| Example 98 | 48 | D-68 | 170 | 160 | 160 | A |
| Example 99 | 49 | D-69 | 180 | 170 | 170 | A |
| Example 100 | 50 | D-70 | 200 | 190 | 170 | A |

As is apparent from the results shown in Table B, the lithographic printing plate precursor according to the invention can provide a lithographic printing plate excellent in the stain resistance, stain resistance after preservation, printing durability and chemical resistance, even when the heat treatment was conducted between the image exposure and development processing.

Examples 101 to 150 and Comparative Examples 7 to 10

[Preparation of Lithographic printing plate precursor 51]

(Preparation of Support 2)

An aluminum plate (material: 1050, refining: H16) having a thickness of 0.24 mm was immersed in an aqueous 5% by weight sodium hydroxide solution maintained at 65˚C to conduct a degreasing treatment for one minute, followed by washed with water. The aluminum plate was immersed in an aqueous 10% by weight hydrochloric acid solution maintained at 25˚C for one minute to neutralize, followed by washed with water. Subsequently, the aluminum plate was subjected to an electrolytic surface-roughening treatment with alternating current under condition of current density of 100 A/$dm^2$ in an aqueous 0.3% by weight hydrochloric acid solution at 25˚C for 60 seconds and then subjected to a desmut treatment in an aqueous 5% by weight sodium hydroxide solution maintained at 60˚C for 10 seconds. The aluminum plate was subjected to an anodizing treatment under condition of current density of 10 A/$dm^2$ and voltage of 15 V in an aqueous 15% by weight sulfuric acid solution at 25˚C for one minute and then subjected to a hydrophilizing treatment using an aqueous 1% by weight polyvinyl phosphonic acid solution at 75˚C to prepare Support 2. The surface roughness of the support was measured and found to be 0.44 μm (Ra indication according to JIS B0601).

(Formation of Intermediate layer)

On support 2 described above was formed the intermediate layer in the same manner as in Lithographic printing plate precursor 1.

(Formation of Photosensitive layer)

Coating solution (2) for photosensitive layer having the composition shown below was coated on the intermediate layer described above using a bar and dried in an oven at 90˚C for 60 seconds to form a photosensitive layer having a dry coating amount of 1.3 g/$m^2$.

| | |
|---|---|
| <Coating solution (2) for photosensitive layer> | |
| Binder Polymer (4) shown above | 0.04 g |
| Binder Polymer (5) shown above | 0.30 g |
| Polymerizable Compound (1) shown above | 0.17 g |
| Polymerizable Compound (2) shown above | 0.51 g |
| Sensitizing Dye (4) shown below | 0.03 g |
| Sensitizing Dye (5) shown below | 0.015 g |
| Sensitizing Dye (6) shown below | 0.015 g |
| Polymerization Initiator (1) shown above | 0.13 g |
| Chain Transfer Agent | 0.01 g |
| Mercaptobenzothiazole | |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |

| | |
|---|---|
| Thermal polymerization inhibitor | 0.01 g |
| N- Nitrosophenylhydroxylamine aluminum salt | |
| Fluorine-Based Surfactant (1) shown above (weight average molecular weight: 11,000) | 0.001 g |
| 1-Methoxy-2-propanol | 3.5 g |
| Methyl ethyl ketone | 8.0 g |

Sensitizing Dye (4):

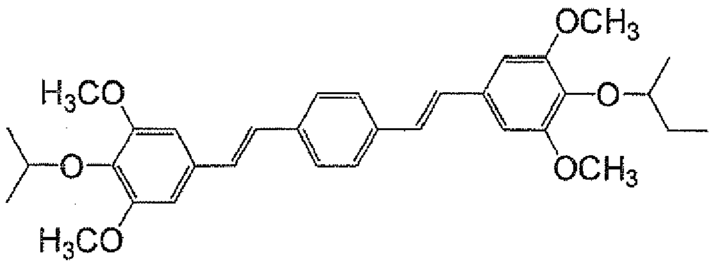

Sensitizing Dye (5):

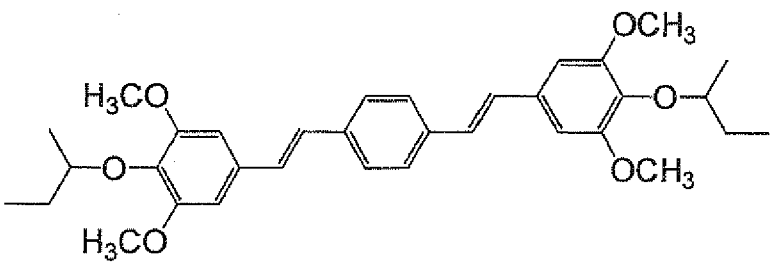

Sensitizing Dye (6):

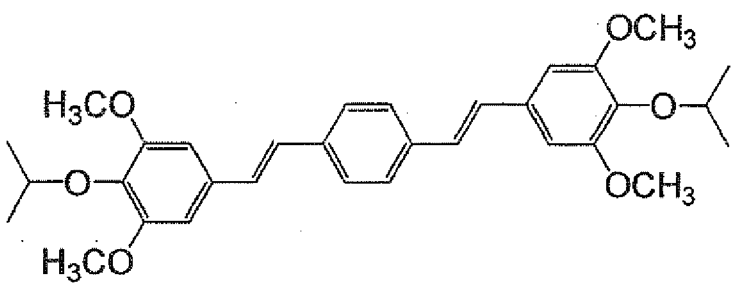

(Formation of Protective layer)

Coating solution (2) for protective layer having the composition shown below was coated on the photosensitive layer described above using a bar so as to have a dry coating amount of 1.2 g/m$^2$ and dried at 125°C for 70 seconds to form a protective layer, thereby preparing Lithographic printing plate precursor 51.

<Coating solution (2) for protective layer>

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C)] | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

[Preparation of Lithographic printing plate precursors 52 to 75 and Comparative lithographic printing plate precursors 4 and 5]

Lithographic printing plate precursors 52 to 75 and Comparative lithographic printing plate precursors 4 and 5 were prepared in the same manner as in the preparation of Lithographic printing plate precursor 51 except for changing the polymer used in the intermediate layer to the compound shown in Table C below, respectively.

[Exposure, Development, Printing and Evaluation]

Using each of the lithographic printing plate precursors, the exposure, development, printing and evaluation were conducted in the same manner as in Example 1 with respect to Examples 101 to 125 and Comparative Examples 7 and 8. Also, the exposure, development, printing and evaluation were conducted in the same manner as in Example 51 with respect to Examples 126 to 150 and Comparative Examples 9 and 10. However, as the developer, Developer (3) described above was used. The results obtained are shown in Table C.

TABLE C

| | Lithographic Printing Plate Precursor | Polymer in Intermediate Layer | Stain Resistance | Stain Resistance After Preservation | Printing Durability | Chemical Resistance | | Stain Resistance | Stain Resistance After Preservation | Printing Durability | Chemical Resistance |
|---|---|---|---|---|---|---|---|---|---|---|---|
| Example 101 | 51 | D-1 | 160 | 150 | 110 | A | Example 126 | 150 | 140 | 120 | A |
| Comparative Example 7 | Comparative Precursor 4 | DH-1 | 100 | 20 | 110 | D | Comparative Example 9 | 90 | 10 | 120 | C |
| Comparative Example 8 | Comparative Precursor 5 | DH-2 | 80 | 20 | 110 | D | Comparative Example 10 | 70 | 10 | 120 | C |
| Example 102 | 52 | D-3 | 160 | 150 | 130 | A | Example 127 | 150 | 140 | 140 | A |
| Example 103 | 53 | D-6 | 170 | 160 | 110 | A | Example 128 | 160 | 150 | 120 | A |
| Example 104 | 54 | D-8 | 170 | 160 | 120 | A | Example 129 | 160 | 150 | 130 | A |
| Example 105 | 55 | D-9 | 160 | 150 | 140 | A | Example 130 | 150 | 140 | 150 | A |
| Example 106 | 56 | D-11 | 180 | 170 | 140 | A | Example 131 | 170 | 160 | 150 | A |
| Example 107 | 57 | D-12 | 170 | 160 | 140 | A | Example 132 | 160 | 150 | 150 | A |
| Example 108 | 58 | D-13 | 170 | 160 | 130 | A | Example 133 | 160 | 150 | 140 | A |
| Example 109 | 59 | D-14 | 170 | 160 | 130 | A | Example 134 | 160 | 150 | 140 | A |
| Example 110 | 60 | D-15 | 180 | 170 | 130 | A | Example 135 | 170 | 160 | 140 | A |

(continued)

| | Lithographic Printing Plate Precursor | Polymer in Intermediate Layer | Stain Resistance | Stain Resistance After Preservation | Printing Durability | Chemical Resistance | | Stain Resistance | Stain Resistance After Preservation | Printing Durability | Chemical Resistance |
|---|---|---|---|---|---|---|---|---|---|---|---|
| Example 111 | 61 | D-18 | 170 | 160 | 140 | A | Example 136 | 160 | 150 | 150 | A |
| Example 112 | 62 | D-21 | 170 | 160 | 110 | A | Example 137 | 160 | 150 | 120 | A |
| Example 113 | 63 | D-23 | 180 | 170 | 110 | A | Example 138 | 170 | 160 | 120 | A |
| Example 114 | 64 | D-24 | 170 | 160 | 140 | A | Example 939 | 160 | 150 | 150 | A |
| Example 115 | 65 | D-27 | 180 | 170 | 140 | A | Example 140 | 170 | 160 | 150 | A |
| Example 116 | 66 | D-29 | 190 | 180 | 130 | A | Example 141 | 180 | 170 | 140 | A |
| Example 117 | 67 | D-31 | 190 | 180 | 130 | A | Example 142 | 180 | 170 | 140 | A |
| Example 118 | 68 | D-32 | 190 | 180 | 140 | A | Example 143 | 180 | 170 | 150 | A |
| Example 120 | 70 | D-35 | 190 | 180 | 120 | A | Example 145 | 180 | 170 | 130 | A |
| Example 121 | 71 | D-36 | 200 | 190 | 130 | A | Example 146 | 190 | 180 | 140 | A |
| Example 122 | 72 | D-39 | 200 | 190 | 130 | A | Example 147 | 190 | 180 | 140 | A |
| Example 123 | 73 | D-41 | 200 | 180 | 110 | A | Example 148 | 190 | 170 | 120 | A |
| Example 124 | 74 | D-43 | 200 | 190 | 130 | A | Example 149 | 190 | 180 | 140 | A |

(continued)

| | Lithographic Printing Plate Precursor | Polymer in Intermediate Layer | Stain Resistance | Stain Resistance After Preservation | Printing Durability | Chemical Resistance | | Stain Resistance | Stain Resistance After Preservation | Printing Durability | Chemical Resistance |
|---|---|---|---|---|---|---|---|---|---|---|---|
| Example 125 | 75 | D-45 | 200 | 190 | 110 | A | Example 150 | 190 | 180 | 120 | A |

As is apparent from the results shown in Table C, the lithographic printing plate precursor according to the invention can provide a lithographic printing plate excellent in the stain resistance, stain resistance after preservation, printing durability and chemical resistance, in spite of the components of the photosensitive layer.

Examples 151 to 177 and Comparative Examples 11 and 12

[Preparation of Lithographic printing plate precursor 76]

(Formation of Intermediate layer)

Coating solution (2) for intermediate layer shown below was coated using a bar on Support 1 described above so as to have a dry coating amount of 20 mg/$m^2$ and dried in an oven at 80˚C for 10 seconds to form an intermediate layer.

<Coating solution (2) for intermediate layer>

| | |
|---|---|
| Polymer shown in Table D below | 0.18 g |
| Hydroxyethyliminodiacetic acid | 0.10 g |
| Methanol | 55.24 g |
| Water | 6.15 g |

(Formation of Photosensitive layer)

Coating solution (3) for photosensitive layer having the composition shown below was coated on the intermediate layer described above using a bar and dried in an oven at 100˚C for 60 seconds to form a photosensitive layer having a dry coating amount of 1.0 g/$m^2$.

Coating solution (3) for photosensitive layer was prepared by mixing Photosensitive solution (1) shown below with Microgel solution (1) shown below just before the coating, followed by stirring.

<Photosensitive solution (1)>

| | |
|---|---|
| Binder Polymer (7) shown above | 0.240 g |
| Infrared Absorbing Dye (1) shown below | 0.030 g |
| Radical Generator (1) shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic Low Molecular Weight Compound (1) shown below | 0.050 g |
| Oil-sensitizing agent (Phosphonium Compound (I) shown below) | 0.055 g |
| Oil-sensitizing agent (Benzyl dimethyl octyl ammonium $PF_6$ salt | 0.018 g |
| Oil-sensitizing agent (Ammonium group-containing polymer shown below (reduced specific viscosity: 44 cSt/g/ml)) | 0.035 g |
| Fluorine-Based Surfactant (1) shown below | 0.008 g |
| 2-Butanone | 1.091 g |
| 1-Methoxy-2-propanol | 8.609 g |

<Microgel solution (1)>

| | |
|---|---|
| Microgel (1) shown below | 2.640 g |
| Distilled water | 2.425 g |

The structures of Binder Polymer (7), Infrared Absorbing Dye (1), Radical Generator (1), Hydrophilic Low Molecular Weight Compound (1), Phosphonium Compound (1), the ammonium group-containing polymer and Fluorine-Based Surfactant (1) are shown below.

Binder Polymer (7) (weight average molecular weight: 70,000):

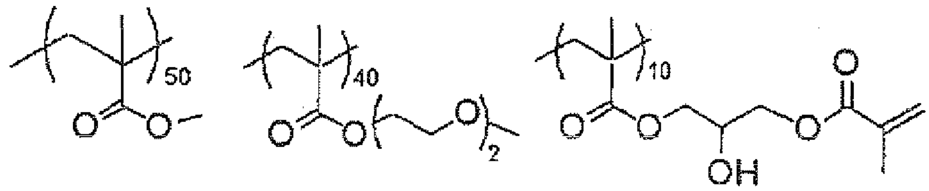

Ammonium group-containing polymer;

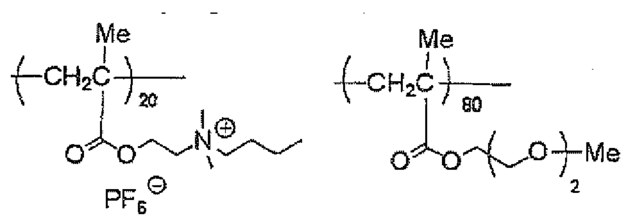

Infrared Absorbing Dye (1):

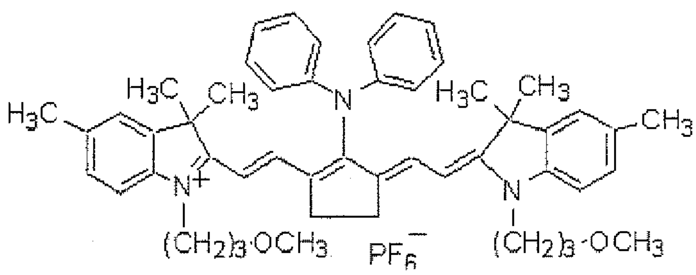

Fluorine-Based Surfactant (1):

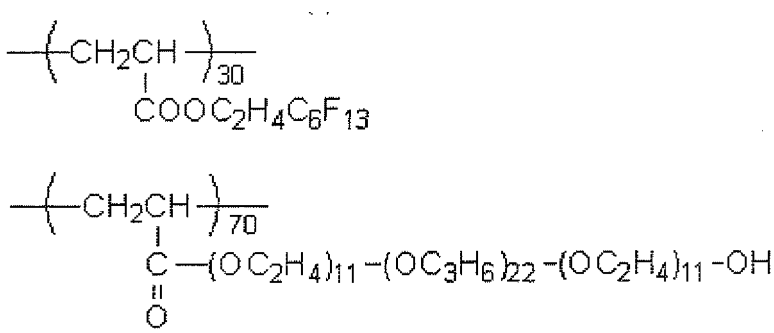

(weight average molecular weight: 13,000)

Phosphonium Compound (1):

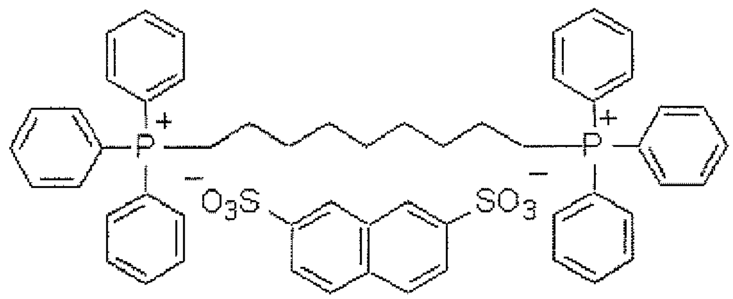

Hydrophilic Low Molecular Weight Compound (1):

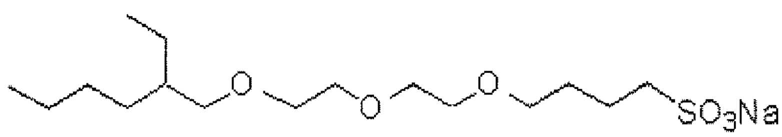

Radical Generator (1):

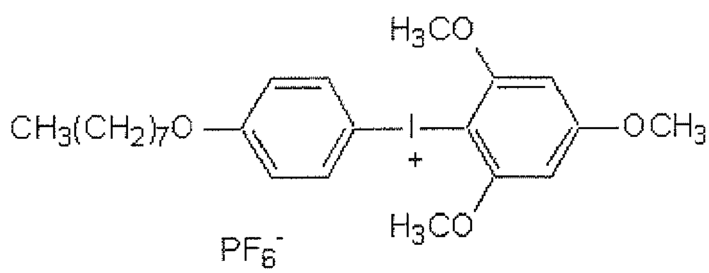

<Microgel (1)>

An oil phase component was prepared by dissolving 10 g of adduct of trimethylol propane and xylene diisocyanate (TAKENTATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of PVA-205 was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50˚C for 3 hours. The microgel liquid thus-obtained was diluted using distilled water so as to have the solid concentration of 15% by weight to prepare Microgel (1). The average particle size of the microgel was measured by a light scattering method and found to be 0.2 μm.

(Formation of Protective layer)

Coating solution (3) for protective layer having the composition shown below was coated on the photosensitive layer described above using a bar and dried in an oven at 120˚C for 60 seconds to form a protective layer having a dry

coating amount of 0.15 g/m$^2$, thereby preparing Lithographic printing plate precursor 76.

| | |
|---|---|
| <Coating solution (3) for protective layer> | |
| Dispersion of Inorganic stratiform compound (1) shown below | 1.5 g |
| Polyvinyl alcohol (CKS 50, produced by Nippon Synthetic Chemical Industry Co., Ltd., sulfonic acid-modified, saponification degree: 99% by mole or more, polymerization degree: 300, aqueous 6% by weight solution) | 0.55 g |
| Polyvinyl alcohol (PVA-405, produced by Kuraray Co., Ltd., saponification degree: 81.5 % by mole, polymerization degree: 500, aqueous 6% by weight solution) | 0.03 g |
| Surfactant (EMALEX 710, produced by Nihon Emulsion Co., Ltd., aqueous 1% by weight solution) | 0.86 g |
| Ion-exchanged water | 6.0 g |

<Dispersion of Inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm to prepare Dispersion of Inorganic stratiform compound (1). The aspect ratio of the particle thus-dispersed was 100 or more.

[Preparation of Lithographic printing plate precursors 77 to 88 and 91 to 102 and Comparative lithographic printing plate precursors 6 and 7]

Lithographic printing plate precursors 77 to 88 and 91 to 102 and Comparative lithographic printing plate precursors 6 and 7 were prepared in the same manner as in the preparation of Lithographic printing plate precursor 76 except for changing the polymer used in the intermediate layer to the compound shown in Table D below, respectively.

[Preparation of Lithographic printing plate precursor 89]

The intermediate layer was formed in the same manner as in the preparation of Lithographic printing plate precursor 76 except for changing the polymer used in the intermediate layer to the compound shown in Table D below.

Coating solution (4) for photosensitive layer shown below was coated on the intermediate layer described above using a bar and dried in an oven at 70˚C for 60 seconds to form a photosensitive layer having a dry coating amount of 0.6 g/m$^2$, thereby preparing Lithographic printing plate precursor 89.

| | |
|---|---|
| <Coating solution (4) for photosensitive layer> | |
| Aqueous dispersion of Fine polymer particle (1) shown below | 20.0 g |
| Infrared Absorbing Dye (2) shown below | 0.2 g |
| Polymerization initiator (IRGACURE 250, produced by Ciba Specialty Chemicals, Inc.) | 0.5 g |
| Polymerizable compound (SR-399, produced by Sartomer Co.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 17.0 g |

The compounds indicated using their trade names in the coating solution for photosensitive layer above are shown below.

IRGACURE 250: (4-Methoxyphenyl)[4-(2-methylpropyl)phenyl]iodonium hexafluorophosphate (75% by weight propylene carbonate solution)

SR-399: Dipentaerythritol pentaacrylate

BYK 336: Modified dimethylpolysiloxane copolymer (25% by weight xylene/methoxypropyl acetate solution)

KLUCEL M: Hydroxypropyl cellulose (2% by weight aqueous solution)

ELVACITE 4026: Highly branched polymethyl methacrylate (10% by weight 2-butanone solution)

Infrared Absorbing Dye (2):

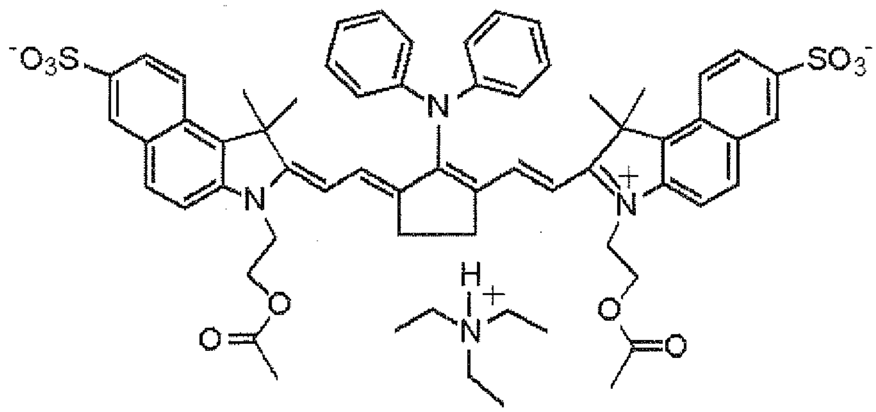

<Aqueous dispersion of Fine polymer particle (1)>

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average number of ethylene glycol repeating units: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the reaction was continued as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 38% or more to obtain Aqueous dispersion of Fine polymer particle (1) of PEGMA/St/AN (10/10/80 in a weight ratio). The particle size distribution of the fine polymer particle had the maximum value at the particle size of 150 nm.

The particle size distribution was determined by taking an electron microphotograph of the fine polymer particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

[Evaluation]

With each lithographic printing plate precursor, stain resistance, stain resistance after preservation and UV ink printing durability were evaluated in the manner described below. The results obtained are shown in Table D.

<Stain resistance>

Each lithographic printing plate precursor was exposed by LUXEL PLATESETTER T-6000III equipped with an infrared semiconductor laser, produced by FUJIFILM Corp. under the conditions of a rotational number of an external drum of 1,000 rpm, a laser output of 70% and a resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and BEST CURE UV-BF-WRO Standard Black Ink (produced by T&K TOKA Co., Ltd.), the dampening water and ink were supplied according to the standard automatic printing start method of LITHRONE 26 to conduct printing on 100 sheets of TOKUBISHI ART PAPER (76.5 kg) at a printing speed of 10,000 sheets per hour.

After the completion of the on-press development of the unexposed area of the photosensitive layer on the printing machine, the supply amount of the dampening water was reduced and the whole surface of the printing plate

was contaminated with the ink. Then, the supply amount of the dampening water was increased and a number of the printing papers required until the ink was completely removed from the non-image area to obtain good printed material was measured. The stain resistance was relatively evaluated by calculating according to the formula shown below using Comparative lithographic printing plate precursor 6 as the criterion (100). When the value is larger, it is meant that the stain resistance is better.

Stain resistance = (Number of printed materials of criterion lithographic printing plate)/(Number of printed materials of subject lithographic printing plate) x 100

<Stain resistance after preservation>

The lithographic printing plate precursor was preserved at 60˚C for 3 days and then the evaluation of stain resistance was conducted in the same manner as described above. As the criterion (100), the stain resistance of Comparative lithographic printing plate precursor 6 without preservation was used. When the value is larger, it is meant that the stain resistance after preservation is better.

<UV ink printing durability>

After the evaluation of stain resistance, the printing was continued. As increase in the number of printing sheets, the photosensitive layer was gradually abraded so that the ink density on a printed material decreased. A number of printed materials obtained until a value obtained by measuring a halftone dot area ratio of 50% halftone of FM screen on the printed material decreased by 5% from the value measured on the $100^{th}$ printed material was measured. The UV ink printing durability was relatively evaluated by calculating according to the formula shown below using

Comparative lithographic printing plate precursor 6 as the criterion (100).

UV ink printing durability = (Number of printed materials of subject lithographic printing plate)/(Number of printed materials of criterion lithographic printing plate) x 100

TABLE D

| | Lithographic Printing Plate Precursor | Polymer in Intermediate Layer | Coating Solution for <Photosensitive Layer | Coating Solution for Protective Layer | Stain Resistance | Stain Resistance After Preservation | UV Ink Printing Durability |
|---|---|---|---|---|---|---|---|
| Example 151 | 76 | D-1 | 3 | 3 | 160 | 150 | 130 |
| Comparative Example 11 | Comparative Precursor 6 | DH-4 | 3 | 3 | 100 | 15 | 100 |
| Comparative Example 12 | Comparative Precursor 7 | DH-5 | 3 | 3 | 100 | 20 | 80 |
| Example 152 | 77 | D-3 | 3 | 3 | 160 | 150 | 150 |
| Example 153 | 78 | D-6 | 3 | 3 | 170 | 160 | 130 |
| Example 154 | 79 | D-8 | 3 | 3 | 170 | 160 | 140 |
| Example 155 | 80 | D-9 | 3 | 3 | 160 | 150 | 160 |
| Example 156 | 81 | D-11 | 3 | 3 | 180 | 170 | 160 |
| Example 157 | 82 | D-12 | 3 | 3 | 170 | 160 | 160 |
| Example 158 | 83 | D-13 | 3 | 3 | 170 | 160 | 150 |
| Example 159 | 84 | D-14 | 3 | 3 | 170 | 160 | 150 |
| Example 160 | 85 | D-15 | 3 | 3 | 180 | 170 | 150 |
| Example 161 | 86 | D-18 | 3 | 3 | 170 | 160 | 160 |
| Example 162 | 87 | D-21 | 3 | 3 | 170 | 160 | 130 |
| Example 163 | 88 | D-23 | 3 | 3 | 180 | 170 | 130 |
| Example 164 | 89 | D-23 | 4 | None | 180 | 170 | 130 |
| Example 166 | 91 | D-24 | 3 | 3 | 170 | 160 | 160 |
| Example 167 | 92 | D-27 | 3 | 3 | 180 | 170 | 160 |
| Example 168 | 93 | D-29 | 3 | 3 | 190 | 180 | 150 |
| Example 169 | 94 | D-31 | 3 | 3 | 190 | 180 | 150 |
| Example 170 | 95 | D-32 | 3 | 3 | 190 | 180 | |

(continued)

| | Lithographic Printing Plate Precursor | Polymer in Intermediate Layer | Coating Solution for <Photosensitive Layer | Coating Solution for Protective Layer | Stain Resistance | Stain Resistance After Preservation | UV Ink Printing Durability |
|---|---|---|---|---|---|---|---|
| Example 172 | 97 | D-35 | 3 | 3 | 190 | 180 | 140 |
| Example 173 | 98 | D-36 | 3 | 3 | 200 | 190 | 150 |
| Example 174 | 99 | D-39 | 3 | 3 | 200 | 190 | 150 |
| Example 175 | 100 | D-41 | 3 | 3 | 200 | 180 | 130 |
| Example 176 | 101 | D-43 | 3 | 3 | 200 | 190 | 150 |
| Example 177 | 102 | D-45 | 3 | 3 | 200 | 190 | 130 |

As is apparent from the results shown in Table D, the lithographic printing plate precursor according to the invention can provide a lithographic printing plate excellent in the stain resistance, stain resistance after preservation and UV ink printing durability according to the on-press development method.

## Claims

**1.** A lithographic printing plate precursor comprising, in the following order:

a support;
an intermediate layer comprising a copolymer containing a repeating unit derived from a monomer having a C log P value of -0.14 or less and containing a carbon-carbon unsaturated double bond through a covalent bond in a side chain of the monomer; and
an image-forming layer comprising (A) a polymerization initiator, (B) a polymerizable compound and (C) a binder polymer.

**2.** The lithographic printing plate precursor as claimed in claim 1, wherein the repeating unit comprises at least one structure selected from a carboxylate anion, a sulfonate anion, a sulfate anion, a phosphate anion, a phosphonate anion, an ammonium cation, a phosphonium cation and a hydroxy group.

**3.** The lithographic printing plate precursor as claimed in claim 1 or 2, wherein the C log P value of the monomer for forming the repeating unit is -0.16 or less.

**4.** The lithographic printing plate precursor as claimed in any one of claims 1 to 3, wherein the repeating unit is a repeating unit represented by one of the following formulae (I) to (VI):

(I)

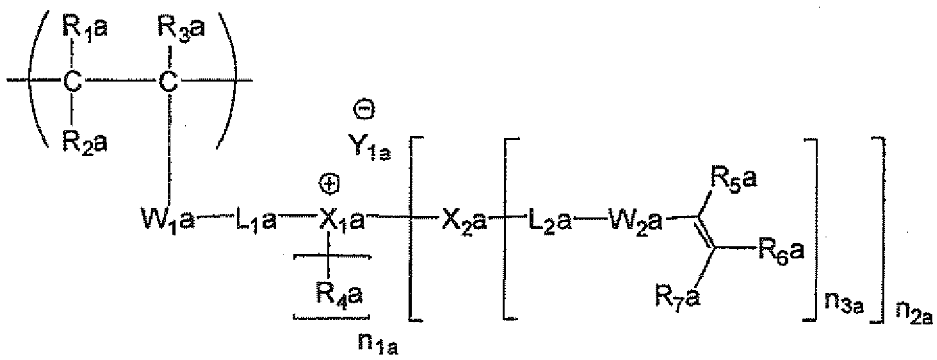

(II)

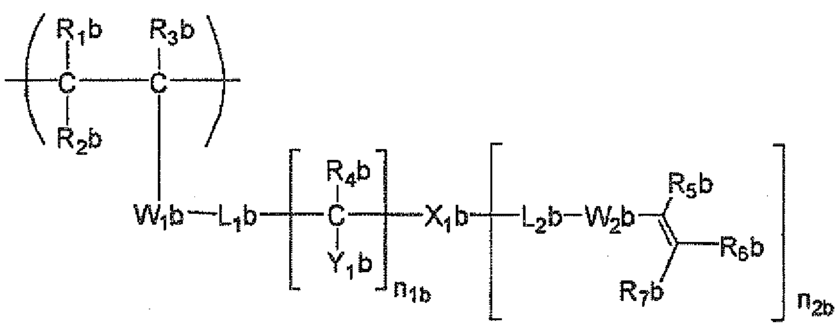

(III)

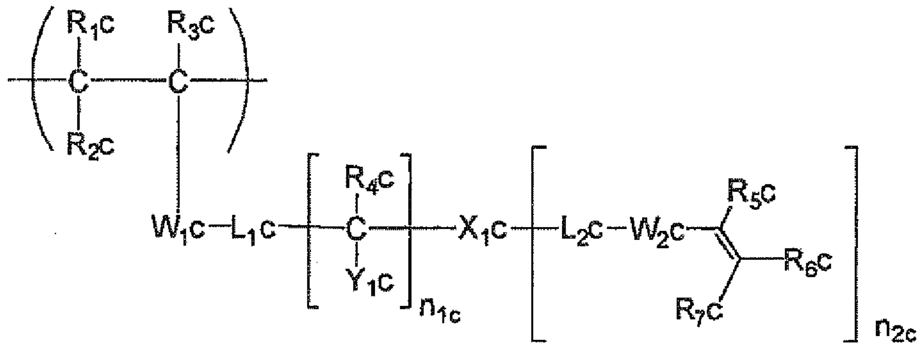

(IV)

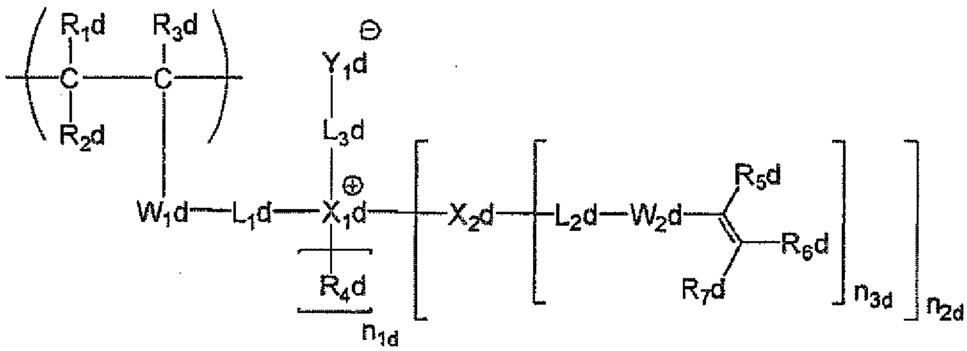

(V)

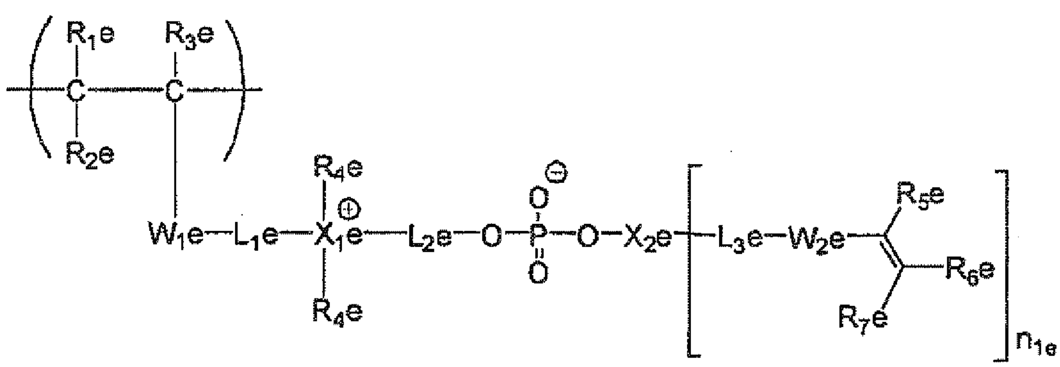

(VI)

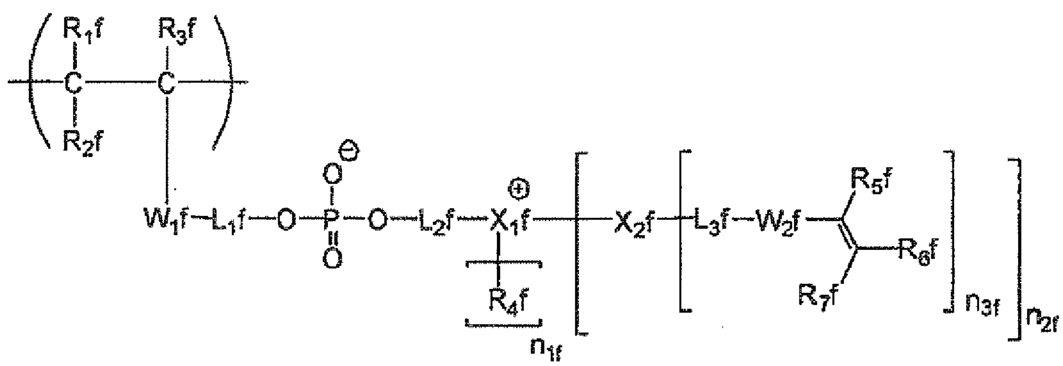

wherein, in the formula (I),
$R_1$a to $R_3$a each represents a hydrogen atom, an alkyl group, a halogen atom or a cyano group, $R_4$a each represents a hydrogen atom or a substituent having from 1 to 30 carbon atoms, $R_5$a to $R_7$a each represents a hydrogen atom, an alkyl group, -CO-O-Rx or -CO-N(Ry)(Rz), Rx represents an allyl group,
Ry and Rz each represents a hydrogen atom, an alkyl group or an aryl group,
$L_1$a and $L_2$a each represents a single bond or a divalent connecting group,
$W_1$a and $W_2$a each represents an alkylene group, an arylene group, -O-, -S-, -CO-, -N(Rw)-, $-SO_2-$ or a divalent connecting group composed of an appropriate combination of these groups, Rw represents a hydrogen atom, an alkyl group or an aryl group,
$X_1$a represents N or P,
$X_2$a represents an ($n_3$a+1) valent connecting group, provided that when $n_3$a is 1, $X_2$a represents a single bond,
$Y_1$a represents an organic or inorganic anion,
$n_1$a represents an integer from 0 to 2,
$n_2$a represents an integer from 1 to 3, provided that $n_1$a + $n_2$a = 3,
$n_3$a represents an integer from 1 to 4;
in the formula (II),
$R_1$b to $R_3$b, $R_4$b, $R_5$b to $R_7$b, $L_1$b, $L_2$b, $W_1$b and $W_2$b have the same meanings as $R_1$a to $R_3$a, $R_4$a, $R_5$a to $R_7$a, $L_1$a, $L_2$a, $W_1$a and $W_2$a in the formula (I), respectively,
$X_1$b represents an ($n_2$b + 1) valent connecting group, provided that when $n_2$b is 1, $X_1$b represents a single bond,
$Y_1$b each represents a hydrogen atom, a hydroxy group or an alkyl group, provided that at least one of $Y_1$b represents a hydroxy group,
$n_1$b represents an integer from 1 to 10,
$n_2$b represents an integer from 1 to 4;
in the formula (III),
$R_1$c to $R_3$c, $R_4$c, $R_5$c to $R_7$c, $L_1$c, $L_2$c, $W_1$c and $W_2$c have the same meanings as $R_1$a to $R_3$a, $R_4$a, $R_5$a to $R_7$a, $L_1$a, $L_2$a, $W_1$a and $W_2$a in the formula (I), respectively,
$n_1$c and $n_2$c have the same meanings as $n_1$b and $n_2$b in the formula (II), respectively, $X_1$c represents an ($n_2$c + 1) valent connecting group, provided that when $n_2$c is I, $X_1$c represents a single bond,
$Y_1$c each represents a hydrogen atom, a hydroxy group, an alkyl group or a group represented by $L_3$c-Q, provided that at least one of $Y_1$c represents a group represented by $L_3$c-Q,
$L_3$c represents a single bond or a divalent connecting group,
Q represents $-CO_2M-SO_3M$, $-OSO_3M$, $-OPO(OM_1)(OM_2)$ or $-PO(OM_3)(OM_4)$, M, $M_1$ and $M_3$ each represents a monovalent metal ion or $N^+(R_0)_4$,
$M_2$ and $M_4$ each represents a hydrogen atom, a monovalent metal ion or $N^+(R_0)_4$,
$R_0$ each represents a hydrogen atom or an alkyl group; in the formula (IV),
$R_1$d to $R_3$d, $R_4$d, $R_5$d to $R_7$d, $L_1$d, $L_2$d, $W_1$d, $W_2$d, $n_3$d and $X_1$d have the same meanings as $R_1$a to $R_3$a, $R_4$a, $R_5$a to $R_7$a, $L_1$a, $L_2$a, $W_1$a, $W_2$a, $n_3$a and $X_1$a in the formula (I), respectively,
$L_3$d represents a divalent connecting group,
$X_2$d represents an ($n_3$d + 1) valent connecting group, provided that when $n_3$d is 1, $X_2$d represents a single bond,
$Y_1$d represents $-CO_2^-$, $-SO_3^-$ or -OPO(O)(ORp),

Rp represents an alkyl group,
$n_1d$ represents 0 or 1,
$n_2d$ represents 1 or 2, provided that $n_1d + n_2d = 2$; in the formula (V),
$R_1e$ to $R_3e$, $R_4e$, $R_5e$ to $R_7e$, $W_1e$, $W_2e$ and $X_1e$ have the same meanings as $R_1a$ to $R_3a$, $R_4a$, $R_5a$ to $R_7a$, $W_1a$, $W_2a$ and $X_1a$ in the formula (I), respectively,
$L_1e$ and $L_2e$ have the same meanings as $L_1a$ in the formula (I), respectively,
$L_3e$ has the same meaning as $L_2a$ in the formula (I),
$n_1e$ has the same meaning as $n_2b$ in the formula (II),
$X_2e$ represents an ($n_1e$ + 1) valent connecting group, provided that when $n_1e$ is 1, $X_2e$ represents a single bond; and in the formula (VI),
$R_1f$ to $R_3f$, $R_4f$, $R_5f$ to $R_7f$, $W_1f$, $W_2f$, $X_1f$, $X_2f$ and $n_1f$ to $n_3f$ have the same meanings as $R_1a$ to $R_3a$, $R_4a$, $R_5a$ to $R_7a$, $W_1a$, $W_2a$, $X_1a$, $X_2a$ and $n_1a$ to $n_3a$ in the formula (I), respectively,
$L_1f$ and $L_2f$ have the same meanings as $L_1a$ in the formula (I), respectively,
$L_3f$ has the same meaning as $L_2a$ in the formula (I).

**5.** The lithographic printing plate precursor as claimed in claim 4, wherein in the formula (I), $W_1a$ is -CO-O- or -CO-N(Rw)-, and $X_1a$ is N; in formula (II), $W_1b$ is -CO-O- or -CO-N(Rw)-; in formula (III), $W_1c$ is -CO-O- or -CO-N(Rw)-, and Q is $-SO_3M$, $-OPO(OM_1)(OM_2)$ or $-PO(OM_3)(OM_4)$; in formula (IV), $W_1d$ is -CO-O- or -CO-N(Rw)-, $X_1d$ is N, and $Y_1d$ is $-CO_2^-$, $-SO_3^-$ or $-OPO(O^-)(ORp)$; in formula (V), $W_1e$ is -CO-O- or -CO-N(Rw)-, and $X_1e$ is N; or in formula (VI), $W_1f$ is -CO-O- or -CO-N(Rw)-, and $X_1f$ is N.

**6.** The lithographic printing plate precursor as claimed in any one of claims 1 to 5, wherein the C log P value of the monomer for forming the repeating unit is -1.0 or less.

**7.** The lithographic printing plate precursor as claimed in any one of claims 1 to 6, wherein the copolymer contains a repeating unit having as a functional group capable of interacting with a surface of the support, a sulfonic acid group or a salt thereof, a phosphoric acid ester group or a salt thereof or a phosphonic acid group or a salt thereof

**8.** The lithographic printing plate precursor as claimed in any one of claims 1 to 7, wherein the image-forming layer further comprises a sensitizing dye.

**9.** The lithographic printing plate precursor as claimed in claim 8, wherein the sensitizing dye is a sensitizing dye having an absorption maximum in a wavelength range from 300 to 450 nm.

**10.** The lithographic printing plate precursor as claimed in claim 8, wherein the sensitizing dye is an infrared absorbing agent.

**11.** The lithographic printing plate precursor as claimed in any one of claims 1 to 10, wherein the image-forming layer further comprises a hydrophobilizing precursor.

**12.** The lithographic printing plate precursor as claimed in any one of claims 1 to 11, wherein the image-forming layer further comprises at least one selected from a microcapsule and a microgel.

**13.** The lithographic printing plate precursor as claimed in any one of claims 1 to 12, wherein the binder polymer is a (meth)acrylic polymer, a polyurethane resin or a polyvinyl butyral resin.

**14.** The lithographic printing plate precursor as claimed in any one of claims 1 to 13, wherein the binder polymer has an ethylenically unsaturated bond group.

**15.** The lithographic printing plate precursor as claimed in any one of claims 1 to 14, which further comprises a protective layer, so that the support, the intermediate layer, the image-forming layer and the protective layer are provided in this order.

**16.** The lithographic printing plate precursor as claimed in claim 15, wherein the protective layer comprises an inorganic stratiform compound.

**17.** A method of preparing a lithographic printing plate comprising:

imagewise exposing a lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in a side chain of the monomer and an image-forming layer containing (A) a polymerization initiator, (B) a polymerizable compound and (C) a binder polymer; and
removing an unexposed area of the image-forming layer by supplying oily ink and an aqueous component on a printing machine to initiate printing without applying any development processing to the exposed lithographic printing plate precursor.

**18.** A method of preparing a lithographic printing plate comprising:

imagewise exposing a lithographic printing plate precursor comprising, in the following order, a support, an intermediate layer containing a copolymer containing a repeating unit derived from a monomer having a C log P value of -0.14 or less and containing a carbon-carbon unsaturated double bond through a covalent bond in a side chain of the monomer and an image-forming layer containing (A) a polymerization initiator, (B) a polymerizable compound and (C) a binder polymer; and
removing an unexposed area of the image-forming layer by processing the exposed lithographic printing plate precursor with a developer having pH of 2 to 11.

FIG. 1

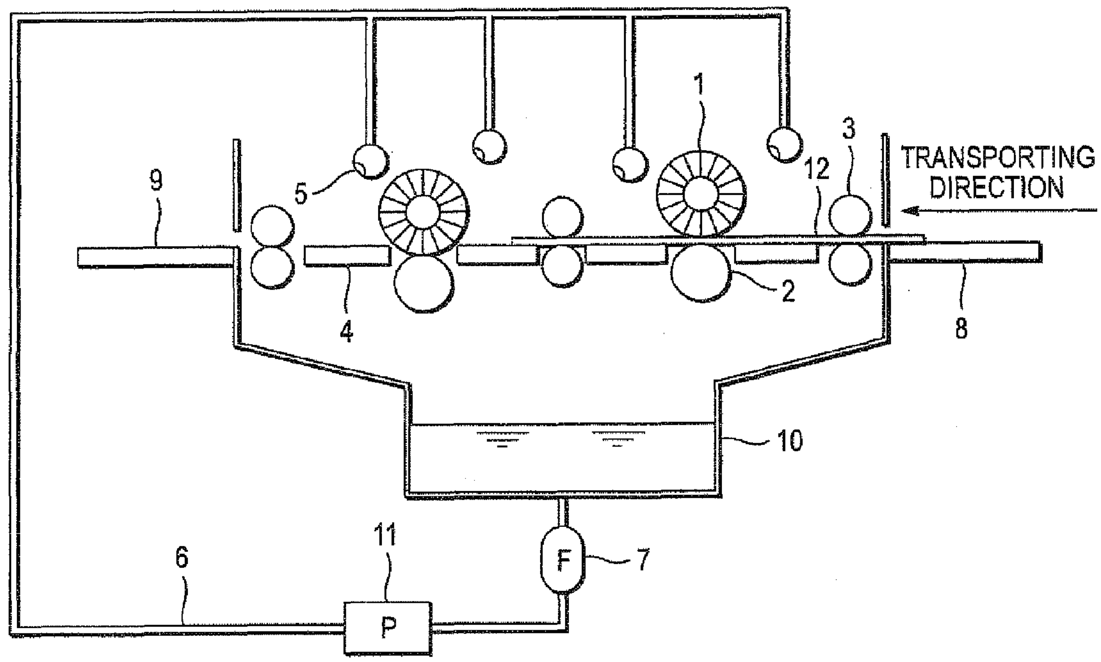

Europäisches Patentamt
European Patent Office
Office européen des brevets

# EUROPEAN SEARCH REPORT

Application Number
EP 10 19 7142

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>Y | JP 2005 014294 A (FUJI PHOTO FILM CO LTD) 20 January 2005 (2005-01-20)<br>* page 10, paragraph 43 *<br>* page 25, first monomer of the page *<br>* pages 77-79, paragraph 250-258 *<br>* page 80, paragraph 262 *<br>* claims 1,2 *<br>----- | 1-6,8, 10,11, 13-15,17<br>7,9,12, 16,18 | INV.<br>G03F7/11<br>B41C1/10<br>B41N1/14 |
| Y | JP 2009 222928 A (FUJIFILM CORP) 1 October 2009 (2009-10-01)<br>* pages 87-93; example 1 *<br>----- | 7,9,12, 16,18 | |
| A | EP 1 767 352 A2 (FUJIFILM CORP [JP]) 28 March 2007 (2007-03-28)<br>* page 15, copolymer 24 *<br>* pages 19-46, paragraph 56-174 *<br>* page 53, paragraph 246-249 *<br>* claim 1 *<br>----- | 1-18 | |

TECHNICAL FIELDS SEARCHED (IPC)

G03F
B41C
B41N

The present search report has been drawn up for all claims

1

| Place of search | Date of completion of the search | Examiner |
|---|---|---|
| The Hague | 27 April 2011 | Dupart, Jean-Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 10 19 7142

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2011

| Patent document cited in search report | Publication date | Patent family member(s) | Publication date |
|---|---|---|---|
| JP 2005014294 A | 20-01-2005 | JP 4384449 B2 | 16-12-2009 |
| JP 2009222928 A | 01-10-2009 | NONE | |
| EP 1767352 A2 | 28-03-2007 | US 2007072116 A1 | 29-03-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006239867 A
- JP 2008256742 A
- JP 2005125749 A
- JP 2006215263 A
- JP 10282679 A
- JP 2304441 A
- JP 2005238816 A
- EP 24629 A
- EP 107792 A
- US 4410621 A
- JP 2007206217 A
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2007187836 A
- JP 2008276155 A
- JP 2005250438 A
- JP 2005250158 A
- JP 2001075279 A
- JP 2007058170 A
- JP 2007093866 A
- JP 2007072816 A
- JP 2006189604 A
- JP 2007171406 A
- JP 2007206216 A
- JP 2007225701 A
- JP 2007225702 A
- JP 2007316582 A
- JP 2007328243 A
- JP 2001133969 A
- JP 2002023360 A
- JP 2002040638 A
- JP 2002278057 A
- JP 2008195018 A
- JP 2007090850 A
- JP 5005005 A
- JP 2001222101 A
- JP 2007000020 A
- JP 2005509192 T
- JP 2004310000 A
- JP 2009172790 A
- JP 2009029124 A
- JP 2005250216 A
- JP 2006025913 A
- JP 2005119273 A
- JP 5045885 A
- JP 6035174 A
- JP 2008203359 A
- JP 2008276166 A
- JP 2009047927 A


### Non-patent literature cited in the description


- **A.J. LEO.** Comprehensive Medicinal Chemistry,. Pergamon Press, 1990, vol. 4, 295
- **C. HANSCH ; A.J. LEO.** Substituent Constants for Correlation Analysis in Chemistry and Biology. John Wiley & Sons
- **A.J. LEO.** Calculating logPoct from Structure. *Chem. Rev.,* 1993, vol. 93, 1281-1306
- Shin Kobunshi Jikkengaku 3, Kobunshi no Gosei to Hanno 1. Kyoritsu Shuppan Co., Ltd,
- Shin Jikken Kagaku Koza 19, Kobunshi Kagaku (I). Maruzen Co., Ltd,
- Busshitsu Kogaku Koza, Kabunshi Gosei Kagaku. Tokyo Denki University Press

- Colour Index. Saishin Ganryo Binran. Pigment Technology Society of Japan, 1977
- Saishin Ganryo Oyou Gijutsu. CMC Publishing Co., Ltd, 1986
- Insatsu Ink Gijutsu. CMC Publishing Co., Ltd, 1984
- Kobunshi Jiten. 2005, 683-684